(19) Europäisches Patentamt
European Patent Office
Office européen des brevets

(11) EP 1 975 709 B1

(12) **EUROPEAN PATENT SPECIFICATION**

(45) Date of publication and mention of the grant of the patent:
**17.06.2009 Bulletin 2009/25**

(51) Int Cl.:
*G03F 7/028* (2006.01) *G03F 7/031* (2006.01)
*G03F 7/033* (2006.01) *B41C 1/10* (2006.01)

(21) Application number: **08005816.7**

(22) Date of filing: **27.03.2008**

(54) **Lithographic printing plate precursor and method of preparing lithographic printing plate**

Lithographiedruckplattenvorläufer und Verfahren zur Herstellung einer Lithographiedruckplatte

Précurseur de plaque d'impression lithographique et procédé pour la préparation d'une plaque d'impression lithographique

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **30.03.2007 JP 2007095469**

(43) Date of publication of application:
**01.10.2008 Bulletin 2008/40**

(73) Proprietor: **FUJIFILM Corporation**
**Minato-ku**
**Tokyo (JP)**

(72) Inventor: **Oohashi, Hidekazu**
**Haibara-gun**
**Shizuoka (JP)**

(74) Representative: **HOFFMANN EITLE**
**Patent- und Rechtsanwälte**
**Arabellastraße 4**
**81925 München (DE)**

(56) References cited:
**EP-A- 1 630 618**
**EP-A- 1 685 957**
**EP-A- 1 798 031**
**EP-A- 1 865 382**
**US-A1- 2006 166 137**
**US-A1- 2007 009 829**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 975 709 B1

## Description

### FIELD OF THE INVENTION

The present invention relates to a lithographic printing plate precursor which is capable of being subjected to a so-called direct plate-making, in which the plate-making is directly conducted based on digital signals, for example, from a computer using various kinds of lasers, particularly, to a lithographic printing plate precursor of a simple processing type which does not need alkali development, and a method of preparing a lithographic printing plate using the lithographic printing plate precursor.

### BACKGROUND OF THE INVENTION

A solid laser, semiconductor laser and gas laser having a large output and a small size, which radiate an ultraviolet ray, visible light or infrared ray having a wavelength of 300 to 1,200 nm, have become easily available, and these lasers are very useful for recording light sources used in the direct plate-making based on digital signals, for example, from a computer. Various investigations on recording materials sensitive to such various laser beams have been made. Typical examples thereof include firstly recording materials capable of being recorded with a infrared laser having a wavelength of not less than 760 nm, for example, positive type recording materials described in U.S. Patent 4, 708, 925 and acid catalyst crosslinking type negative type recording materials described in JP-A-8-276558 (the term "JP-A" as used herein means an "unexamined published Japanese patent application") (corresponding to U.S. Patent 6,132,935), and secondly recording materials responsive to an ultraviolet ray or visible light laser having a wavelength of from 300 to 700 nm, for example, radical polymerization type negative type recording materials described in U.S. Patent 2,850,445 and JP-B-44-20189 (the term "JP-B" as used herein means an "examined Japanese patent publication").

Further, with respect to hitherto known lithographic printing plate precursors (hereinafter, also referred to as PS plates), a step of removing the non-image area by dissolution (development processing) is indispensable and a post-processing step, for example, washing the printing plate after the development processing with water, treatment of the printing plate after the development processing with a rinse solution containing a surfactant or treatment of the printing plate after the development processing with an oil-desensitizing solution containing gum arabic or a starch derivative, is also necessary. The point that such additional wet treatments are indispensable is a large subject of investigation in hitherto known PS plates. Even when the first half (image-forming process) of plate-making process is simplified by the above-described digital processing, the effects due to the simplification is still insufficient as long as the last half (development processing) is the troublesome wet treatment.

Particularly, the consideration for global environment has become a great concern throughout the field of industry in recent years. In view of the consideration for global environment, a treatment with a developer closer to a neutral range and a small amount of waste liquid are subjects of further investigations. Further, it is desirable that the wet type post-processing is simplified or changed to a dry processing.

From this viewpoint, as one method for eliminating the processing step, a method referred to as on-machine development wherein an exposed printing plate precursor is mounted on a cylinder of a printing machine and the non-image area of the printing plate precursor is removed by supplying dampening water and ink while rotating the cylinder is known. Specifically, according to the method, the printing plate precursor is exposed and mounted on a printing machine as it is to complete development processing in a conventional process of printing.

A lithographic printing plate precursor suitable for the on-machine development is required to have an image-forming layer soluble in dampening water or an ink solvent and a bright room handling property suitable for development on a printing machine placed in a bright room.

However, it is substantially impossible for hitherto known PS plates to fulfill such requirements.

In order to fulfill such requirements, a lithographic printing plate precursor having provided on a hydrophilic support an image-forming layer in which fine particles of thermoplastic hydrophobic polymer are dispersed in a hydrophilic binder polymer is proposed (see, for example, Japanese Patent 2,938,397(corresponding to U.S. Patent 6,030,750)). In the plate-making, the lithographic printing plate precursor is exposed to an infrared laser to agglomerate (fuse) the fine particles of thermoplastic hydrophobic polymer by heat generated by light-to-heat conversion thereby forming an image, and mounted on a cylinder of a printing machine to carry out on-machine development by supplying at least any one of dampening water and ink. Since the lithographic printing plate precursor has the sensitive zone in an infrared region, it has also the handling property in a bright room.

However, the image formed by the agglomeration (fusion) of the fine particles of thermoplastic hydrophobic polymer is insufficient in strength and has a problem of printing durability as a printing plate.

Lithographic printing plate precursors including microcapsules containing a polymerizable compound incorporated therein in stead of the thermoplastic fine particles are also proposed (see, for example, JP-A-2000-211262, JP-A-2001-277740 (corresponding to US2001/0018159A1), JP-A-2002-29162 (corresponding to US2002/0031715A1), JP-A-2002-46361 (corresponding to US2002/0031715A1), JP-A-2002-137562 (corresponding to US2002/0102488A1), JP-A-2002-326470 (corresponding to US2002/0117066A1) and JP-A-2001-337460 (corresponding to US2003/0190553A1)). In the lithographic printing plate precursors according to such a proposal, it is advantageous that the polymer image formed by a reaction of the polymerizable compound is excellent in the strength in comparison with the image formed by the fusion of the fine particles.

Also, since the polymerizable compound has high reactivity, many proposals for isolation of the polymerizable compound using microcapsules have been made. Further, it has been proposed to use a thermally degradable polymer in a shell of the microcapsule.

In JP-A-2001-337460 (corresponding to US2003/0190553A1), a negative type lithographic printing plate precursor comprising (A) a layer containing a latex and (B) an ink-receptive layer, wherein the layer (B) contains a light-to-heat conversion agent is described. It is also described that according to the negative type lithographic printing plate precursor, printing durability of the ink-receptive layer is improved because heat generated when the light-to-heat conversion agent absorbs mainly an infrared ray is prevented from dispersion into a substrate.

However, in the hitherto known lithographic printing plate precursors described in Japanese Patent 2,938,397 (corresponding to U.S. Patent 6,030,750), JP-A-2000-211262, JP-A-2001-277740 (corresponding to US2001/0018159A1), JP-A-2002-29162 (corresponding to US2002/0031715A1), JP-A-2002-46361 (corresponding to US2002/0031715A1), JP-A-2002-137562 (corresponding to US2002/0102488A1), JP-A-2002-326470 (corresponding to US2002/0117066A1) and JP-A-2001-337460 (corresponding to US2003/0190553A1), it is insufficient to achieve a good balance between printing durability of the image formed by laser exposure and stain resistance so that further improvements have been requested. Specifically, in such a lithographic printing plate precursor of a simple processing type, a support having a surface of high hydrophilicity is used in order to make possible development with an aqueous solution having pH of 10 or less or dampening water (ordinarily nearly neutral) on a printing machine and as a result, the image area is apt to be removed from the support by dampening water during printing so that sufficient printing durability can not be obtained. On the contrary, when the surface of support renders hydrophobic, ink also adheres on the non-image area during printing to cause printing stain. Thus, it is extremely difficult to achieve a good balance between the printing durability and the stain resistance and a lithographic printing plate precursor of a simple processing type which provides good stain resistance and sufficient printing durability has not yet been known.

EP-A-1 630 618 relates to a method for producing a lithographic printing plate by removing, after exposure, the unexposed area of the image recording layer with use of developer at a pH of 2 to 10 in an automatic processor.

US A1 2006/0166137 and EP-A-1 685 957 relate to packaged bodies of lithographic printing plate precursors which are capable of direct plate making by scanning with laser beams.

EP-A-1 798 031 relates to a packaged body of lithographic printing plate precursors, wherein an image-recording layer or a protective layer of the outermost surface layer contains an inorganic layered compound.

US A1 2007/0009829 relates to laser sensitive negative-working lithographic printing plates having a photosensitive layer over a hydrophilically treated darker aluminium substrate.

EP-A1-1 865 382 relates to a method for the preparation of lithographic printing plates including imagewise exposing a lithographic printing plate precursors comprising a hydrophilic support and a photosensitive layer.

## SUMMARY OF THE INVENTION

Therefore, an object of the present invention is to provide a lithographic printing plate precursor capable of being subjected to a direct plate-making based on digital data, for example, from a computer, by image-recording using a solid laser or semiconductor laser radiating an ultraviolet ray or visible light, particularly, a lithographic printing plate precursor of a simple processing type which can be developed with an aqueous solution having pH of 10 or less or on a printing machine and provides high printing durability and good stain resistance, and a method of preparing a lithographic printing plate.

As a result of the intensive investigations, the inventors have found that the above-described object can be achieved by providing a layer containing an organic resin fine particle between a support and a photosensitive layer.

Specifically, the present invention includes the following items.

(1) A negative type lithographic printing plate precursor comprising a support, a layer containing an organic resin fine particle and a photosensitive layer containing (a) a radical polymerizable compound, (b) a binder polymer, (c) an initiator and (d) a sensitizing dye having an absorption maximum in a wavelength range of 350 to 450 nm, in this order.

(2) The negative type lithographic printing plate precursor as described in (1), wherein the organic resin fine particle has a functional group which interacts with the photosensitive layer.

(3) The negative type lithographic printing plate precursor as described in (1) or (2), wherein the organic resin fine

particle has a functional group which interacts with a surface of the support.

(4) The negative type lithographic printing plate precursor as described in any one of (1) to (3), wherein the organic resin fine particle has a minimum film-forming temperature of 60°C or more.

(5) The negative type lithographic printing plate precursor as described in any one of (1) to (4), wherein the photosensitive layer does not contain a light-to-heat conversion agent.

(6) The negative type lithographic printing plate precursor as described in any one of (1) to (5), which further comprises a protective layer on the photosensitive layer.

(7) The negative type lithographic printing plate precursor as described in any one of (1) to (6), wherein an amount of the organic resin fine particle in the organic resin fine particle-containing layer is 50% by weight or more based on a total solid content of the particle-containing layer.

(8) The negative type lithographic printing plate precursor as claimed in any one of (1) to (7), wherein an average particle size of the organic resin fine particle is from 0.01 to 1 μm.

(9) A method of preparing a lithographic printing plate comprising exposing imagewise the lithographic printing plate precursor as described in any one of (1) to (8) with a laser, and rubbing a surface of the exposed lithographic printing plate precursor with a rubbing member in the presence of a developer having pH of 2 to 10 in an automatic processor equipped with the rubbing member to remove an unexposed area of the photosensitive layer and the layer containing an organic resin fine particle.

(10) The method of preparing a lithographic printing plate as described in (9), wherein the exposed lithographic printing plate precursor is subjected to a heat treatment between the exposure and the development.

According to the present invention, a lithographic printing plate precursor which is capable of being subjected to a so-called direct plate-making, in which the plate-making is directly conducted based on digital signals, for example, from a computer using various kinds of lasers, particularly, a lithographic printing plate precursor of a simple processing type which does not need development with an aqueous alkali solution, and a method of preparing a lithographic printing plate using the lithographic printing plate precursor are obtained.

## BRIEF DESCRIPTION OF THE DRAWINGS

Fig.1 is an illustration for showing a structure of an automatic development processor.

[Description of reference numerals and signs]

| | |
|---|---|
| 61: | Rotating brush roller |
| 62: | Backing roller |
| 63: | Transport roller |
| 64: | Transport guide plate |
| 65: | Spray pipe |
| 66: | Pipe line |
| 67: | Filter |
| 68: | Plate supply table |
| 69: | Plate discharge table |
| 70: | Developer tank |
| 71: | Circulating pump |
| 72: | Plate |

## DETAILED DESCRIPTION OF THE INVENTION

The lithographic printing plate precursor according to the invention will be described in more detail below.

The lithographic printing plate precursor according to the invention comprises, in the following order, a support, a layer containing an organic resin fine particle and a photosensitive layer containing (a) a radical polymerizable compound, (b) a binder polymer, (c) an initiator and (d) a sensitizing dye having an absorption maximum in a wavelength range of 350 to 450 nm. [Layer containing organic resin fine particle]

The layer (hereinafter also referred to as a "fine particle-containing layer") containing an organic resin fine particle for use in the invention is a layer mainly containing an organic resin fine particle as described below.

(Organic resin fine particle)

As the organic resin fine particle for use in the invention, any fine particulate organic resin can be preferably used. In particular, a water-dispersible organic resin fine particle is preferred. Examples of the organic resin include a synthetic resin, for example, an acrylic resin, a methacrylic resin, a urethane resin, an ester resin, an amide resin, a urea resin, a styrene resin, a carbonate resin or ethylene resin and a natural resin, for example, natural rubber and an acrylic resin, a methacrylic resin, a urethane resin, a styrene resin, a urea resin or an amide resin is preferred.

It is preferred that the organic resin fine particle for use in the invention has a functional group capable of interacting with the photosensitive layer. The introduction of the functional group capable of interacting with the photosensitive layer makes it possible to form a stronger image area to further improve printing durability. Examples of the functional group capable of interacting with the photosensitive layer include groups capable of forming a hydrogen bond, a covalent bond or an electrostatic bond with the photosensitive layer and in particular, a radical polymerizable unsaturated double bond group and a radical polymerization chain transferable functional group, for example, a thiol group, a sulfido group or a disulfide group are preferable. As the radical polymerizable unsaturated double bond group, functional groups represented by formula (1) to (3) shown below are particularly preferable.

Formula (1):

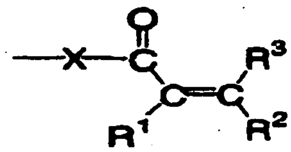

In formula (1), $R^1$ to $R^3$ each independently represents a hydrogen atom or a monovalent organic group. $R^1$ preferably includes, for example, a hydrogen atom or an alkyl group which may have a substituent. Among them, a hydrogen atom, a methyl group or a $-CH_2X$ group is preferable because of high radical reactivity. X represents a halogen atom, a cyano group, a $-OR^{14}$ group, a $-OCOR^{14}$ group, a $-OCONR^{14}R^{15}$ group, a $-OCOOR^{14}$ group, a $-OSO_2R^{14}$ group, a $-OPO(OR^{14})(OR^{15})$ group, a $-OPOR^{14}(OR^{15})$ group, a $-NR^{14}R^{15}$ group, a $-NR^{14}COR^{15}$ group, a $-NR^{14}COOR^{15}$ group, a $-NR^{14}CONR^{15}R^{16}$ group, a $-NR^{14}SO_2R^{15}$ group, a $-N(SO_2R^{14})(SO_2R^{15})$ group, a $-N(COR^{14})(COR^{15})$ group, a $-SR^{14}$ group, a $-SOR^{14}$ group, a $-SO_2R^{14}$ group, a $-SO_3R^{14}$ group, a $-SO_2NR^{14}R^{15}$ group or a $-PO(OR^{14})(OR^{15})$ group and in particular, a halogen atom, a cyano group, a $-OR^{14}$ group, a $-OCOR^{14}$ group, a $-OCONR^{14}R^{15}$ group, a $-OCOOR^{14}$ group, $-NR^{14}R^{15}$ group, a $-NR^{14}COR^{15}$ group, a $-NR^{14}COOR^{15}$ group, a $-NR^{14}CONR^{15}R^{16}$ group or a $-SR^{14}$ group is preferable. $R^{14}$ to $R^{16}$ each independently represents a hydrogen atom, an alkyl group which may have a substituent, an aryl group which may have a substituent, an alkynyl group which may have a substituent or an alkenyl group which may have a substituent.

$R^2$ and $R^3$ each independently preferably includes, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.

X represents an oxygen atom, a sulfur atom or $-N(R^{12})-$, and $R^{12}$ represents a hydrogen atom or a monovalent organic group. The monovalent organic group represented by $R^{12}$ includes, for example, an alkyl group which may have a substituent. $R^{12}$ is preferably a hydrogen atom, a methyl group, an ethyl group or an isopropyl group because of high radical reactivity.

Examples of the substituent introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

Formula (2):

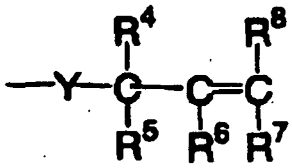

In formula (2), $R^4$ to $R^8$ each independently represents a hydrogen atom or a monovalent organic group. $R^4$ to $R^8$ each independently preferably includes, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable. Examples of the substituent introduced include those described in Formula (1).

Y represents an oxygen atom, a sulfur atom or -N($R^{12}$)-, and $R^{12}$ has the same meaning as $R^{12}$ defined in Formula (1). Preferable examples for $R^{12}$ are also same as those described in Formula (1).

Formula (3):

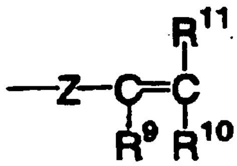

In formula (3), $R^9$ to $R^{11}$ each independently represents a hydrogen atom or a monovalent organic group. The monovalent organic group includes an alkyl group which may have a substituent. Among them, $R^9$ is preferably a hydrogen atom or a methyl group because of high radical reactivity. $R^{10}$ and $R^{11}$ each independently preferably includes, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity. Examples of the substituent introduced include those described in Formula (1).

Z represents an oxygen atom, a sulfur atom, -N($R^{13}$)- or a phenylene group which may have a substituent. $R^{13}$ includes an alkyl group which may have a substituent or the like. Among them, a methyl group, an ethyl group or an isopropyl group is preferable because of high radical reactivity.

In the organic resin fine particle having a radical polymerizable unsaturated double bond group or a radical polymerization chain transferable functional group, for example, a free radical (a polymerization initiating radical or a propagating radical in the process of polymerization of the polymerizable compound) is added to the functional group to cause addition-polymerization between the photosensitive layer and the fine particle-containing layer directly or through a polymerization chain of the polymerizable compound, as a result, a strong covalent bond is formed between the photosensitive layer and the fine particle-containing layer. Alternatively, an atom (for example, a hydrogen atom on the carbon atom adjacent to the functional group) in the organic resin constituting the organic resin fine particle or a binder in the photosensitive layer is withdrawn by a free radical to produce a radical and the radicals are combined with each other to form a strong covalent bond between the photosensitive layer and the fine particle-containing layer.

The content of the radical polymerizable unsaturated double bond group (content of radical-polymerizable unsaturated double bond determined by iodine titration) in the organic resin fine particle for use in the invention is preferably from 0.01 to 20.0 mmol, more preferably from 0.1 to 15.0 mmol, most preferably from 1.0 to 10.0 mmol, per g of the organic resin fine particle.

It is preferred that the organic resin fine particle for use in the invention has a functional group capable of

interacting with the support. The introduction of the functional group capable of interacting with the support makes possible firmer adhesion of the image area to the support to further improve printing durability. Examples of the functional group capable of interacting with the support include functional groups capable of forming a hydrogen bond, a covalent bond, an electrostatic bond or a coordinate bond with the support and it is preferable to appropriately select the functional group depending on the support used. In the case wherein the support is an aluminum support conventionally used in a lithographic printing plate precursor, the functional group capable of interacting with the support preferably includes a phosphonic acid group, a phosphoric acid group, a 1, 3-diketone group, a boric acid group, an ammonium group, a hydroxy group, a carboxylic acid group, a siloxane group and an amino group and among them, a phosphonic acid group, a phosphoric acid group, a boric acid group, an ammonium group or a carboxylic acid group is particularly preferable.

The content of the functional group capable of interacting with the support in the organic resin fine particle for use in the invention is preferably from 0.01 to 20.0 mmol, more preferably from 0.1 to 15.0 mmol, most preferably from 1.0 to 10.0 mmol, per g of the organic resin fine particle from the standpoint of achieving a good balance between the printing durability and the stain resistance.

It is preferred that the organic resin fine particle for use in the invention has a minimum film-forming temperature of 60°C or more. The use of the organic resin fine particle having a minimum film-forming temperature of 60°C or more makes it possible to prevent heat fusion of the organic resin fine particle at the time of heating of the fine particle-containing layer, photosensitive layer or possibly protective layer by drying after coating on the support or at the time of heating for the purpose of further advancing the radical polymerization after the laser exposure to increase curing degree of the photosensitive layer and as a result, the organic resin fine particle can be easily removed at the time of development to achieve good developing property in a simple processing. The organic resin fine particle preferably has the minimum film-forming temperature of 60°C or more, more preferably has the minimum film-forming temperature of 70°C or more, particularly preferably has the minimum film-forming temperature of 80°C or more. The minimum film-forming temperature of the organic resin fine particle can be determined according to a temperature gradient plate method or using a melting point instrument. Since the minimum film-forming temperature of the organic resin fine particle is varied depending on the organic resin structure, it is preferred to achieve the minimum film-forming temperature of 60°C or more by appropriately adjusting the organic resin structure. Preferable organic resin structure is an organic resin having a glass transition temperature of 60°C or more. Although such an organic resin is obtained by selecting a structural unit constituting the resin (for example, a styrene resin or a methacrylic resin), it is particularly preferred for the organic resin to have a crosslinking structure therein. By appropriately control the amount of the crosslinking structure introduced, various kinds of the structural units constituting the organic resin can be selected so that the introduction of the functional group capable of interacting with the photosensitive layer or the functional group capable of interacting with the support as described above becomes easy. The amount of the crosslinking structure introduced is not restricted as long as the minimum film-forming temperature exceeds 60°C. From the standpoint of achieving a good balance between the printing durability and the stain resistance, the amount of the crosslinking structure introduced is preferably from 2.5 to 50% by mole, more preferably from 5 to 25% by mole, taking the resin structural unit as 100% by mole.

With respect to the average particle size of the organic resin fine particle for use in the invention, as the average particle size decreases, the printing durability is improved because of increase in the contact point with the support but the developing property in a simple processing decreases because they becomes hardly removed by the simple processing. On the contrary, when the average particle size increases, the developing property in a simple processing is improved but the printing durability degrades. Therefore, from the standpoint of achieving a good balance between the printing durability and the stain resistance, the average particle size of the organic resin fine particle is preferably from 0.01 to 1 $\mu$m, more preferably from 0.02 to 0.5 $\mu$m, particularly preferably from 0.03 to 0.3 $\mu$m. The average particle size can be determined according to a known method, for example, an electron microscope method or a light scattering method. By using the organic resin fine particle having the crosslinking structure and average particle size as described above, the good developing property in a simple processing and high printing durability can be achieved. The particle size distribution of the organic resin fine particle is not particularly restricted and the standard deviation of the particle size is preferably 100 nm or less, more preferably 80 nm or less.

The organic resin fine particles for use in the invention may be used individually or as a mixture of two or more thereof. It is also possible to use the organic resin fine particles having the different particle sizes from each other in mixture.

Specific examples of the organic resin for forming the organic resin fine particle for use in the invention are set forth below, but the invention should not be construed as being limited thereto.

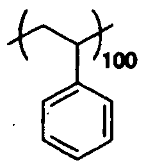

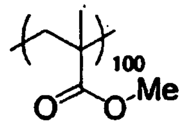

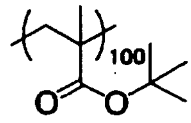

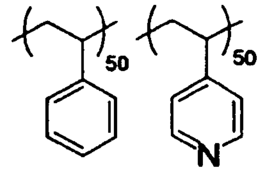

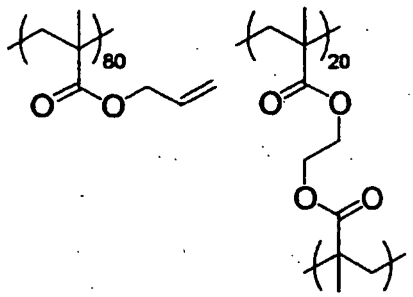

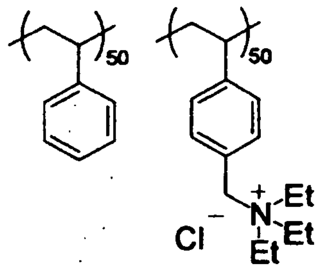

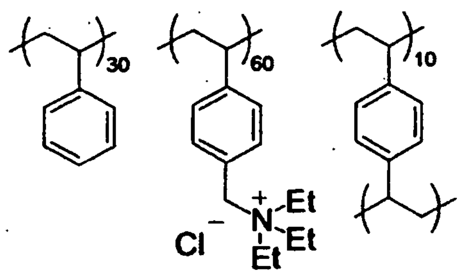

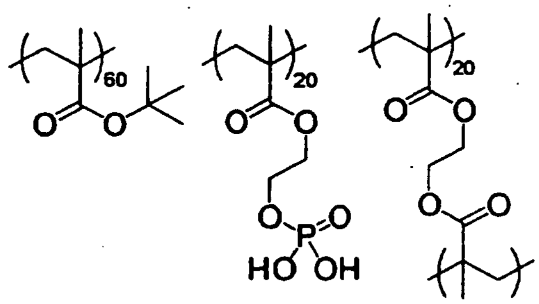

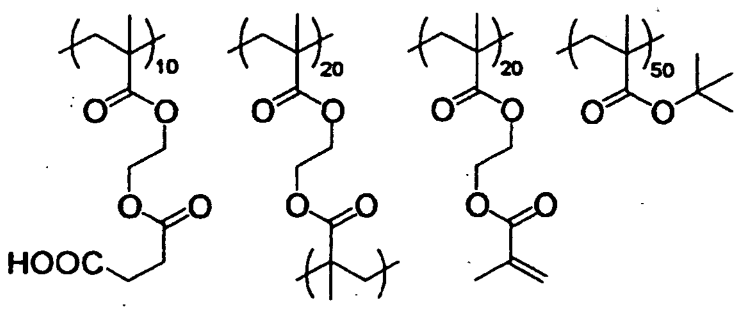

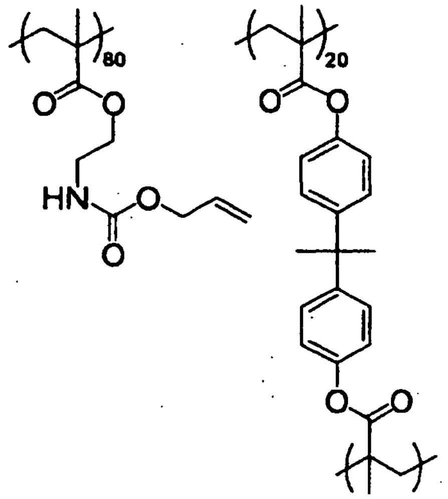

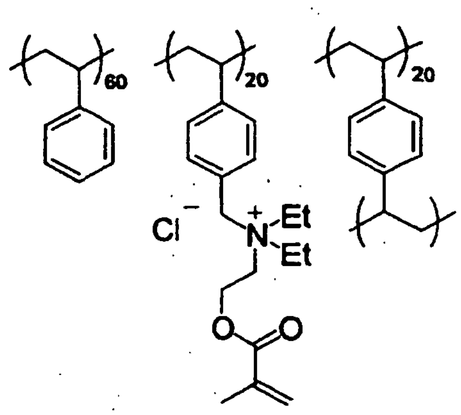

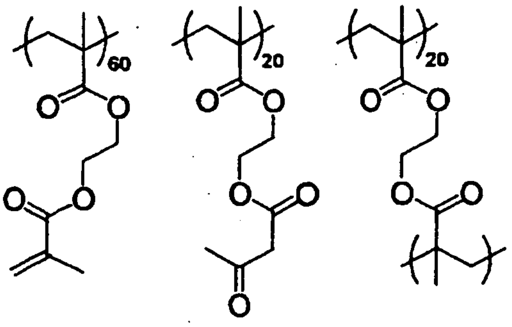

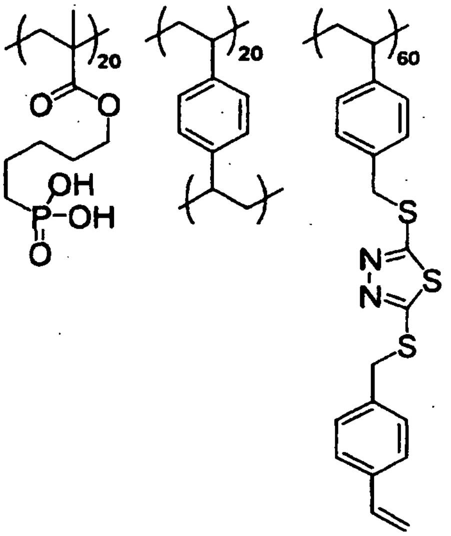

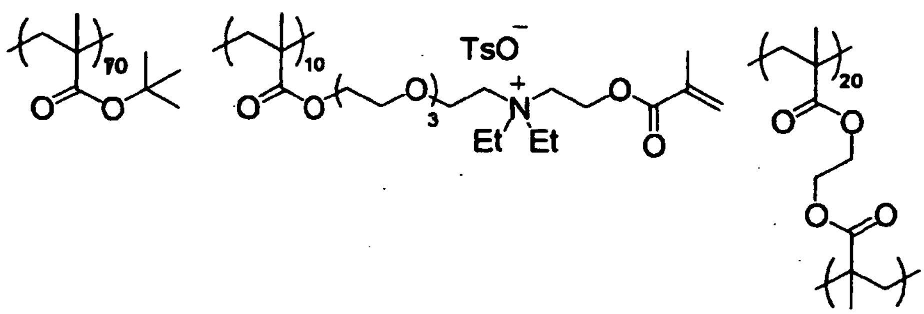

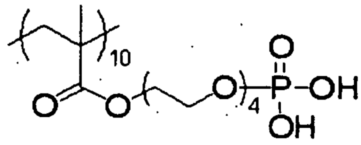

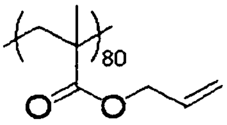

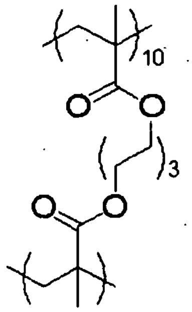

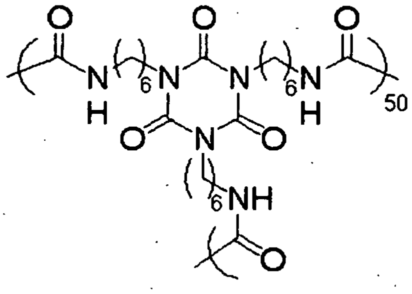

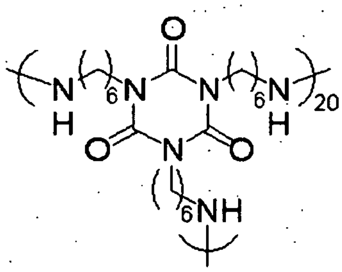

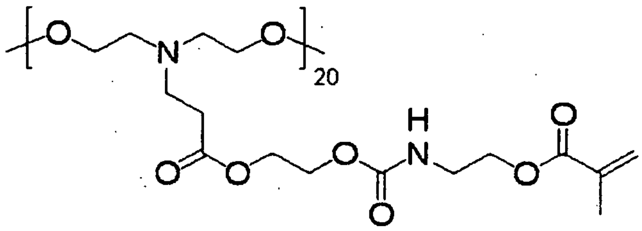

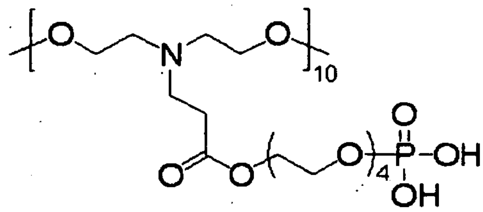

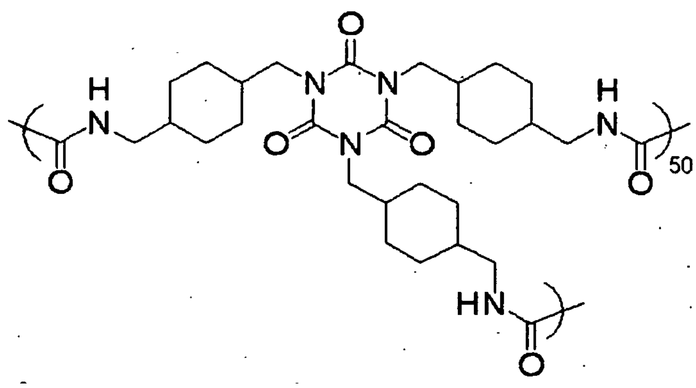

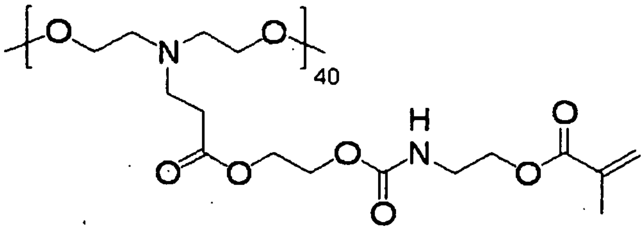

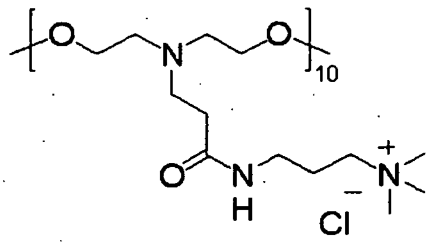

The organic resin fine particle for use in the invention can be produced by a conventionally known polymerization method, for example, emulsion polymerization using a surfactant, soap-free emulsion polymerization, seed emulsion polymerization, suspension polymerization or dispersion polymerization, a conventionally known method of producing a microcapsule, for example, a method of utilizing coacervation described in U.S. Patents 2,800,457 and 2,800,458, a method of using interfacial polymerization described in British Patent 990,443, U.S. Patent 3,287,154, JP-B-38-19574, JP-B-42-446 and JP-B-42-711, a method of using deposition of polymer described in U.S. Patents 3, 418, 250 and 3, 660, 304, a method of using an isocyanate polyol wall material described in U.S. Patent 3, 796, 669, a method of using an isocyanate wall material described in U.S. Patent 3, 914, 511, a method of using a urea-formaldehyde-type or urea-formaldehyde-resorcinol-type wall-forming material described in U.S. Patens 4,001,140, 4,087,376 and 4,089,802, a method of using a wall material, for example, a melamine-formaldehyde resin or hydroxycellulose described in U. S. Patent 4,025,445, an in-situ method by monomer polymerization described in JP-B-36-9163 and JP-B-51-9079, a spray drying method described in British Patent 930,422 and U.S. Patent 3,111,407 or an electrolytic dispersion cooling method described in British Patents 952,807 and 967,074, or a method wherein the organic resin is dissolved in an organic solvent immiscible with water, emulsifying or dispersing together with an emulsifier or a disperser and evaporating the organic solvent.

The amount of the organic resin fine particle in the fine particle-containing layer for use in the invention is preferably 50% by weight or more, more preferably 70% by weight or more, particularly preferably 80% by weight or more, based on the total solid content of the fine particle-containing layer.

(Other components)

To the fine particle-containing layer for use in the invention may be added a hydrophilic resin, a surfactant or the like as long as the effects of the invention are not damaged.

Examples of the hydrophilic resin added to the fine particle-containing layer for use in the invention include gum arabic, casein, gelatin, a starch derivative, carboxymethyl cellulose or a sodium salt thereof, cellulose acetate, sodium alginate, a vinyl acetate-maleic acid copolymer, a styrene-maleic acid copolymer, polyacrylic acid or a salt thereof, polymethacrylic acid or a salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, polyethylene glycol, a hydroxypropylene polymer, polyvinyl alcohol, a hydrolyzed polyvinyl acetate having a hydrolysis degree of 60% by mole or more, preferably 80% by mole or more, polyvinyl formal, polyvinyl butyral, polyvinyl pyrrolidone, a homopolymer or polymer of acrylamide, a homopolymer or copolymer of methacrylamide, a homopolymer or copolymer of N-methylolacrylamide, polyvinyl pyrrolidone, an alcohol-soluble nylon and a polyether of 2,2-bis (4-hydroxyphenyl)propane with epichlorohydrin. Of the hydrophilic resins, a hydrophilic resin comprising (a1) a repeating unit containing at least one ethylenically unsaturated bond, (a2) a repeating unit containing at least one functional group capable of interacting with the surface of support and (a3) a repeating unit containing at least one hydrophilic functional group is particularly preferable.

The repeating unit of (a1) is preferably represented by the following formula (A1):

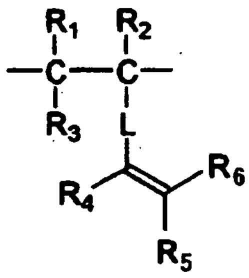 (A1)

In formula (A1), $R_1$ to $R_3$ each independently represents a hydrogen atom, an alkyl group having from 1 to 6 carbon atoms or a halogen atom. $R_4$ to $R_6$ each independently represents a hydrogen atom, an alkyl group having from 1 to 6 carbon atoms, a halogen atom, an acyl group or an acyloxy group. Alternatively, $R_4$ and $R_5$ or $R_5$ and $R_6$ may be combined with each other to form a ring. L represents a divalent connecting group selected from -CO-, -O-, -NH-, a divalent aliphatic group, a divalent aromatic group and a combination thereof.

Specific examples of the combination of groups represented by L are set forth below. In each of the specific examples shown below, the left side connects to the main chain and the right side connects to the ethylenic unsaturated bond group.

L1: -CO-NH-divalent aliphatic group-O-CO-
L2: -CO-divalent aliphatic group-O-CO-
L3: -CO-O-divalent aliphatic group-O-CO-
L4: -divalent aliphatic group-O-CO-
L5: -CO-NH-divalent aromatic group-O-CO-
L6: -CO-divalent aromatic group-O-CO-
L7: -divalent aromatic group-O-CO-
L8: -CO-divalent aliphatic group-CO-O-divalent aliphatic group-O-CO-
L9: -CO-divalent aliphatic group-O-CO-divalent aliphatic group-O-CO-
L10: -CO-divalent aromatic group-CO-O-divalent aliphatic group-O-CO-
L11: -CO-divalent aromatic group-O-CO-divalent aliphatic group-O-CO-
L12: -CO-divalent aliphatic group-CO-O-divalent aromatic group-O-CO-
L13: -CO-divalent aliphatic group-O-CO-divalent aromatic group-O-CO-
L14: -CO-divalent aromatic group-CO-O-divalent aromatic group-O-CO-
L15: -CO-divalent aromatic group-O-CO-divalent aromatic group-O-CO-

The divalent aliphatic group includes an alkylene group, a substituted alkylene group, an alkenylene group, a substituted alkenylene group, an alkinylene group, a substituted alkinylene group and a polyalkyleneoxy group. Among them, an alkylene group, a substituted alkylene group, an alkenylene group and a substituted alkenylene group are preferable, and an alkylene group and a substituted alkylene group are more preferable.

Of the divalent aliphatic groups, a chain structure is preferable than a cyclic structure, and further a straight chain structure is more preferable than a branched chain structure.

A number of carbon atoms included in the divalent aliphatic group is preferably from 1 to 20, more preferably from 1 to 15, still more preferably from 1 to 12, yet still more preferably from 1 to 10, and most preferably from 1 to 8.

Examples of the substituent for the divalent aliphatic group include a halogen atom (e.g., F, Cl, Br or I), a hydroxy group, a carboxyl group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, a monoarylamino group and a diarylamino group.

The divalent aromatic group includes an arylene group and a substituted arylene group. It preferably includes a phenylene group, a substituted phenylene group, a naphthylene group and a substituted naphthylene group.

Examples of the substituent for the divalent aromatic group include an alkyl group in addition to the substituents described for the divalent aliphatic group described above.

Specific examples of the repeating unit of (a1) are set forth below, but the invention should not be construed as being limited thereto.

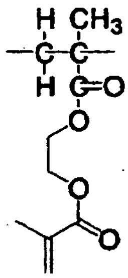
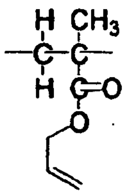
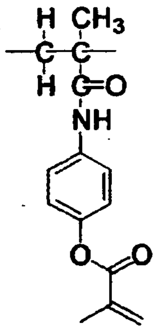
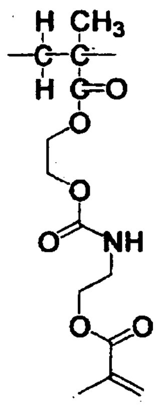
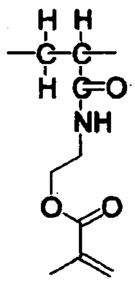
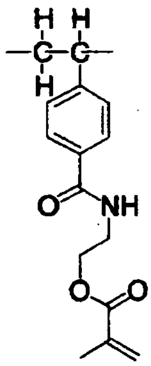
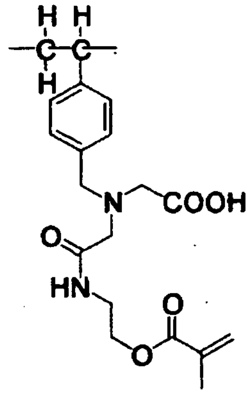
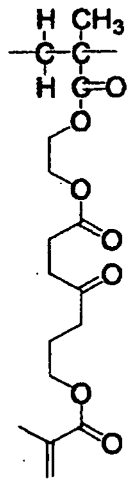

The repeating unit of (a2) is preferably represented by the following formula (A2):

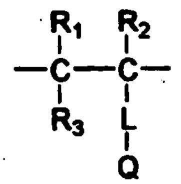 **(A2)**

In formula (A2), $R_1$ to $R_3$ and L have the same meanings as those defined in formula (A1), respectively. Q represents a functional group (hereinafter, also referred to as a "specific functional group") capable of interacting with the surface of support.

As the specific functional group, for example, a group capable of undergoing interaction, for example, forming a covalent bond, an ionic bond or a hydrogen bond or undergoing polar interaction or van der Waals interaction, with Si-OH, Si-$O^-$, $Al^{3+}$, aluminum oxide, zirconium oxide or the like present on the surface of support is exemplified. Specific examples of the specific functional group are set forth below.

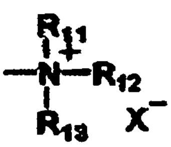
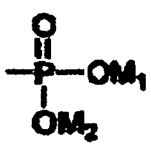
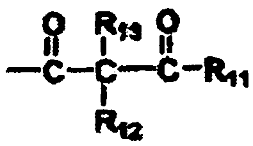
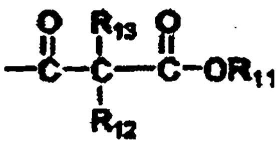

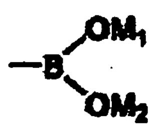 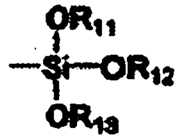 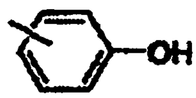 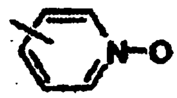

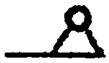 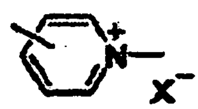 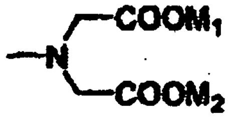 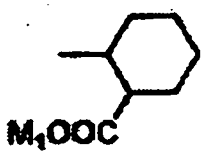

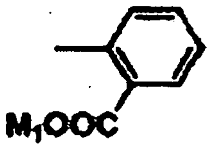 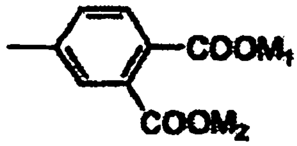

In the above-formulae, $R_{11}$ to $R_{13}$ each independently represents a hydrogen atom, an alkyl group, an aryl group, an alkynyl group or an alkenyl group, $M_1$ and $M_2$ each independently represents a hydrogen atom, a metal atom or an ammonium group, and $X^-$ represents a counter anion.

Of the specific functional groups, an onium salt group, for example, an ammonium group or a pyridinium group, a phosphoric ester group, a phosphonic acid group, a boric acid group or a β-diketone group, for example, an acetylacetone group is preferable.

In formula (A2), L represents a divalent connecting group selected from -CO-, -O-, -NH-, a divalent aliphatic group, a divalent aromatic group and a combination thereof.

Specific examples of the combination of groups represented by L include the following groups in addition to the specific examples set forth for L in formula (A1). In each of the specific examples shown below, the left side connects to the main chain and the right side connects to the ethylenic unsaturated bond group.

L16: -CO-NH-
L17: -CO-O-
L18: -divalent aromatic group-

Specific examples of the repeating unit of (a2) are set forth below, but the invention should not be construed as being limited thereto.

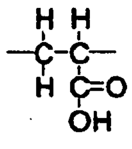 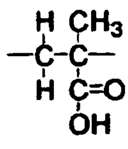 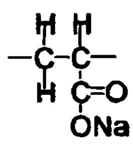 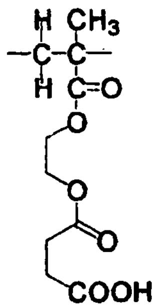 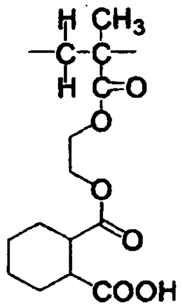

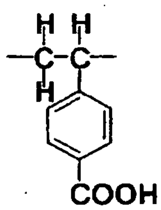 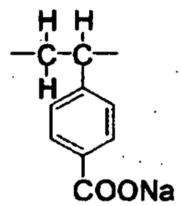

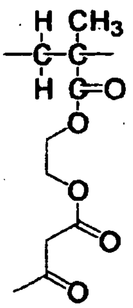 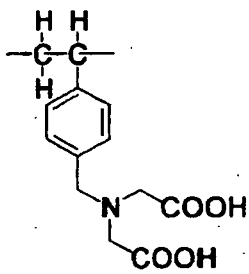 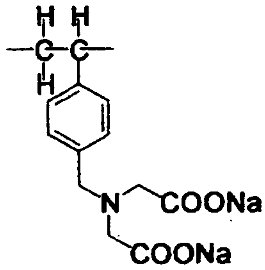 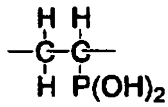

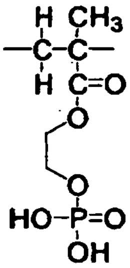 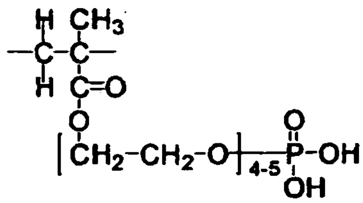

The repeating unit of (a3) is preferably represented by the following formula (A3):

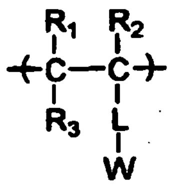 (A3)

In formula (A3), $R_1$ to $R_3$ and L have the same meanings as those defined in formula (A1), respectively. W represents a group shown below.

$-COO-M_1$, $-SO_3-M_1$,

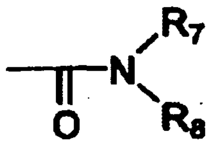 , 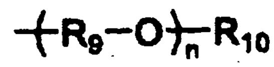 .

In the above-formulae, $M_1$ has the same meaning as that defined with respect to formula (A2) above. $R_7$ and $R_8$ each independently represents a hydrogen atom or a straight chin or branched alkyl group having from 1 to 6 carbon atoms. $R_9$ represents a straight chin or branched alkylene group having from 1 to 6 carbon atoms. $R_{10}$ represents a hydrogen atom or an alkyl group having from 1 to 12 carbon atoms. n represents an integer of 1 to 100.

Specific examples of the repeating unit of (a3) are set forth below, but the invention should not be construed as being limited thereto.

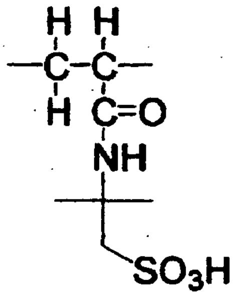

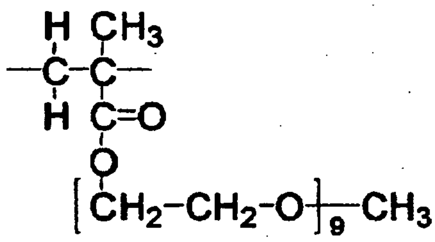

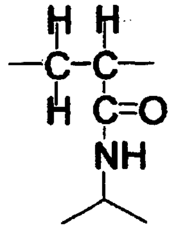

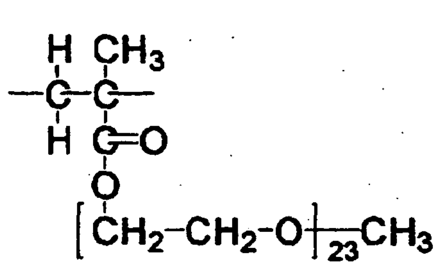

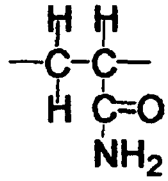

The amount of the hydrophilic resin added to the fine particle-containing layer for use in the invention is preferably from 0 to 50% by weight, more preferably from 0.05 to 40% by weight, particularly preferably from 0.1 to 30% by weight, based on the total solid content of the fine particle-containing layer.

The surfactant added to the fine particle-containing layer for use in the invention includes, for example, a nonionic surfactant, an anionic surfactant, a cationic surfactant, an amphoteric surfactant and a fluorine-based surfactant.

The nonionic surfactant is not particular restricted, and nonionic surfactants hitherto known can be used. Examples of the nonionic surfactant include polyoxyethylene alkyl ethers, polyoxyethylene alkyl phenyl ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N-bis-2-hydroxyalkylamines, polyoxyethylene alkylamines, triethanolamine fatty acid esters, trialylamine oxides, polyethylene glycols and copolymers of polyethylene glycol and polypropylene glycol.

The anionic surfactant is not particularly restricted and anionic surfactants hitherto known can be used. Examples of the anionic surfactant include fatty acid salts, abietic acid salts, hydroxyalkanesulfonic acid salts, alkanesulfonic acid salts, dialkylsulfosuccinic ester salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic monoamide disodium salts, petroleum sulfonic acid salts, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styrylphenyl ether sulfate ester salts, alkyl phosphate ester salts, polyoxyethylene alkyl ether phosphate ester salts, polyoxyethylene alkyl phenyl ether phosphate ester salts, partial saponification products of styrene/maleic anhydride copolymer, partial saponification products of olefin/maleic anhydride copolymer and naphthalene sulfonate formalin condensates.

The cationic surfactant is not particularly restricted and cationic surfactants hitherto known can be used. Examples of the cationic surfactant include alkylamine salts, quaternary ammonium salts, polyoxyethylene alkyl amine salts and polyethylene polyamine derivatives.

The amphoteric surfactant is not particularly restricted and amphoteric surfactants hitherto known can be used. Examples of the amphoteric surfactant include carboxybetaines, aminocarboxylic acids, sulfobetaines, aminosulfuric esters and imidazolines.

In the surfactants described above, the term "polyoxyethylene" can be replaced with "polyoxyalkylene", for example, polyoxymethylene, polyoxypropylene or polyoxybutylene, and such surfactants can also be used in the invention.

Further, a preferable surfactant includes a fluorine-based surfactant containing a perfluoroalkyl group in its molecule. Examples of the fluorine-based surfactant include an anionic type, for example, perfluoroalkyl carboxylates, perfluoroalkyl sulfonates or perfluoroalkylphosphates; an amphoteric type, for example, perfluoroalkyl betaines; a cationic type, for example, perfluoroalkyl trimethyl ammonium salts; and a nonionic type, for example, perfluoroalkyl amine oxides, perfluoroalkyl ethylene oxide adducts, oligomers having a perfluoroalkyl group and a hydrophilic group, oligomers having a perfluoroalkyl group and an oleophilic group, oligomers having a perfluoroalkyl group, a hydrophilic group and an oleophilic group or urethanes having a perfluoroalkyl group and an oleophilic group. Further, fluorine-based surfactants described in JP-A-62-170950, JP-A-62-226143 and JP-A-60-168144 are also preferably exemplified.

The surfactants may be used individually or in combination of two or more thereof.

The amount of the surfactant added to the fine particle-containing layer for use in the invention is preferably from 0 to 10% by weight, more preferably from 0.005 to 5% by weight, particularly preferably from 0.01 to 3% by weight, based on the total solid content of the fine particle-containing layer.

The dry coating amount of the fine particle-containing layer for use in the invention is preferably from 0.001 to 0.5 $g/m^2$, more preferably from 0.003 to 0.3 $g/m^2$, particularly preferably from 0.01 to 0.15 $g/m^2$. In the dry coating amount described above, the developing property and stain resistance in the non-image area and the printing durability of the image area are preferable.

The fine particle-containing layer according to the invention can be formed according to a known method. For instance, a solution containing the organic resin fine particle and other components, if desired in an appropriate solvent, for example, water, methanol, ethanol, 1-methoxy-2-propanol, 2-propanol, acetonitrile, acetone, methyl ethyl ketone, cyclohexanone, γ-butyrolactone, tetrahydrofuran, 1,4-dioxane, sulfolane, dimethylsulfoxide, dimethylformamide, dimethylacetamide, N-methyl-2-pyrolidinone or tetramethylurea is coated on the support according to a conventional method to form the fine particle-containing layer.

The fine particle-containing layer for use in the invention does not contain the light-to-heat conversion agent described in paragraph number [0019] of JP-A-2001-337460.

According to the lithographic printing plate precursor of the invention, by using the fine particle-containing layer, the organic resin fine particles are removed, for example, by rubbing with a brash at the time of development to reveal the surface of aluminum support, thereby forming the hydrophilic non-image area. On the other hand, in the image area, the organic resin fine particles are connected upon the radical polymerization occurred in the photosensitive layer to adhere at multi-points to the support, thereby increasing the adhesion. Due to the adhesion and the strength of the crosslinked photosensitive layer, the image area which withstands the rubbing with a brash at the time of development and external force (for example, peel force or abrasion force) at the time of printing and exhibits high printing durability is formed. Thus, the lithographic printing plate precursor of a simple processing type which achieves a good balance between the printing durability and the stain resistance can be obtained.

[Photosensitive layer]

The photosensitive layer for use in the lithographic printing plate precursor according to the invention contains (a) a radical polymerizable compound, (b) a binder polymer, (c) an initiator and (d) a sensitizing dye having an absorption maximum in a wavelength range of 350 to 450 nm.

The components of the photosensitive layer will be described below.

(a) Radical polymerizable compound

The radical polymerizable compound (hereinafter also simply referred to as a "polymerizable compound") for use in the photosensitive layer according to the invention is an addition-polymerizable compound having at least one ethylenically unsaturated double bond, and it is selected from compounds having at least one, preferably two or more, terminal ethylenically unsaturated double bonds. Such compounds are widely known in the art and they can be used in the invention without any particular limitation. The compound has a chemical form, for example, a monomer, a prepolymer, specifically, a dimer, a trimer or an oligomer, or a copolymer thereof, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with an aliphatic polyhydric alcohol compound and amides of an unsaturated carboxylic acid with an aliphatic polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of

an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of an aliphatic polyhydric alcohol compound with an unsaturated carboxylic acid, include acrylic acid esters, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri (acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, isocyanuric acid ethylene oxide (EO) modified triacrylate or polyester acrylate oligomer;

methacrylic acid esters, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane or bis [p-(methacryloxyethoxy)phenyl]dimethylmethane;

itaconic acid esters, for example, ethylene glycol diitaconate, propylene glycol diitaconate, 1,3-butanediol diitaconate, 1,4-butanediol diitaconate, tetramethylene glycol diitaconate, pentaerythritol diitaconate or sorbitol tetraitaconate;

crotonic acid esters, for example, ethylene glycol dicrotonate, tetramethylene glycol dicrotonate, pentaerythritol dicrotonate or sorbitol tetracrotonate;

isocrotonic acid esters, for example, ethylene glycol diisocrotonate, pentaerythritol diisocrotonate or sorbitol tetraisocrotonate;

and maleic acid esters, for example, ethylene glycol dimaleate, triethylene glycol dimaleate, pentaerythritol dimaleate and sorbitol tetramaleate.

Other examples of the ester, which can be preferably used, include aliphatic alcohol esters described in JP-B-51-47334 and JP-A-57-196231, esters having an aromatic skeleton described in JP-A-59-5240, JP-A-59-5241 and JP-A-2-226149, and esters containing an amino group described in JP-A-1-165613.

The above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferred examples of the amide monomer include amides having a cyclohexylene structure described in JP-B-54-21726.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

$$CH_2=C(R_4)COOCH_2CH(R_5)OH \qquad (A)$$

wherein $R_4$ and $R_5$ each independently represents H or $CH_3$.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Further, a photosensitive composition having remarkably excellent photo-speed can be obtained by using an addition polymerizable compound having an amino structure or a sulfide structure in its molecule, described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth) acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used.

Details of the method of using the polymerizable compound, for example, selection of the structure, individual or combination use or an amount added, can be appropriately determined in accordance with the characteristic design

of the final lithographic printing plate precursor. For instance, the compound is selected from the following standpoints.

In view of the sensitivity, a structure having a large content of unsaturated group per molecule is preferred and in many cases, a difunctional or more functional compound is preferred. Also, in order to increase the strength of the image area, that is, cured layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength.

The selection and use method of the polymerizable compound are also important factors for the compatibility and dispersibility with other components (for example, a binder polymer, a polymerization initiator or a coloring agent) in the photosensitive layer. For instance, the compatibility may be improved in some cases by using the compound of low purity or using two or more kinds of the compounds in combination. A specific structure may be selected for the purpose of improving an adhesion property to a support, a protective layer or the like described hereinafter.

The polymerizable compound is used preferably in a range of 5 to 80% by weight, more preferably in a range of 25 to 75% by weight, based on the total solid content of the photosensitive layer. The polymerizable compounds may be used individually or in combination of two or more thereof. In the method of using the polymerizable compound, the structure, blend and amount added can be appropriately selected by taking account of the degree of polymerization inhibition due to oxygen, resolution, fogging property, change in refractive index, surface tackiness and the like. Further, depending on the case, a layer construction, for example, an undercoat layer or an overcoat layer, and a coating method, may also be considered.

(d) Binder polymer

The binder polymer which can be used in the photosensitive layer according to the invention is preferably a water-insoluble polymer. Further, the binder polymer which can be used in the invention preferably does not substantially contain an acid group, for example, a carboxyl group, a sulfonic acid group or a phosphoric acid group. An acid value (acid content per g of polymer, indicated by the chemical equivalent number) of the binder polymer is preferably 0. 3 meq/g or less, more preferably 0.1 meq/g or less.

Specifically, the binder polymer which can be used in the invention is preferably insoluble in water and an aqueous solution having a pH of 10 or more. The solubility of the hydrophobic binder polymer in water or an aqueous solution having a pH of 10 or more is preferably 0.5% by weight or less, more preferably 0.1% by weight or less. By using such a binder polymer, film strength, water resistance and ink-receptive property of the photosensitive layer are increased and improvement in printing durability can be achieved.

As for the binder polymer, conventionally known binder polymers preferably having the characteristics in the above-described range can be used without limitation as long as the performances of the lithographic printing plate of the invention are not impaired, and a linear organic polymer having film-forming property is preferred.

Preferable examples of such a binder polymer include a polymer selected from an acrylic resin, a vinyl acetal resin, a urethane resin, an amide resin, an epoxy resin, a methacrylic resin, a styrene resin, an ester resin, a carbonate resin and a vinyl resin. Among them, an acrylic resin, a methacrylic resin and a urethane resin are preferred, and a (meth)acrylic acid ester copolymer is more preferred. More specifically, a copolymer of a (meth)acrylic acid alkyl or aralkyl ester with a (meth)acrylic acid ester containing a $-CH_2CH_2O-$ or $-CH_2CH_2NH-$ unit in R of the ester residue (-COOR) of the (meth)acrylic acid ester is particularly preferred. The alkyl group in the (meth) acrylic acid alkyl ester is preferably an alkyl group having from 1 to 5 carbon atoms, more preferably a methyl group. Preferable examples of the (meth)acrylic acid aralkyl ester include benzyl (meth)acrylate.

The binder polymer can be imparted with a crosslinking property in order to increase the film strength of the image area.

In order to impart the crosslinking property to the binder polymer, a crosslinkable functional group is introduced into a main chain or side chain of the polymer. The crosslinkable functional group may be introduced by copolymerization or a polymer reaction.

The term "crosslinkable group" as used herein means a group capable of crosslinking the polymer binder in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bond group, an amino group or an epoxy group as a functional group capable of conducting an addition polymerization reaction. Also, a functional group capable of forming a radical upon irradiation with light may be used and such a crosslinkable group includes, for example, a thiol group, a halogen atom and an onium salt structure. Among them, the ethylenically unsaturated bond group is preferable, and functional groups represented by formulae (1) to (3) shown below are particularly preferable.

Formula (1):

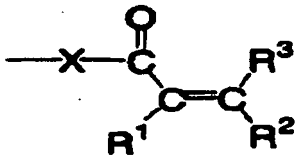

In formula (1), $R^1$ to $R^3$ each independently represents a hydrogen atom or a monovalent organic group. $R^1$ preferably includes, for example, a hydrogen atom or an alkyl group which may have a substituent. Among them, a hydrogen atom or a methyl group is preferable because of high radical reactivity. $R^2$ and $R^3$ each independently preferably includes, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.

X represents an oxygen atom, a sulfur atom or $-N(R^{12})-$, and $R^{12}$ represents a hydrogen atom or a monovalent organic group. The monovalent organic group represented by $R^{12}$ includes, for example, an alkyl group which may have a substituent. Among them, a hydrogen atom, a methyl group, an ethyl group or an isopropyl group is preferable for $R^{12}$ because of high radical reactivity.

Examples of the substituent introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

Formula (2):

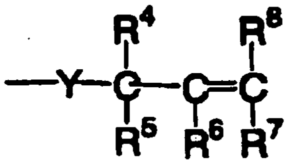

In formula (2), $R^4$ to $R^8$ each independently represents a hydrogen atom or a monovalent organic group. $R^4$ to $R^8$ each independently preferably includes, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable. Examples of the substituent introduced include those described in Formula (1).

Y represents an oxygen atom, a sulfur atom or $-N(R^{12})-$, and $R^{12}$ has the same meaning as $R^{12}$ defined in Formula (1). Preferable examples for $R^{12}$ are also same as those described in Formula (1).

Formula (3):

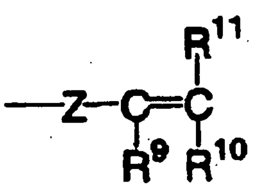

In formula (3), $R^9$ to $R^{11}$ each independently represents a hydrogen atom or a monovalent organic group. The monovalent organic group includes, for example, an alkyl group which may have a substituent. A hydrogen atom or a methyl group is preferable for $R^9$ because of high radical reactivity. $R^{10}$ and $R^{11}$ each independently preferably includes, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity. Examples of the substituent introduced include those described in Formula (1).

Z represents an oxygen atom, a sulfur atom, $-N(R^{13})-$ or a phenylene group which may have a substituent. $R^{13}$ includes an alkyl group which may have a substituent or the like. Among them, a methyl group, an ethyl group or an isopropyl group is preferable for $R^{13}$ because of high radical reactivity.

Among the polymers, a (meth)acrylic acid copolymer and a polyurethane each having a crosslinkable functional group in the side chain thereof are more preferable.

In the binder polymer having a crosslinking property, for example, a free radical (a polymerization initiating radical or a propagating radical in the process of polymerization of the polymerizable compound) generated upon the image exposure is added to the crosslinkable functional group to cause addition-polymerization between polymers directly or through a polymerization chain of the polymerizable compound, as a result, crosslinking is formed between polymer molecules to effect curing. Alternatively, an atom (for example, a hydrogen atom on the carbon atom adjacent to the functional crosslinkable group) in the polymer is withdrawn by a free radical to produce a polymer radical and the polymer radicals are combined with each other to form crosslinking between polymer molecules to effect curing.

The content of the crosslinkable functional group (content of radical-polymerizable unsaturated double bond determined by iodine titration) in the binder polymer is preferably from 0.1 to 10.0 mmol, more preferably from 1.0 to 7. 0 mmol, most preferably from 2.0 to 5.5 mmol, per g of the binder polymer.

In view of improvement in the developing property with an aqueous solution, the binder polymer is preferably hydrophilic. On the other hand, in view of increasing the printing durability, it is important that the binder polymer has good compatibility with the polymerizable compound contained in the photosensitive layer, that is, the binder polymer is preferably oleophilic. From these standpoints, it is also effective in the invention to copolymerize a hydrophilic group-containing component and an oleophilic group-containing component in the binder polymer in order to improve the developing property and printing durability. Examples of the hydrophilic group-containing component preferably include components having a hydrophilic group, for example, a hydroxy group, a carboxylate group, a hydroxyethyl group, an ethyleneoxy group, a hydroxypropyl group, a polyoxyethyl group, a polyoxypropyl group, an amino group, an aminoethyl group, an aminopropyl group, an ammonium group, an amido group and a carboxymethyl group.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymer may be any of a random polymer, a block polymer, a graft polymer and the like, and it is preferably a random polymer.

The binder polymers may be used individually or in combination of two or more thereof.

The content of the binder polymer is ordinarily from 5 to 90% by weight, preferably from 10 to 70% by weight, more preferably from 10 to 60% by weight, based on the total solid content of the photosensitive layer. In the range described above, preferable strength of the image area and good image-forming property are obtained.

(c) Initiator

The initiator (hereinafter also referred to as a "polymerization initiator") for use in the photosensitive layer according to the invention is a compound which generates a radical with light energy to initiate or accelerate polymerization of the polymerizable compound. The polymerization initiator is appropriately selected to use, for example, from known polymerization initiators and compounds containing a bond having small bond dissociation energy.

The polymerization initiator includes, for example, an organic halogen compound, a carbonyl compound, an organic peroxide, an azo compound, an azido compound, a metallocene compound, a hexaarylbiimidazole compound, an organic boron compound, a disulfone compound, an oxime ester compound and an onium salt compound.

The organic halogen compounds described above specifically include, for example, compounds described in Wakabayashi et al., Bull. Chem. Soc. Japan, 42, 2924 (1969), U.S. Patent 3,905,815, JP-B-46-4605, JP.-A-48-36281, JP-A-53-133428, JP-A-55-32070, JP-A-60-239736, JP-A-61-169835, JP-A-61-169837, JP-A-62-58241, JP-A-62-212401, JP-A-63-70243, JP-A-63-298339 and M. P. Hutt, Journal of Heterocyclic Chemistry, 1, No. 3 (1970). Among

them, oxazole compounds and s-triazine compounds each substituted with a trihalomethyl group are preferable.

More preferably, s-triazine derivatives in which at least one of mono-, di- or tri-halogen substituted methyl group is connected to the s-triazine ring and oxazole derivatives in which at least one of mono-, di- or tri-halogen substituted methyl group is connected to the oxazole ring are exemplified. Specific examples thereof include

2,4,6-tris(monochloromethyl)-s-triazine,
2,4,6-tris(dichloromethyl)-s-triazine,
2,4,6-tris(trichloromethyl)-s-triazine,
2-methyl-4,6-bis(trichloromethyl)-s-triazine,
2-n-propyl-4,6-bis(trichloromethyl)-s-triazine,
2-(α,α,β-trichloroethyl)-4,6-bis(trichloromethyl)-s-triazine,
2-(3,4-epoxyphenyl)-4,6-bis(trichloromethyl)-s-triazine,
2-[1-(p-methoxyphenyl)-2,4-butadienyl]-4,6-bis(trichloromethy
1)-s-triazine, 2-styryl-4,6-bis(trichloromethyl)-s-triazine,
2-(p-methoxystyryl-4,6-bis(trichloromethyl)-s-triazine,
2-(p-isopropyloxystyryl-4,6-bis(trichloromethyl)-s-triazine,
2-(p-tolyl)-4,6-bis(trichloromethyl)-s-triazine,
2-(4-methoxynaphthyl)-4,6-bis(trichloromethyl)-s-triazine,
2-phenylthio-4,6-bis(trichloromethyl)-s-triazine,
2-benzylthio-4,6-bis(trichloromethyl)-s-triazine,
2,4,6-tris(dibromomethyl)-s-triazine,
2,4,6-tris(tribromomethyl)-s-triazine,
2-methyl-4,6-bis(tribromomethyl)-s-triazine,
2-methoxy-4,6-bis(tribromomethyl)-s-triazine and compounds shown below.

(I)-1
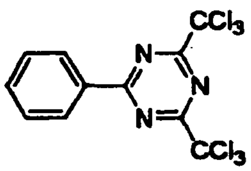

(I)-2
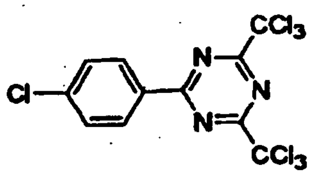

(I)-3
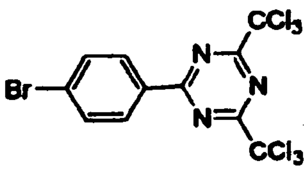

(I)-4
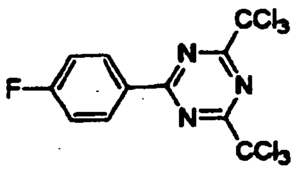

(I)-5
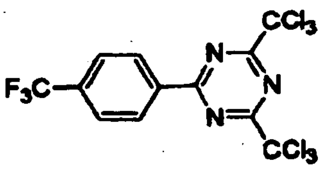

(I)-6
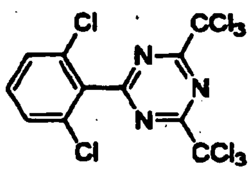

(I)-7
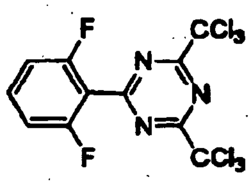

(I)-8
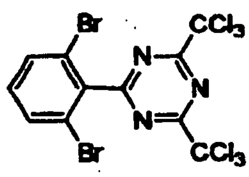

(I)-9

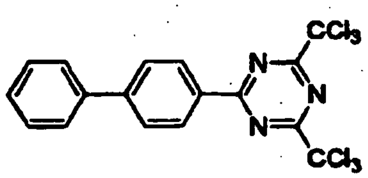

(I)-10

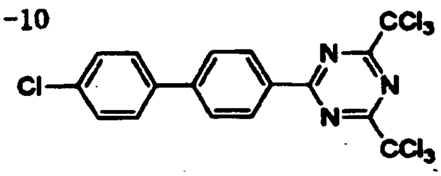

(I)-11

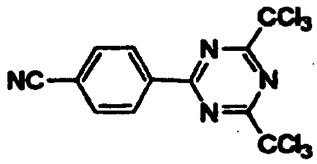

(I)-12

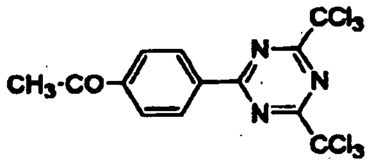

(I)-13

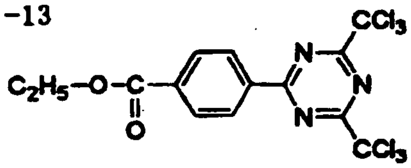

(I)-14

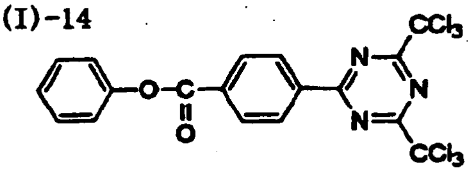

(I)-15

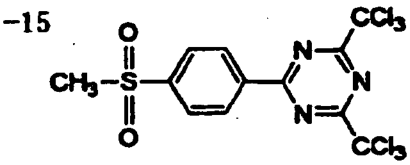

(I)-16

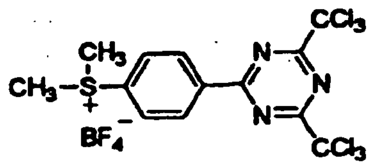

(I)-17

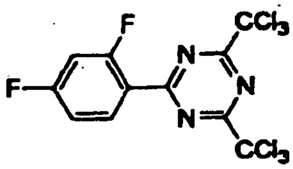

(I)-18

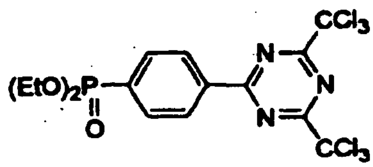

(I)-19

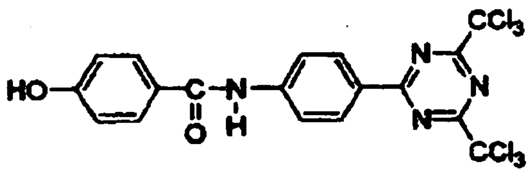

(I)-20

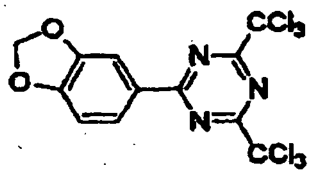

(I)-21

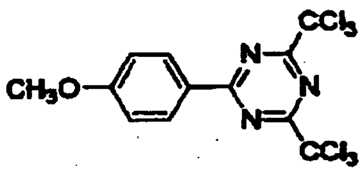

(I)-22

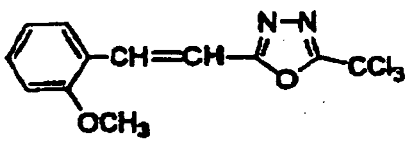

(I)-23

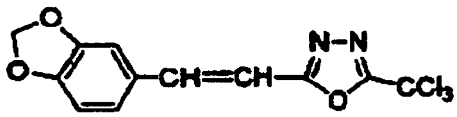

(I)-24

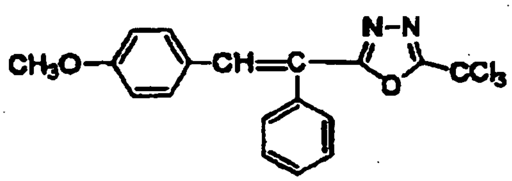

(I)-25

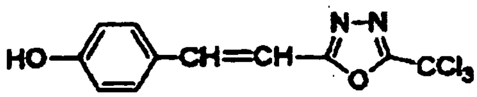

(I)-26

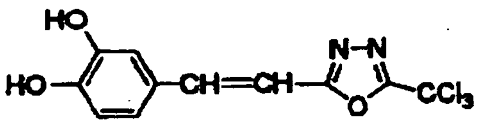

(I)-27

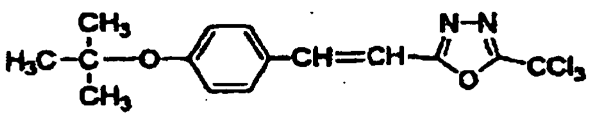

The carbonyl compounds described above include, for example, benzophenone derivatives, e.g., benzophenone, Michler's ketone,

2-methylbenzophenone, 3-methylbenzophenone,
4-methylbenzophenone, 2-chlorobenzophenone,
4-bromobenzophenone or 2-carboxybenzophenone, acetophenone derivatives, e.g., 2,2-dimethoxy-2-phenylacetophenone,

2,2-diethoxyacetophenone, 1-hydroxycyclohexylphenylketone, α-hydroxy-2-methylphenylpropane,
1-hydroxy-1-methylethyl-(p-isopropylphenyl)ketone,
1-hydroxy-1-(p-dodecylphenyl)ketone,
2-methyl-(4'-(methylthio)phenyl)-2-morpholino-1-propane or
1,1,1,-trichloromethyl-(p-butylphenyl)ketone, thioxantone derivatives, e.g., thioxantone, 2-ethylthioxantone,
2-isopropylthioxantone, 2-chlorothioxantone,
2,4-dimetylthioxantone, 2,4-dietylthioxantone or
2,4-diisopropylthioxantone, and benzoic acid ester derivatives, e.g., ethyl p-dimethylaminobenzoate or ethyl p-diethylaminobenzoate.

The azo compounds described above include, for example, azo compounds described in JP-A-8-108621.
The organic peroxides described above include, for example, trimethylcyclohexanone peroxide, acetylacetone peroxide,

1,1-bis(tert-butylperoxy)-3,3,5-trimethylcyclohexane,
1,1-bis(tert-butylperoxy)cyclohexane,
2,2-bis(tert-butylperoxy)butane, tert-butylhydroperoxide, cumene hydroperoxide, diisopropylbenzene hydroperoxide,
2,5-dimethylhexane-2,5-dihydroperoxide,
1,1,3,3-tetramethylbutyl hydroperoxide, tert-butylcumyl peroxide, dicumyl peroxide,
2,5-dimethyl-2,5-di(tert-butylperoxy)hexane, 2,5-oxanoyl peroxide, peroxy succinic acid, benzoyl peroxide,
2,4-dichlorobenzoyl peroxide, diisopropylperoxy dicarbonate, di-2-ethylhexylperoxy dicarbonate, di-2-ethoxyethylperoxy
dicarbonate, dimethoxyisopropylperoxy dicarbonate,
di(3-methyl-3-methoxybutyl)peroxy dicarbonate,
tert-butylperoxy acetate, tert-butylperoxy pivalate,
tert-butylperoxy neodecanoate, tert-butylperoxy octanoate,
tert-butylperoxy laurate, tersyl carbonate,
3,3',4,4'-tetra(tert-butylperoxycarbonyl)benzophenone,
3,3',4,4'-tetra(tert-hexylperoxycarbonyl)benzophenone,
3,3',4,4'-tetra(p-isopropylcumylperoxycarbonyl)benzophenone, carbonyl di(tert-butylperoxydihydrogen diphthalate) and carbonyl di(tert-hexylperoxydihydrogen diphthalate).

The metallocene compounds described above include, for example, various titanocene compounds described in JP-A-59-152396, JP-A-61-151197, JP-A-63-41484, JP-A-2-249, JP-A-2-4705 and JP-A-5-83588, for example, dicyclopentadienyl-Ti-bisphenyl,

dicyclopentadienyl-Ti-bis-2,6-difluorophen-1-yl,
dicyclopentadienyl-Ti-bis-2,4-difluorophen-1-yl,
dicyclopentadienyl-Ti-bis-2,4,6-triafluorophen-1-yl,
dicyclopentadienyl-Ti-bis-2,3,5,6-tetrafluorophen-1-yl,
dicyclopentadienyl-Ti-bis-2,3,4,5,6-pentafluorophen-1-yl,
dimethylcyclopentadienyl-Ti-bis-2,6-difluorophen-1-yl,
dimethylcyclopentadienyl-Ti-bis-2,4,6-triafluorophen-1-yl,
dimethylcyclopentadienyl-Ti-bis-2,3,5,6-tetrafluorophen-1-yl,
dimethylcyclopentadienyl-Ti-bis-2,3,4,5,6-pentafluorophen-1-y 1, or
bis(cyclopentadienyl)-bis(2,6-difluoro-3-(pyr-1-yl)phenyl)
titanium and iron-arene complexes described in JP-A-1-304453 and JP-A-1-152109.

The hexaarylbiimidazole compounds described above include, for example, various compounds described in JP-B-6-29285 and U.S. Patents 3,479,185, 4,311,783 and 4,622,286, specifically, for example,

2,2'-bis(o-chlorophenyl)-4,4',5,5'-tetraphenylbiimidazole,
2,2'-bis(o-bromophenyl)-4,4',5,5'-tetraphenylbiimidazole,
2,2'-bis(o,p-dichlorophenyl)-4,4',5,5'-tetraphenylbiimidazole,
2,2'-bis(o-chlorophenyl)-4,4',5,5'-tetra(m-methoxyphenyl)biim idazole,
2,2'-bis(o,o'-dichlorophenyl)-4,4',5,5'-tetraphenylbiimidazol e, 2,2'-bis(o-nitrophenyl)-4.,4',5,5'-tetraphenylbiimidazole,

2,2'-bis(o-methylphenyl)-4,4',5,5'-tetraphenylbiimidazole and
2,2'-bis(o-trifluoromethylphenyl)-4,4',5,5'-tetraphenylbiimid azole.

The organic boron compounds described above include, for example, organic boric acid salts described in JP-A-62-143044, JP-A-62-150242, JP-A-9-188685, JP-A-9-188686, JP-A-9-188710, JP-A-2000-131837, JP-A-2002-107916, Japanese Patent 2764769, JP-A-2002-116539 and Martin Kunz, Rad Tech' 98, Proceeding, April 19-22 (1998), Chicago, organic boron sulfonium complexes or organic boron oxosulfonium complexes described in JP-A-6-157623, JP-A-6-175564 and JP-A-6-175561, organic boron iodonium complexes described in JP-A-6-175554 and JP-A-6-175553, organic boron phosphonium complexes described in JP-A-9-188710, and organic boron transition metal coordination complexes described in JP-A-6-348011, JP-A-7-128785, JP-A-7-140589, JP-A-7-306527 and JP-A-7-292014.

The disulfone compounds described above include, for example, compounds described in JP-A-61-166544 and JP-A-2002-328465.

The oxime ester compounds described above include, for example, compounds described in J. C. S. Perkin II, 1653-1660 (1979), J. C. S. Perkin II, 156-162 (1979), Journal of Photopolymer Science and Technology, 202-232 (1995) and JP-A-2000-66385, and compounds described in JP-A-2000-80068. Specific examples thereof include compounds represented by the following structural formulae:

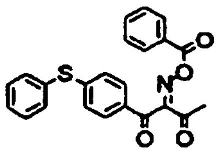 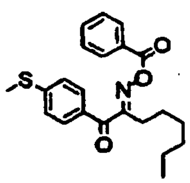 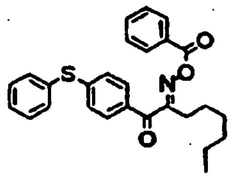 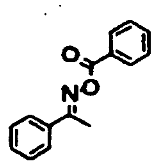 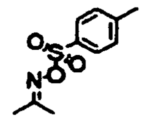

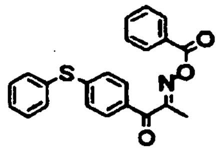 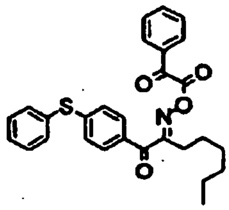 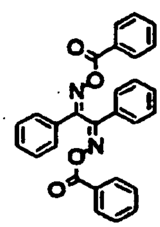 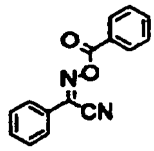 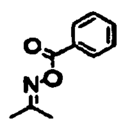

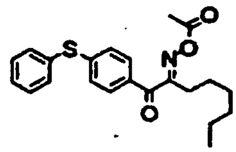 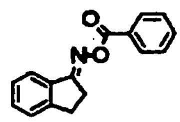 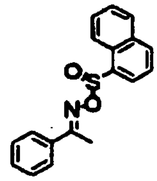 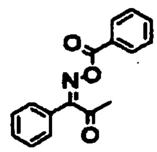 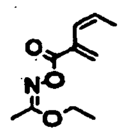

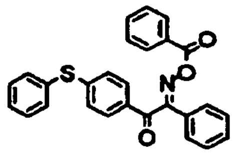 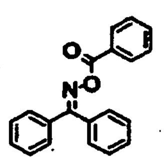 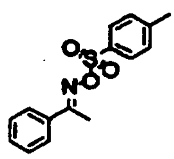 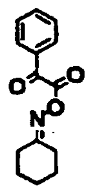 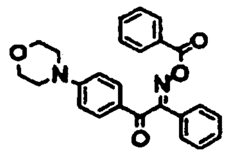

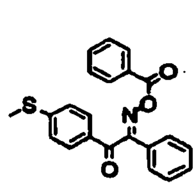 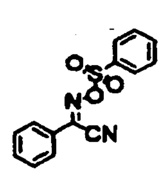

The onium salt compounds described above include, for example, diazonium salts described in S. I. Schlesinger, Photogr. Sci. Eng., 18, 387 (1974) and T. S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U.S. Patents 339,049 and 410,201, JP-A-2-150848 and JP-A-2-296514, sulfonium salts described in European Patents 370,693, 390,214, 233,567, 297,443 and 297,442, U.S. Patents 4,933,377, 161,811, 410,201, 339,049, 4,760,013, 4,734,444 and 2, 833, 827 and German Patents 2, 904, 626, 3, 604, 580 and 3,604,581, selenonium salts described in J.V. Crivello et al. , Macromolecules, 10 (6), 1307 (1977) and J.V. Crivello et al., J. Polymer Sci., Polymer Chem. Ed., 17, 1047 (1979), and arsonium salts described in C.S. Wen et al., Teh, Proc. Conf. Rad. Curing ASIA, p. 478, Tokyo, Oct. (1988).

In the invention, the onium salt functions not as an acid generator, but as an ionic radical polymerization initiator.

The onium salts preferably used in the invention include onium salts represented by the following formulae (RI-I) to (RI-III):

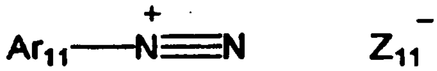

(RI-I)

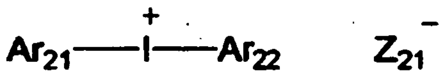

(RI-II)

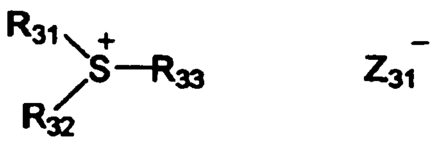

(RI-III)

In formula (RI-I), $Ar_{11}$ represents an aryl group having 20 or less carbon atoms, which may have 1 to 6 substituents. Preferable examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylimino group having from 1 to 12 carbon atoms, an alkylamido group or arylamido having from 1 to 12 carbon atoms, a carbonyl group, a carboxyl group, a cyano group, a sulfonyl group, an thioalkyl group having from 1 to 12 carbon atoms and an thioaryl group having from 1 to 12 carbon atoms. $Z_{11}^-$ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion and a sulfate ion. Among them, a perchlorate ion, a hexafluorophosphate ion, a tetrafluoroborate ion, a sulfonate ion and a sulfinate ion are preferred in view of stability.

In the formula (RI-II), $Ar_{21}$ and $Ar_{22}$ each independently represents an aryl group having 20 or less carbon atoms, which may have 1 to 6 substituents. Preferable examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylimino group having from 1 to 12 carbon atoms, an alkylamido group or arylamido group having from 1 to 12 carbon atoms, a carbonyl group, a carboxyl group, a cyano group, a sulfonyl group, an thioalkyl group having from 1 to 12 carbon atoms and an thioaryl group having from 1 to 12 carbon atoms. $Z_{21}^-$ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity.

In the formula (RI-III), $R_{31}$, $R_{32}$ and $R_{33}$ each independently represents an aryl group having 20 or less carbon atoms, which may have 1 to 6 substituents, an alkyl group, an alkenyl group or an alkynyl group. Among them, the aryl group is preferred in view of reactivity and stability. Preferable examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an

aryloxy group having from 1 to 12 carbon atoms, a halogen atom, an alkylamino group having from 1 to 12 carbon atoms, a dialkylimino group having from 1 to 12 carbon atoms, an alkylamido group or arylamido group having from 1 to 12 carbon atoms, a carbonyl group, a carboxyl group, a cyano group, a sulfonyl group, an thioalkyl group having from 1 to 12 carbon atoms and an thioaryl group having from 1 to 12 carbon atoms. $Z_{31}^-$ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity. Carboxylate ions described in JP-A-2001-343742 are more preferable, and carboxylate ions described in JP-A-2002-148790 are particularly preferable.

Specific examples of the onium salt are set forth below, but the invention should not be construed as being limited thereto.

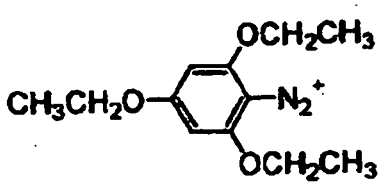 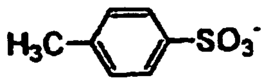 (N-1)

$PF_6^-$ (N-2)

$PF_6^-$ (N-2)

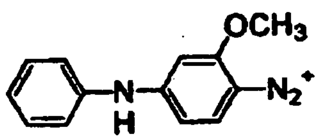 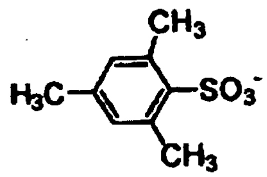 (N-3)

$ClO_4^-$ (N-4)

$PF_6^-$ (N-5)

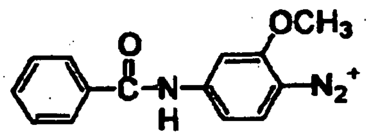 $CF_3SO_3^-$ (N-6)

$BF_4^-$ (N-7)

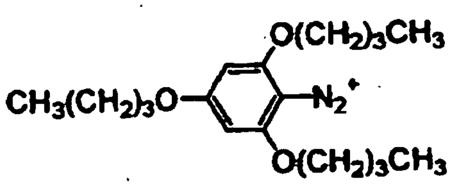 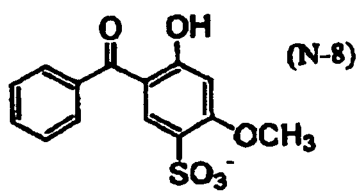 (N-8)

$ClO_4^-$ (N-9)

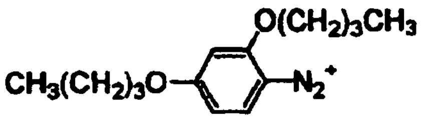 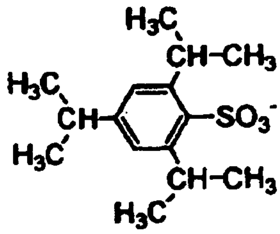 (N-10)

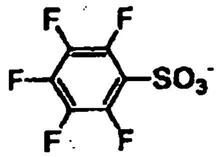 (N-11)

$PF_6^-$ (N-12)

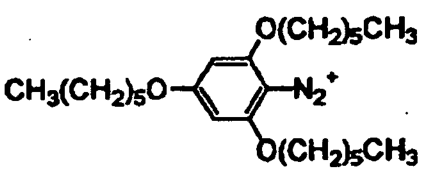 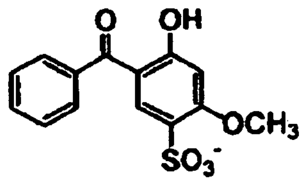 (N-13)

$ClO_4^-$ (N-14)

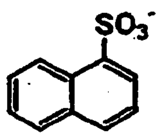 (N-15)

$PF_6^-$ (N-16)

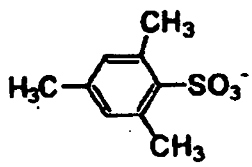 (N-17)

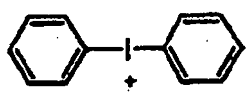 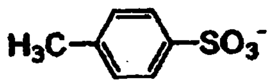 (I-1)

$PF_6^-$ (I-2)

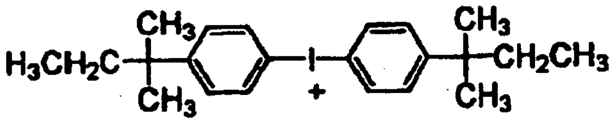

$PF_6^-$ (I-3)

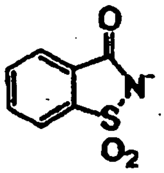

(I-9)

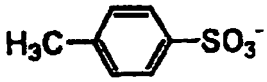

(I-4)

$ClO_4^-$ (I-5)

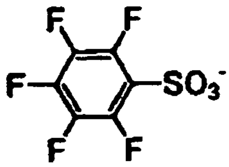

(I-6)

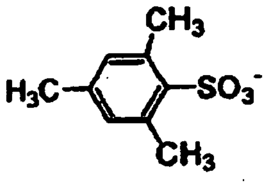

(I-11)

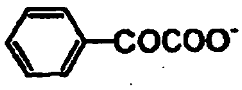

(I-7)

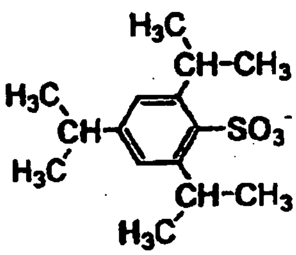

(I-12)

$CF_3SO_3^-$ (I-8)

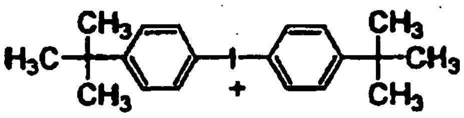
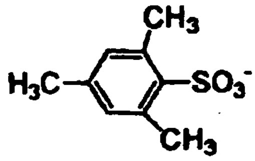

(I-13)

$ClO_4^-$ (I-14)

$PF_6^-$ (I-15)

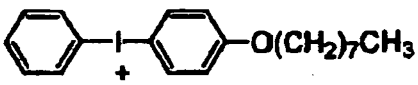
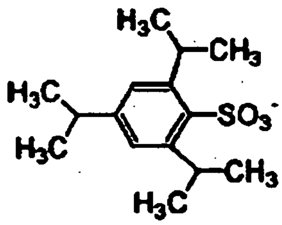

(I-16)

$CF_3COO^-$ (I-17)

$CF_3SO_3^-$ (I-18)

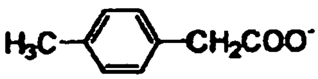

(I-19)

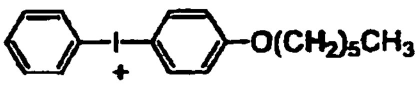
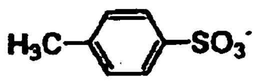

(I-20)

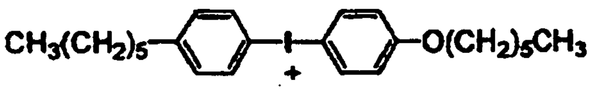
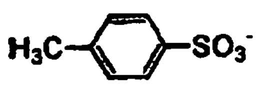

(I-21)

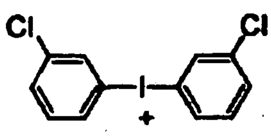

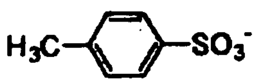

(I-23)

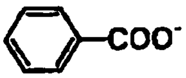

(I-18)

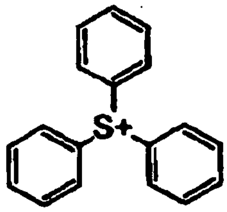

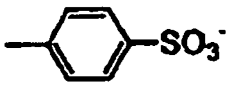

(S-1)

$PF_6^-$ (S-2)

$ClO_4^-$ (S-3)

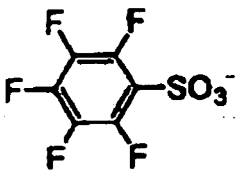

(S-4)

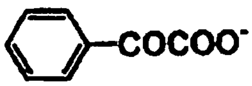

(S-5)

$CF_3SO_3^-$ (S-6)

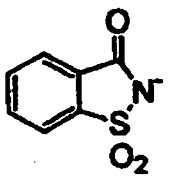

(S-7)

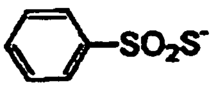

(S-8)

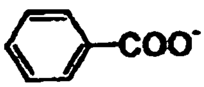

(S-9)

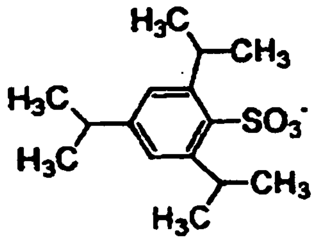

(S-10)

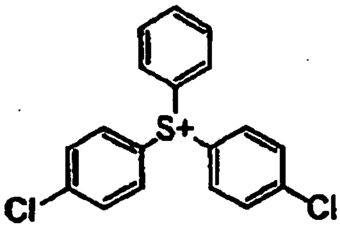

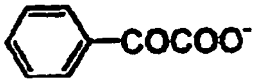

(S-11)

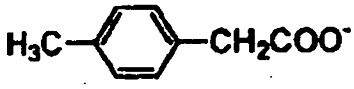

(S-12)

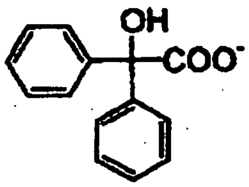

(S-13)

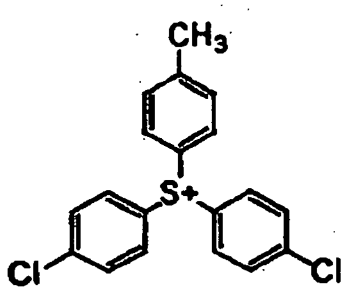

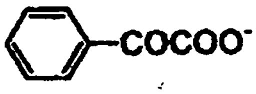

(S-14)

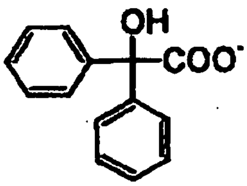

(S-15)

$BF_4^-$ (S-16)

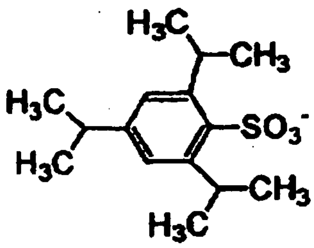

(S-17)

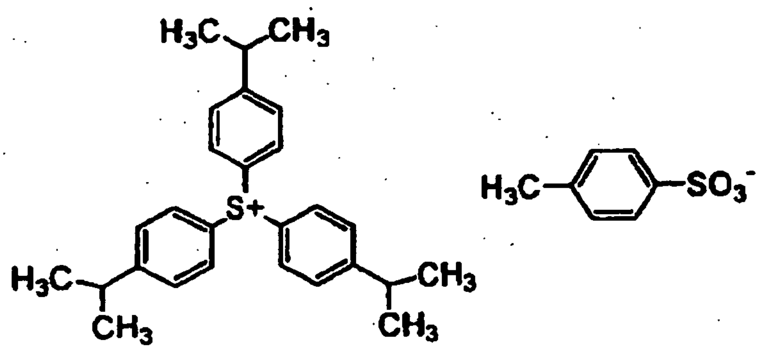

(S-18)

The polymerization initiator is not limited to those described above. In particular, from the standpoint of reactivity and stability, the triazine type initiators, organic halogen compounds, oxime ester compounds, metallocene compounds, hexaarylbiimidazole compounds, diazonium compounds, iodonium compounds and sulfonium compounds are preferable.

The polymerization initiators may be used individually or in combination of two or more thereof. Also, the polymerization initiator may be added together with other components in one layer or may be added to a different layer separately provided. The polymerization initiator can be added preferably in an amount from 0.1 to 50% by weight, more preferably from 0. 5 to 30% by weight, particularly preferably from 0.8 to 20% by weight, based on the total solid content of the photosensitive layer.

(d) Sensitizing dye having absorption maximum in wavelength range of 350 to 450 nm

The sensitizing dye having an absorption maximum in a wavelength range of 350 to 450 nm for use in the photosensitive layer according to the invention includes, for example, merocyanine dyes represented by formula (I) shown below, benzopyranes or coumarins represented by formula (II) shown below, aromatic ketones represented by formula (III) shown below and anthracenes represented by formula (IV) shown below.

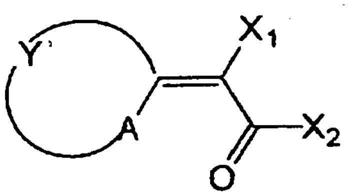

( I )

In formula (I), A represents a sulfur atom or $NR_6$, $R_6$ represents a monovalent non-metallic atomic group, Y represents a non-metallic atomic group necessary for forming a basic nucleus of the dye together with adjacent A and the adjacent carbon atom, and $X_1$ and $X_2$ each independently represents a monovalent non-metallic atomic group or $X_1$ and $X_2$ may be combined with each other to form an acidic nucleus of the dye.

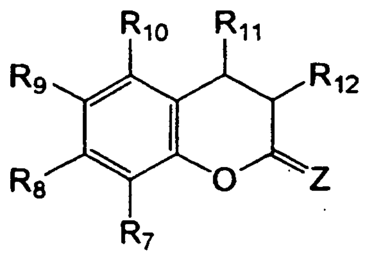

(II)

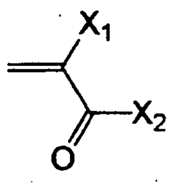

( I ' )

In formula (II), =Z represents an oxo group, a thioxo group, an imino group or an alkylydene group represented by the partial structural formula (1') described above, $X_1$ and $X_2$ have the same meanings as those defined in formula (I) respectively, and $R_7$ to $R_{12}$ each independently represents a monovalent non-metallic atomic group.

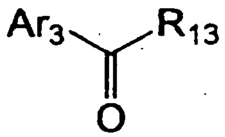

(III)

In formula (III), $Ar_3$ represents an aromatic group which may have a substituent or a heteroaromatic group which may have a substituent, and $R_{13}$ represents a monovalent non-metallic atomic group. $R_{13}$ preferably represents an aromatic group or a heteroaromatic group. $Ar_3$ and $R_{13}$ may be combined with each other to form a ring.

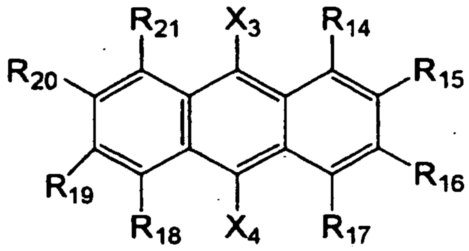

(I V)

In formula (IV), $X_3$, $X_4$ and $R_{14}$ to $R_{21}$ each independently represents a monovalent non-metallic atomic group. Preferably, $X_3$ and $X_4$ each independently represents an electron-donating group having a negative Hammett substituent constant.

In formulae (I) to (IV), preferable examples of the monovalent non-metallic atomic group represented by any one of $X_1$ to $X_4$ and $R_6$ to $R_{21}$ include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group,
a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group or a 3-butynyl group), an aryl group (for example, a phenyl group, a biphenyl group, a naphthyl group, a tolyl group, a xylyl group,
a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group or a phosphonatophenyl group) , a heteroaryl group (for example, a group derived from a heteroaryl ring, for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrine, acridine, perimidine, phenanthroline, phthalazine, phenarsazine, phenoxazine, furazane or phenoxazine), an alkenyl group (for example, a vinyl group, a 1-propenyl

group, a 1-butenyl group, a cinnamyl group or a 2-chloro-1-ethenyl group) , an alkynyl group (for example, an ethynyl group, a 1-propynyl group, a 1-butynyl group or a trimethylsilylethynyl group) , a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and its conjugated base group (hereinafter referred to as a "phosphonato group"), a dialkylphosphono group ($-PO_3(alkyl)_2$), a diarylphosphono group ($-PO_3(aryl)_2$), an alkylarylphosphono group ($-PO_3(alkyl)(aryl)$), a monoalkylphosphono group ($-PO_3H(alkyl)$) and its conjugated base group (hereinafter referred to as an "alkylphosphonato group"), a monoarylphosphono group ($-PO_3H(aryl)$) and its conjugated base group (hereinafter referred to as an "arylphosphonato group"), a phosphonooxy group ($-OPO_3H_2$) and its conjugated base group (hereinafter referred to as a "phosphonatooxy group"), a dialkylphosphonooxy group ($-OPO_3(alkyl)_2$), a diarylphosphonooxy group ($-OPO_3(aryl)_2$), an alkylarylphosphonooxy group ($-OPO_3(alkyl)(aryl)$), a monoalkylphosphonooxy group ($-OPO_3H(alkyl)$) and its conjugated base group (hereinafter referred to as an "alkylphosphonatooxy group"), a monoarylphosphonooxy group ($-OPO_3H(aryl)$) and its conjugated base group (hereinafter referred to as an "arylphosphonatooxy group"), a cyano group and a nitro group. Among the above-described groups, a hydrogen atom, an alkyl group, an aryl group, a halogen atom, an alkoxy group and an acyl group are particularly preferred.

The basic nucleus of the dye formed by Y together with the adjacent A and the adjacent carbon atom in formula (I) includes, for example, a 5-membered, 6-membered or 7-membered, nitrogen-containing or sulfur-containing heterocyclic ring, and is preferably a 5-membered or 6-membered heterocyclic ring.

As the nitrogen-containing heterocyclic ring, those which are known to constitute basic nuclei in merocyanine dyes described in L.G. Brooker et al, J. Am. Chem. Soc., Vol. 73, pp. 5326 to 5358 (1951) and references cited therein can be preferably used. Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenyl)thiazole or 4-(2-thienyl)thiazole); benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole or 5-ethoxycarbonylbenzothiazole); naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole or 7-methoxynaphtho[1,2]thiazole); thianaphtheno-7',6',4,5-thiazoles (for example, 4'-methoxythianaphtheno-7',6',4,5-thiazole); oxazoles (for example, 4-methyloxazole, 5-methyloxazole, 4-phenyloxazole, 4,5-diphenyloxazole, 4-ethyloxazole, 4,5-dimethyloxazole or 5-phenyloxazole); benzoxazoles (for example, benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole or 6-hydroxybenzoxazole); naphthoxazoles (for example, naphth[1,2]oxazole or naphth[2,1]oxazole); selenazoles (for example, 4-methylselenazole or 4-phenylselenazole); benzoselenazoles (for example, benzoselenazole, 5-chlorobenzoselenazole, 5-methoxybenzoselenazole, 5-hydroxybenzoselenazole or tetrahydrobenzoselenazole); naphthoselenazoles (for example, naphtho[1,2]selenazole or naphtho[2,1]selenazole); thiazolines (for example, thiazoline or 4-methylthiazoline); quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline or 8-hydroxyquinoline); isoquinolines (for example, isoquinoline or 3,4-dihydroisoquinoline);
benzimidazoles (for example, 1,3-diethylbenzimidazole or 1-ethyl-3-phenylbenzimidazole); 3,3-dialkylindolenines (for example, 3,3-dimethylindolenine, 3,3,5-trimethylindolenine or 3,3,7-trimethylindolenine); and pyridines (for example, pyridine or 5-methylpyridine).

Examples of the sulfur-containing heterocyclic ring include dithiol partial structures in dyes described in JP-A-3-296759.

Specific examples thereof include benzodithiols (for example, benzodithiol, 5-tert-butylbenzodithiol or 5-methylbenzodithiol); naphthodithiols (for example, naphtho[1,2]dithiol or naphtho[2,1]dithiol); and dithiols (for example, 4,5-dimethyldithiol, 4-phenyldithiol, 4-methoxycarbonyldithiol, 4,5-dimethoxycarbonyldithiol, 4,5-ditrifluoromethyldithiol, 4,5-dicyanodithiol, 4-methoxycarbonylmethyldithiol or 4-carboxymethyldithiol).

In the description with respect to the heterocyclic ring above, for convenience and by convention, the names of heterocyclic mother skeletons are used. In the case of constituting the basic nucleus partial structure in the sensitizing dye, the heterocyclic ring is introduced in the form of a substituent of alkylydene type where a degree of unsaturation is decreased one step. For example, a benzothiazole skeleton is introduced as a 3-substituted-2(3H)-benzothiazolilydene group.

Of the sensitizing dyes having an absorption maximum in a wavelength range of 350 to 450 nm, dyes represented by formula (V) shown below are more preferable in view of high sensitivity.

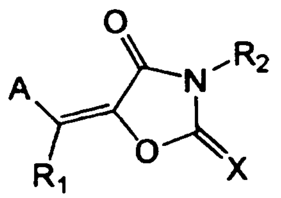

(V)

In formula (V), A represents an aromatic cyclic group which may have a substituent or a heterocyclic group which may have a substituent, X represents an oxygen atom, a sulfur atom or =N($R_3$), and $R_1$, $R_2$ and $R_3$ each independently represents a monovalent non-metallic atomic group, or A and $R_1$ or $R_2$ and $R_3$ may be combined with each other to form an aliphatic or aromatic ring.

The formula (V) will be described in more detail below. $R_1$, $R_2$ and $R_3$ each independently represents a monovalent non-metallic atomic group, preferably a substituted or unsubstituted alkyl group, a substituted or unsubstituted alkenyl group, a substituted or unsubstituted aryl group, a substituted or unsubstituted heteroaryl group, a substituted or unsubstituted alkoxy group, a substituted or unsubstituted alkylthio group, a hydroxy group or a halogen atom.

Preferable examples of $R_1$, $R_2$ and $R_3$ will be specifically described below. Preferable examples of the alkyl group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group, a monovalent non-metallic atomic group exclusive of a hydrogen atom is used. Preferable examples thereof include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N, N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido

group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and its conjugated base group (hereinafter referred to as a "phosphonato group"), a dialkylphosphono group ($-PO_3(alkyl)_2$), a diarylphosphono group ($-PO_3(aryl)_2$), an alkylarylphosphono group ($-PO_3(alkyl)(aryl)$), a monoalkylphosphono group ($-PO_3H(alkyl)$) and its conjugated base group (hereinafter referred to as an "alkylphosphonato group"), a monoarylphosphono group ($-PO_3H(aryl)$) and its conjugated base group (hereinafter referred to as an "arylphosphonato group"), a phosphonooxy group ($-OPO_3H_2$) and its conjugated base group (hereinafter referred to as a "phosphonatooxy group"), a dialkylphosphonooxy group ($-OPO_3(alkyl)_2$), a diarylphosphonooxy group ($-OPO_3(aryl)_2$), an alkylarylphosphonooxy group ($-OPO_3(alkyl)(aryl)$), a monoalkylphosphonooxy group ($-OPO_3H(alkyl)$) and its conjugated base group (hereinafter referred to as an "alkylphosphonatooxy group"), a monoarylphosphonooxy group ($-OPO_3H(aryl)$) and its conjugated base group (hereinafter referred to as an "arylphosphonatooxy group") , a cyano group, a nitro group, an aryl group, a heteroaryl group, an alkenyl group and an alkynyl group.

In the substituents, specific examples of the alkyl group include those described for the alkyl group above. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group and a phosphonatophenyl group.

Examples of the heteroaryl group include a monocyclic or polycyclic aromatic cyclic group containing at least one of a nitrogen atom, an oxygen atom and a sulfur atom. Examples of especially preferable heteroaryl group include a group derived from a heteroaryl ring, for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine. These groups may be benzo-fused or may have a substituent.

Examples of the alkenyl group include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl group and a trimethylsilylethynyl group. Examples of $G_1$ in the acyl group ($G_1CO-$) include a hydrogen atom and the above-described alkyl group and aryl group. Of the substituents, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonooxy group, a phosphonatooxy group, an aryl group and an alkenyl group are more preferable.

On the other hand, as an alkylene group in the substituted alkyl group, a divalent organic residue resulting from elimination of any one of hydrogen atoms on the above-described alkyl group having from 1 to 20 carbon atoms can be enumerated. Examples of preferable alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferable substituted alkyl group represented by any one of $R_1$, $R_2$ and $R_3$, which is obtained by combining the above-described substituent with the alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group,

an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropylgroup, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Preferable examples of the aryl group represented by any one of $R_1$, $R_2$ and $R_3$ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among them, a phenyl group and a naphthyl group are more preferable.

Specific examples of the preferable substituted aryl group represented by any one of $R_1$, $R_2$ and $R_3$ include aryl groups having a monovalent non-metallic atomic group exclusive of a hydrogen atom as a substituent on the ring-forming carbon atom of the above-described aryl group. Preferable examples of the substituent include the above-described alkyl groups and substituted alkyl groups, and the substituents described for the above-described substituted alkyl group. Specific examples of the preferable substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propynylphenyl group, a 2-butynylphenyl group and a 3-butynylphenyl group.

Specific examples of the preferable substituted or unsubstituted alkenyl group and the preferable substituted or unsubstituted heteroaryl group represented by any one of $R_1$, $R_2$ and $R_3$ include those described with respect to the alkenyl group and heteroaryl group above, respectively.

Next, A in formula (V) will be described below. A represents an aromatic cyclic group which may have a substituent or heterocyclic group which may have a substituent. Specific examples of the aromatic cyclic group which may have a substituent and heterocyclic group which may have a substituent include those described for the aryl group and heteroaryl group represented by any one of $R_1$, $R_2$ and $R_3$ in formula (V), respectively.

The sensitizing dye represented by formula (V) is obtained by a condensation reaction of the above-described acidic nucleus or an active methyl group-containing acidic nucleus with a substituted or unsubstituted, aromatic ring or hetero ring. Specifically, it can be synthesized with reference to the description of JP-B-59-28329.

Preferable specific examples (D1) to (D41) of the compound represented by formula (V) are set forth below. Further, when isomers with respect to a double bond connecting an acidic nucleus and a basic nucleus are present in each of the compounds, the invention should not be construed as being limited to any one of the isomers.

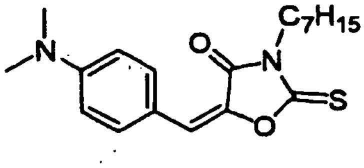

(D1)

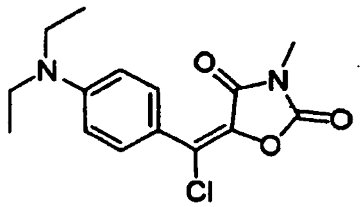

(D2)

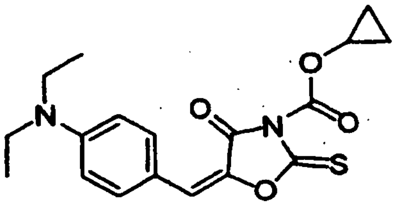

(D3)

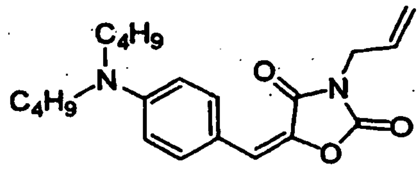

(D4)

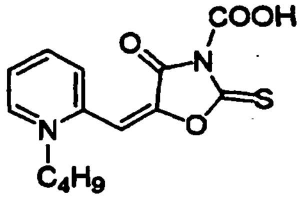

(D5)

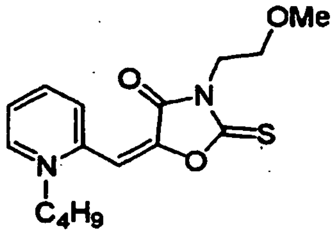

(D6)

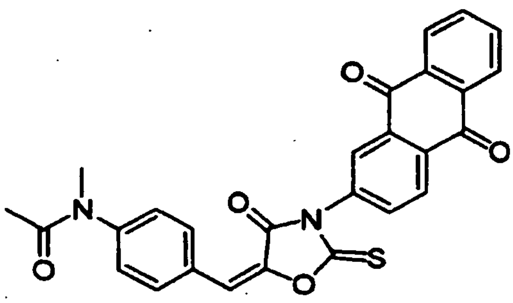

(D7)

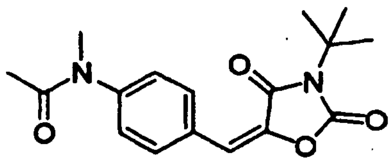

(D8)

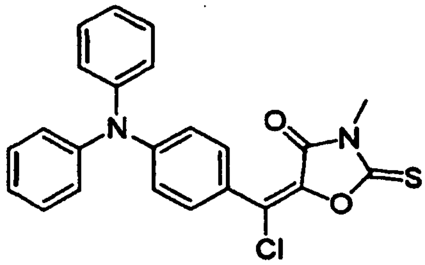

(D9)

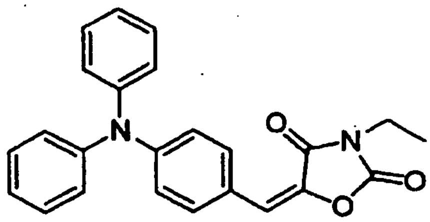

(D10)

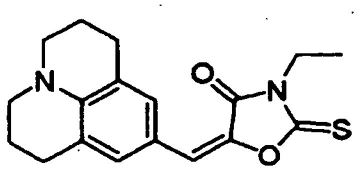

(D11)

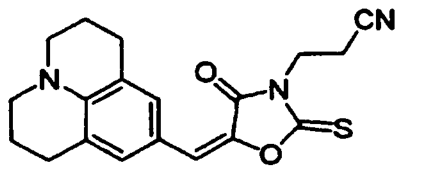

(D12)

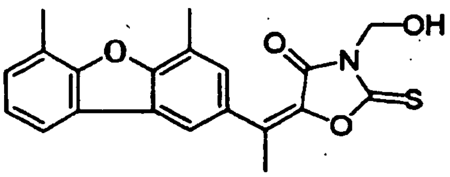

(D13)

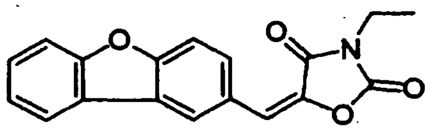

(D14)

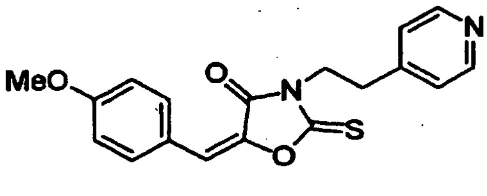

(D15)

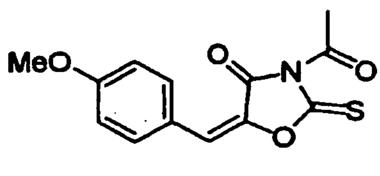

(D16)

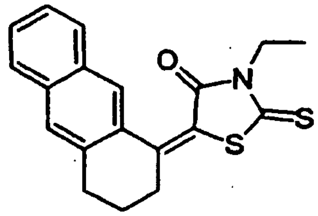

(D17)

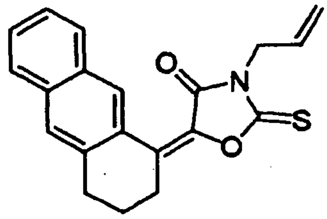

(D18)

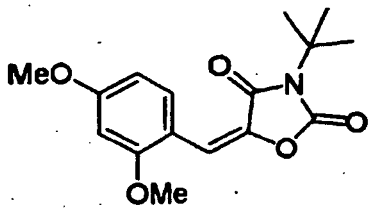

(D19)

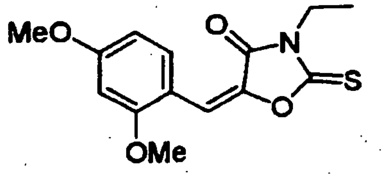

(D20)

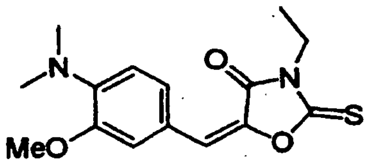

(D21)

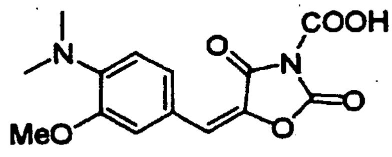

(D22)

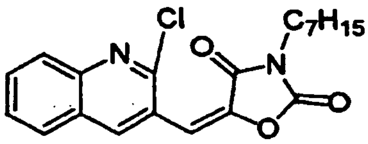

(D23)

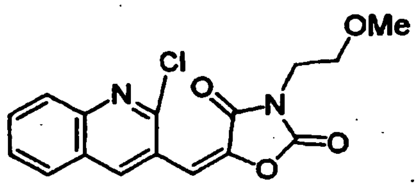

(D24)

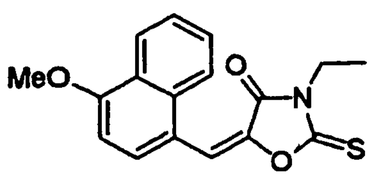

(D25)

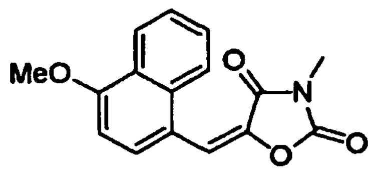

(D26)

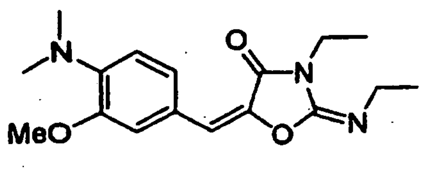

(D27)

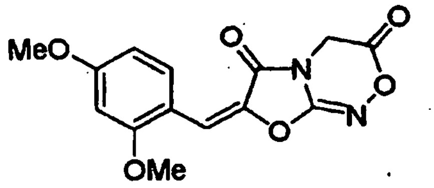

(D28)

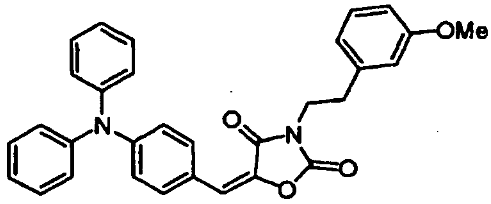

(D29)

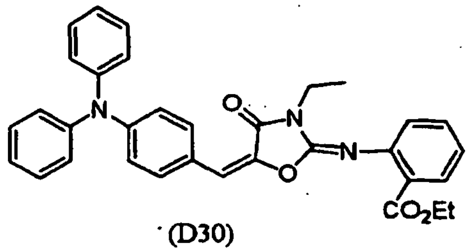

(D30)

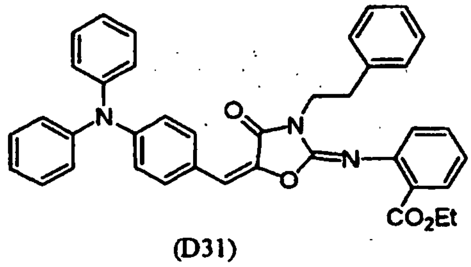

(D31)

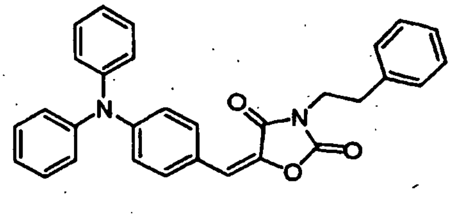

(D32)

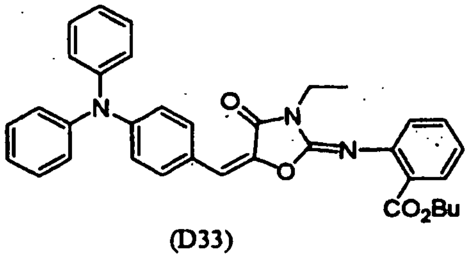

(D33)

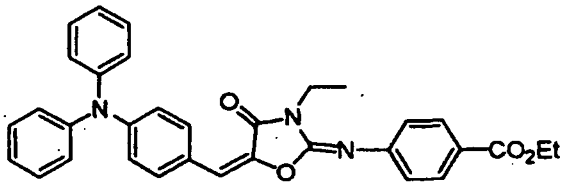

(D34)

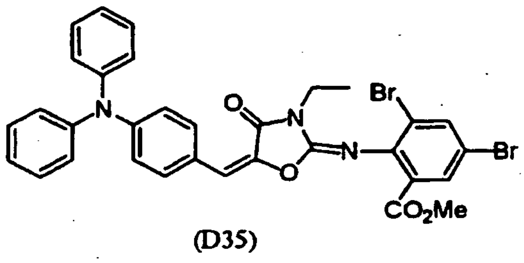

(D35)

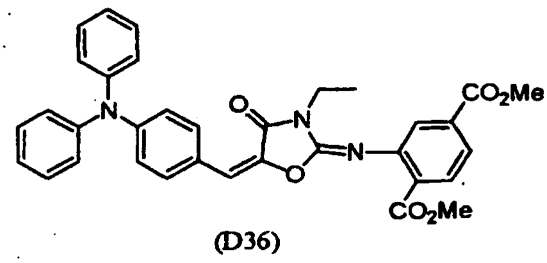

(D36)

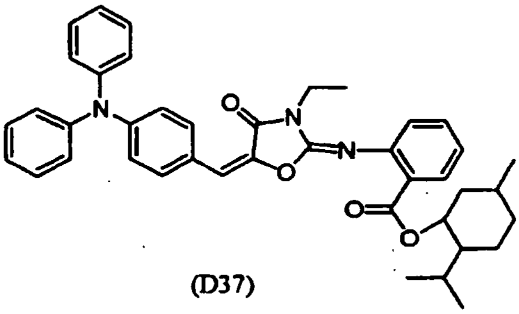

(D37)

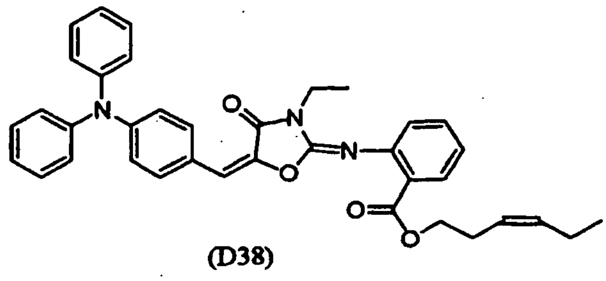

(D38)

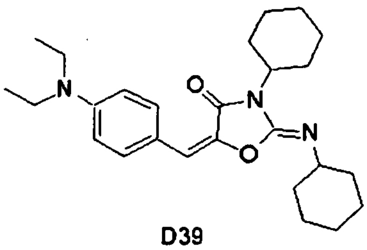
D39

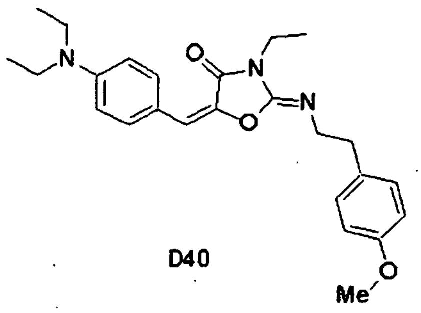
D40

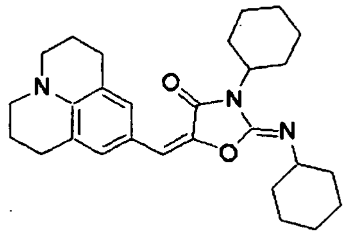
D41

The sensitizing dye having an absorption maximum in a wavelength range of 350 to 450 nm is preferably used in a range of 1.0 to 10.0% by weight, more preferably in a range of 1.5 to 5.0% by weight, based on the total solid content of the photosensitive layer.

The photosensitive layer for use in the lithographic printing plate precursor of the invention may contain, for example, a co-sensitizer, a polymerization inhibitor, a microcapsule, a surfactant, a hydrophilic polymer, a coloring agent, a print-out agent, a higher fatty acid derivative, a plasticizer, a fine particle or a hydrophilic low molecular weight compound, if desired, in addition to the components (a) to (d) described above. (Co-sensitizer)

The sensitivity of the photosensitive layer can be further increased by using a certain additive. Such a compound is referred to as a co-sensitizer in the invention. The operation mechanism of the co-sensitizer is not quite clear but may be considered to be mostly based on the following chemical process. Specifically, the co-sensitizer reacts with various intermediate active species (for example, a radical, a peroxide, an oxidizing agent or a reducing agent) generated during the process of photo-reaction initiated by light absorption of the photopolymerization initiation system and subsequent addition-polymerization reaction to produce new active radicals. The co-sensitizers are roughly classified into (a) a compound which is reduced to produce an active radical, (b) a compound which is oxidized to produce an active radical and (c) a compound which reacts with a radical having low activity to convert it into a more highly active radical or acts as a chain transfer agent. However, in many cases, a common view about that an individual compound belongs to which type is not present.

(a) Compound which is reduced to produce an active radical Compound having carbon-halogen bond:

An active radical is considered to be generated by the reductive cleavage of the carbon-halogen bond. Specific examples of the compound preferably used include a trihalomethyl-s-triazine and a trihalomethyloxadiazole. Compound having nitrogen-nitrogen bond:

An active radical is considered to be generated by the reductive cleavage of the nitrogen-nitrogen bond. Specific examples of the compound preferably used include a hexaarylbiimidazole.

Compound having oxygen-oxygen bond:

An active radical is considered to be generated by the reductive cleavage of the oxygen-oxygen bond. Specific examples of the compound preferably used include an organic peroxide. Onium compound:

An active radical is considered to be generated by the reductive cleavage of a carbon-heterobond or oxygen-nitrogen bond. Specific examples of the compound preferably used include a diaryliodonium salt, a triarylsulfonium salt and an N-alkoxypyridinium (azinium) salt.

Ferrocene and iron allene complexe:

An active radical can be reductively generated.

(b) Compound which is oxidized to produce an active radical Alkylate complex:

An active radical is considered to be generated by the oxidative cleavage of a carbon-hetero bond. Specific examples of the compound preferably used include a triaryl alkyl borate. Alkylamine compound:

An active radical is considered to be generated by the oxidative cleavage of a C-X bond on the carbon adjacent to nitrogen, wherein X is preferably a hydrogen atom, a carboxy group, a trimethylsilyl group or a benzyl group. Specific examples of the compound include an ethanolamine, an N-phenylglycine and an N-trimethylsilylmethylaniline.

Sulfur-containing or tin-containing compound:

A compound in which the nitrogen atom of the above-described amine is replaced by a sulfur atom or a tin atom is considered to generate an active radical in the same manner. Also, a compound having an S-S bond is known to effect sensitization by the cleavage of the S-S bond.

α-Substituted methylcarbonyl compound:

An active radical can be generated by the oxidative cleavage of carbonyl-α-carbon bond. The compound in which the carbonyl is converted into an oxime ether also shows the similar function. Specific examples of the compound include an 2-alkyl-1-[4-(alkylthio)phenyl]-2-morpholinopronone-1 and an oxime ether obtained by a reaction of the 2-alkyl-1-[4-(alkylthio)phenyl]-2-morpholinopronone-1 with a hydroxyamine and subsequent etherification of the N-OH.

Sulfinic acid salt:

An active radical can be reductively generated. Specific examples of the compound include sodium arylsulfinate.

(c) Compound which reacts with a radical to convert it into a more highly active radical or acts as a chain transfer agent:

For example, a compound having SH, PH, SiH or GeH in its molecule is used as the compound which reacts with a radical to convert it into a more highly active radical or acts as a chain transfer agent. The compound donates hydrogen to a low active radical species to generate a radical or is oxidized and deprotonized to generate a radical. Specific examples of the compound include a 2-mercaptobenzimidazole.

A large number of examples of the co-sensitizer are more specifically described, for example, in JP-A-9-236913 as additives for the purpose of increasing sensitivity. Some of them are set forth below, but the invention should not be construed as being limited thereto.

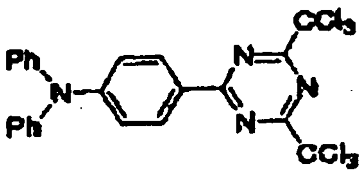

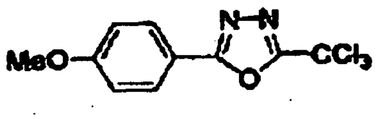

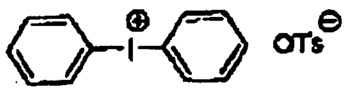

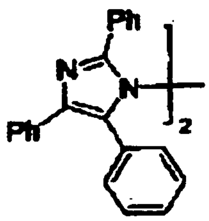

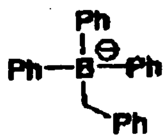

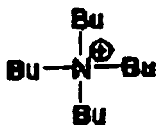

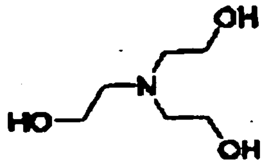

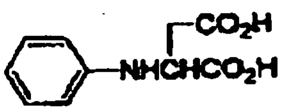

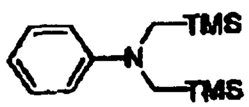

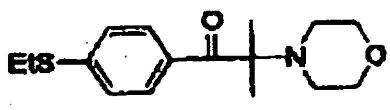

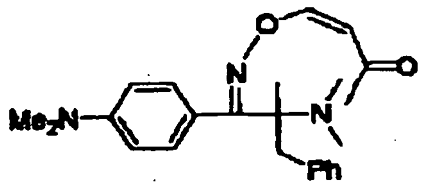

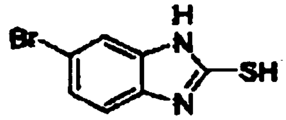

Similarly to the above-described sensitizing dye, the co-sensitizer can be subjected to various chemical modifications so as to improve the characteristics of the photosensitive layer of the lithographic printing plate precursor. For

instance, methods, for example, binding to the sensitizing dye, polymerization initiator, polymerizable compound or other radical-generating part, introduction of a hydrophilic site, introduction of a substituent for improving compatibility or inhibiting deposition of crystal, introduction of a substituent for improving adhesion property, and formation of a polymer, may be used. The co-sensitizers may be used individually or in combination of two or more thereof. The amount of the co-sensitizer used is ordinarily from 0.05 to 100 parts by weight, preferably from 1 to 80 parts by weight, more preferably from 3 to 50 parts by weight, per 100 parts by weight of the polymerizable compound.

(Microcapsule)

In the invention, in order to incorporate the above-described constituting components of the photosensitive layer and other constituting components described hereinafter into the photosensitive layer, a part of the constituting components is encapsulated into microcapsules and added to the photosensitive layer as described, for example, in JP-A-2001-277740 and JP-A-2001-277742. In such a case, each constituting component may be present inside or outside the microcapsule in an appropriate ratio.

As a method of microencapsulating the constituting components of the photosensitive layer, known methods can be used. Methods for the production of microcapsules include, for example, a method of utilizing coacervation described in U.S. Patents 2,800,457 and 2,800,458, a method of using interfacial polymerization described in U.S. Patent 3,287,154, JP-B-38-19574 and JP-B-42-446, a method of using deposition of polymer described in U.S. Patents 3,418,250 and 3,660,304, a method of using an isocyanate polyol wall material described in U.S. Patent 3, 796, 669, a method of using an isocyanate wall material described in U.S. Patent 3,914,511, a method of using a urea-formaldehyde-type or urea-formaldehyde-resorcinol-type wall-forming material described in U.S. Patens 4,001,140, 4,087,376 and 4,089,802, a method of using a wall material, for example, a melamine-formaldehyde resin or hydroxycellulose described in U.S. Patent 4,025,445, an in-situ method by polymerization of monomer described in JP-B-36-9163 and JP-B-51-9079, a spray drying method described in British Patent 930,422 and U.S. Patent 3,111,407, and an electrolytic dispersion cooling method described in British Patents 952,807 and 967,074, but the invention should not be construed as being limited thereto.

A preferable microcapsule wall used in the invention has three-dimensional crosslinking and has a solvent-swellable property. From this point of view, a preferable wall material of the microcapsule includes polyurea, polyurethane, polyester, polycarbonate, polyamide and a mixture thereof, and particularly polyurea and polyurethane are preferred. Further, a compound having a crosslinkable functional group, for example, an ethylenically unsaturated bond, capable of being introduced into the binder polymer described above may be introduced into the microcapsule wall.

The average particle size of the microcapsule is preferably from 0.01 to 3.0 μm, more preferably from 0.05 to 2.0 μm, particularly preferably from 0.10 to 1.0 μm. In the range described above, preferable resolution and good preservation stability can be achieved.

(Surfactant)

In the invention, it is preferred to use a surfactant in the photosensitive layer in order to progress the developing property and to improve the state of surface coated. The surfactant includes, for example, a nonionic surfactant, an anionic surfactant, a cationic surfactant, an amphoteric surfactant and a fluorine-based surfactant.

The nonionic surfactant used in the invention is not particular restricted, and nonionic surfactants hitherto known can be used. Examples of the nonionic surfactant include polyoxyethylene alkyl ethers, polyoxyethylene alkyl phenyl ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N-bis-2-hydroxyalkylamines, polyoxyethylene alkylamines, triethanolamine fatty acid esters, trialylamine oxides, polyethylene glycols and copolymers of polyethylene glycol and polypropylene glycol.

The anionic surfactant used in the invention is not particularly restricted and anionic surfactants hitherto known can be used. Examples of the anionic surfactant include fatty acid salts, abietic acid salts, hydroxyalkanesulfonic acid salts, alkanesulfonic acid salts, dialkylsulfosuccinic ester salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic monoamide disodium salts, petroleum sulfonic acid salts, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styrylphenyl ether sulfate ester salts, alkyl phosphate ester salts, polyoxyethylene alkyl ether phosphate ester salts, polyoxyethylene alkyl phenyl ether phosphate ester salts,

partial saponification products of styrene/maleic anhydride copolymer, partial saponification products of olefin/maleic anhydride copolymer and naphthalene sulfonate formalin condensates.

The cationic surfactant used in the invention is not particularly restricted and cationic surfactants hitherto known can be used. Examples of the cationic surfactant include alkylamine salts, quaternary ammonium salts, polyoxyethylene alkyl amine salts and polyethylene polyamine derivatives.

The amphoteric surfactant used in the invention is not particularly restricted and amphoteric surfactants hitherto known can be used. Examples of the amphoteric surfactant include carboxybetaines, aminocarboxylic acids, sulfobetaines, aminosulfuric esters and imidazolines.

In the surfactants described above, the term "polyoxyethylene" can be replaced with "polyoxyalkylene", for example, polyoxymethylene, polyoxypropylene or polyoxybutylene, and such surfactants can also be used in the invention.

Further, a preferable surfactant includes a fluorine-based surfactant containing a perfluoroalkyl group in its molecule. Examples of the fluorine-based surfactant include an anionic type, for example, perfluoroalkyl carboxylates, perfluoroalkyl sulfonates or perfluoroalkylphosphates; an amphoteric type, for example, perfluoroalkyl betaines; a cationic type, for example, perfluoroalkyl trimethyl ammonium salts; and a nonionic type, for example, perfluoroalkyl amine oxides, perfluoroalkyl ethylene oxide adducts, oligomers having a perfluoroalkyl group and a hydrophilic group, oligomers having a perfluoroalkyl group and an oleophilic group, oligomers having a perfluoroalkyl group, a hydrophilic group and an oleophilic group or urethanes having a perfluoroalkyl group and an oleophilic group. Further, fluorine-based surfactants described in JP-A-62-170950, JP-A-62-226143 and JP-A-60-168144 are also preferably exemplified.

The surfactants may be used individually or in combination of two or more thereof.

The content of the surfactant is preferably from 0.001 to 10% by weight, more preferably from 0.01 to 7% by weight, based on the total solid content of the photosensitive layer.

(Hydrophilic polymer)

In the invention, a hydrophilic polymer may be incorporated into the photosensitive layer in order to improve the developing property and dispersion stability of microcapsule.

Preferable examples of the hydrophilic polymer include those having a hydrophilic group, for example, a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group and a phosphoric acid group.

Specific examples of the hydrophilic polymer include gum arabic, casein, gelatin, a starch derivative, carboxymethyl cellulose or a sodium salt thereof, cellulose acetate, sodium alginate, a vinyl acetate-maleic acid copolymer, a styrene-maleic acid copolymer, polyacrylic acid or a salt thereof, polymethacrylic acid or a salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, polyethylene glycol, a hydroxypropylene polymer, polyvinyl alcohol, a hydrolyzed polyvinyl acetate having a hydrolysis degree of 60% by mole or more, preferably 80% by mole or more, polyvinyl formal, polyvinyl butyral, polyvinyl pyrrolidone, a homopolymer or polymer of acrylamide, a homopolymer or copolymer of methacrylamide, a homopolymer or copolymer of N-methylolacrylamide, polyvinyl pyrrolidone, an alcohol-soluble nylon, and a polyether of 2,2-bis(4-hydroxyphenyl)propane with epichlorohydrin.

The hydrophilic polymer preferably has a weight average molecular weight of 5,000 or more, more preferably from 10,000 to 300,000. The hydrophilic polymer may be any of a random polymer, a block polymer, a graft polymer or the like.

The content of the hydrophilic polymer in the photosensitive layer is preferably 20% by weight or less, more preferably 10% by weight or less, based on the total solid content of the photosensitive layer.

(Coloring agent)

In the invention, a dye having large absorption in the visible light region can be used as a coloring agent for the image. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (produced by Orient Chemical Industry Co., Ltd.), Victoria Pure Blue, Crystal Violet (CI42555), Methyl Violet (CI42535), Ethyl Violet, Rhodamine B (CI45170B), Malachite Green (CI42000), Methylene Blue (CI52015), and dyes described in JP-A-62-293247. Also, a pigment, for example, phthalocyanine-based pigment, azo-based pigment, carbon black and titanium oxide can be preferably used.

It is preferable to add the coloring agent, because the image area and the non-image area after the image formation can be easily distinguished. The amount of the coloring agent added is preferably from 0.01 to 10% by weight

based on the total solid content of the photosensitive layer.

(Print-out agent)

In the photosensitive layer according to the invention, a compound capable of undergoing discoloration by the effect of an acid or a radical can be added in order to form a print-out image. As such a compound, for example, various dyes, e.g., diphenylmethane-based, triphenylmethane-based, thiazine-based, oxazine-based, xanthene-based, anthraquinone-based, iminoquinone-based, azo-based and azomethine-based dyes are effectively used.

Specific examples thereof include dyes, for example, Brilliant Green, Ethyl Violet, Methyl Green, Crystal Violet, Basic Fuchsine, Methyl Violet 2B, Quinaldine Red, Rose Bengale, Metanil Yellow, Thymolsulfophthalein, Xylenol Blue, Methyl Orange, Paramethyl Red, Congo Red, Benzopurpurine 4B, α-Naphthyl Red, Nile Blue 2B, Nile Blue A, Methyl Violet, Malachite Green, Parafuchsine, Victoria Pure Blue BOH (produced by Hodogaya Chemical Co. , Ltd.), Oil Blue #603 (produced by Orient Chemical Industry Co., Ltd.), Oil Pink #312 (produced by Orient Chemical Industry Co., Ltd.), Oil Red 5B (produced by Orient Chemical Industry Co., Ltd.), Oil Scarlet #308 (produced by Orient Chemical Industry Co., Ltd.), Oil Red OG (produced by Orient Chemical Industry Co., Ltd.), Oil Red RR (produced by Orient Chemical Industry Co., Ltd.), Oil Green #502 (produced by Orient Chemical Industry Co., Ltd.), Spiron Red BEH Special (produced by Hodogaya Chemical Co., Ltd.), m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carboxystearylamino-4-p-N,N-bis(hydroxyethyl)aminophenylimi nonaphthoquinone, 1-phenyl-3-methyl-4-p-diethylaminophenylimino-5-pyrazolone and 1-β-naphthyl-4-p-diethylaminophenylimino-5-pyrazolone, and leuco dyes, for example, p,p',p''-hexamethyltriaminotriphenyl methane (leuco Crystal Violet) and Pergascript Blue SRB (produced by Ciba Geigy).

Other preferable examples include leuco dyes known as a material for heat-sensitive paper or pressure-sensitive paper. Specific examples thereof include Crystal Violet Lactone, Malachite Green Lactone, Benzoyl Leuco Methylene Blue, 2-(N-phenyl-N-methylamino)-6-(N-p-tolyl-N-ethyl)aminofluorane, 2-anilino-3-methyl-6-(N-ethyl-p-toluidino) fluorane, 3, 6-dimethoxyfluorane, 3-(N,N-diethylamino)-5-methyl-7-(N,N-dibenzylamino)fluorane, 3-(N-cyclohexyl-N-methylamino)-6-methyl-7-anilinofluorane, 3-(N,N-diethylamino)-6-methyl-7-anilinofluorane, 3-(N,N-diethylamino)-6-methyl-7-xylidinofluorane, 3-(N,N-diethylamino)-6-methyl-7-chlorofluorane, 3-(N,N-diethylamino)-6-methoxy-7-aminofluorane, 3-(N,N-diethylamino)-7-(4-chloroanilino)fluorane, 3-(N,N-diethylamino)-7-chlorofluorane, 3-(N,N-diethylamino)-7-benzylaminofluorane, 3-(N,N-diethylamino)-7,8-benzofluorane, 3-(N,N-dibutylamino)-6-methyl-7-anilinofluorane, 3-(N,N-dibutylamino)-6-methyl-7-xylidinofluorane, 3-piperidino-6-methyl-7-anilinofluorane, 3-pyrrolidino-6-methyl-7-anilinofluorane, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-phthalide and 3-(4-diethylaminophenyl)-3-(1-ethyl-2-methylindol-3-yl)phthal ide.

The dye capable of undergoing discoloration by the effect of an acid or a radical is preferably added in an amount of 0.01 to 15% by weight based on the total solid content of the photosensitive layer.

(Polymerization inhibitor)

To the photosensitive layer according to the invention, a small amount of a thermal polymerization inhibitor is preferably added in order to prevent the polymerizable compound from undergoing undesirable thermal polymerization during the production or preservation of the photosensitive layer.

Preferable examples of the thermal polymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis (4-methyl-6-tert-butylphenol) and N-nitroso-N-phenylhydroxylamine aluminum salt.

The amount of the thermal polymerization inhibitor added is preferably from about 0.01 to about 5% by weight based on the total solid content of the photosensitive layer.

(Higher fatty acid derivative)

In the photosensitive layer according to the invention, for example, a higher fatty acid derivative, e.g., behenic acid or behenic acid amide may be added and localized on the surface of the photosensitive layer during the process of drying after coating in order to avoid polymerization inhibition due to oxygen. The amount of the higher fatty acid derivative added is preferably from about 0.1 to about 10% by weight based on the total solid content of the photosensitive layer.

(Plasticizer)

The photosensitive layer according to the invention may contain a plasticizer. Preferable examples of the plasticizer include a phthalic acid ester, for example, dimethyl phthalate, diethyl phthalate, dibutyl phthalate, diisobutyl phthalate, diocyl phthalate, octyl capryl phthalate, dicyclohexyl phthalate, ditridecyl phthalate, butyl benzyl phthalate, diisodecyl phthalate or diallyl phthalate; a glycol ester, for example, dimethyl glycol phthalate, ethyl phthalylethyl glycolate, methyl phthalylethyl glycolate, butyl phthalylbutyl glycolate or triethylene glycol dicaprylic acid ester; a phosphoric acid ester, for example, tricresyl phosphate or triphenyl phosphate; an aliphatic dibasic acid ester, for example, diisobutyl adipate, dioctyl adipate, dimethyl sebacate, dibutyl sebacate, dioctyl azelate or dibutyl maleate; polyglycidyl methacrylate, triethyl citrate, glycerin triacetyl ester and butyl laurate. The content of the plasticizer is preferably about 30% by weight or less based on the total solid content of the photosensitive layer.

(Fine inorganic particle)

The photosensitive layer according to the invention may contain fine inorganic particle in order to increase strength of the cured layer in the image area. The fine inorganic particle preferably includes, for example, silica, alumina, magnesium oxide, titanium oxide, magnesium carbonate, calcium alginate and a mixture thereof. Even if the fine inorganic particle has no light to heat converting property, it can be used, for example, for strengthening the layer or enhancing interface adhesion property due to surface roughening. The fine inorganic particle preferably has an average particle size from 5 nm to 10 μm, more preferably from 0.5 to 3μm. In the range described above, it is stably dispersed in the photosensitive layer, sufficiently maintains the film strength of the photosensitive layer and can form the non-image area excellent in hydrophilicity and preventing from the occurrence of stain at the printing.

The fine inorganic particle described above is easily available as a commercial product, for example, colloidal silica dispersion.

The content of the fine inorganic particle is preferably 20% by weight or less, more preferably 10% by weight or less, based on the total solid content of the photosensitive layer.

(Hydrophilic low molecular weight compound)

The photosensitive layer according to the invention may contain a hydrophilic low molecular weight compound in order to improve the developing property. The hydrophilic low molecular weight compound includes a water-soluble organic compound, for example, a glycol compound, e.g., ethylene glycol, diethylene glycol, triethylene glycol, propylene glycol, dipropylene glycol or tripropylene glycol, or an ether or ester derivative thereof, a polyhydroxy compound, e.g., glycerine or pentaerythritol, an organic amine, e.g., triethanol amine, diethanol amine or monoethanol amine, or a salt thereof, an organic sulfonic acid, e.g., toluene sulfonic acid or benzene sulfonic acid, or a salt thereof, an organic phosphonic acid, e.g., phenyl phosphonic acid, or a salt thereof, an organic carboxylic acid, e.g., tartaric acid, oxalic acid, citric acid, maleic acid, lactic acid, gluconic acid or an amino acid, or a salt thereof, and an organic quaternary ammonium salt, e.g., tetraethyl ammonium hydrochloride.

The photosensitive layer according to the invention does not contain the light-to-heat conversion agent described in paragraph number [0213] of JP-A-2001-337460. In this regard, the present invention is also clearly distinguished from the invention described in JP-A-2001-337460, because the light-to-heat conversion agent which absorbs laser light to convert heat is the indispensable element of the invention described in JP-A-2001-337460.

(Formation of photosensitive layer)

The photosensitive layer according to the invention is formed by dispersing or dissolving each of the necessary constituting components described above to prepare a coating solution and coating the solution. The solvent used include, for example, ethylene dichloride, cyclohexanone, methyl ethyl ketone, methanol, ethanol, propanol, ethylene glycol monomethyl ether, 1-methoxy-2-propanol, 2-methxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water, but the invention should not be construed as being limited thereto. The solvents may be used individually or as a mixture. The solid concentration of the coating solution is preferably from 1 to 50% by weight.

The photosensitive layer according to the invention may also be formed by preparing plural coating solutions by dispersing or dissolving the same or different components described above into the same or different solvents and conducting repeatedly plural coating and drying.

The coating amount (solid content) of the photosensitive layer after the coating and drying may be varied depending on the use, but ordinarily, it is preferably from 0.3 to 3.0 g/$m^2$. In the range described above, the preferable

sensitivity and good film property of the photosensitive layer can be obtained.

Various methods can be used for the coating. Examples of the method include bar coater coating, spin coating, spray coating, curtain coating, dip coating, air knife coating, blade coating and roll coating.

[Support]

The support for use in the lithographic printing plate precursor according to the invention is not particularly restricted as long as it is a dimensionally stable plate-like hydrophilic support. The support includes, for example, paper, paper laminated with plastic (for example, polyethylene, polypropylene or polystyrene), a metal plate (for example, aluminum, zinc or copper plate), a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal film) and paper or a plastic film laminated or deposited with the metal described above. Preferable examples of the support include a polyester film and an aluminum plate. Among them, the aluminum plate is preferred since it has good dimensional stability and is relatively inexpensive.

The aluminum plate includes a pure aluminum plate, an alloy plate comprising aluminum as a main component and containing a trace amount of hetero elements and a thin film of aluminum or aluminum alloy laminated with plastic. The hetero element contained in the aluminum alloy includes, for example, silicon, iron, manganese, copper, magnesium, chromium, zinc, bismuth, nickel and titanium. The content of the hetero element in the aluminum alloy is preferably 10% by weight or less. Although a pure aluminum plate is preferred in the invention, since completely pure aluminum is difficult to be produced in view of the refining technique, the aluminum plate may slightly contain the hetero element. The composition is not specified for the aluminum plate and those materials known and used conventionally can be appropriately utilized.

The thickness of the aluminum support is preferably from 0.1 to 0.6 mm, more preferably from 0.15 to 0.4 mm, still more preferably from 0.2 to 0.3 mm.

Prior to the use of aluminum plate, a surface treatment, for example, roughening treatment or anodizing treatment is preferably performed. The surface treatment facilitates improvement in the hydrophilic property and ensures adhesion between the photosensitive layer and the support. In advance of the roughening treatment of the aluminum plate, a degreasing treatment, for example, with a surfactant, an organic solvent or an aqueous alkaline solution is conducted for removing rolling oil on the surface thereof, if desired.

The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively).

As the method of the mechanical roughening treatment, a known method, for example, a ball grinding method, a brush grinding method, a blast grinding method or a buff grinding method can be used.

The electrochemical roughening treatment method includes, for example, a method of conducting it by passing alternating current or direct current in an electrolyte containing an acid, for example, hydrochloric acid or nitric acid. Also, a method of using a mixed acid described in JP-A-54-63902 can be used.

The aluminum plate after the roughening treatment is then subjected, if desired, to an alkali etching treatment using an aqueous solution, for example, of potassium hydroxide or sodium hydroxide and further subjected to a neutralizing treatment, and then subjected to an anodizing treatment in order to enhance the abrasion resistance, if desired.

As the electrolyte used for the anodizing treatment of the aluminum plate, various electrolytes capable of forming porous oxide film can be used. Ordinarily, sulfuric acid, hydrochloric acid, oxalic acid, chromic acid or a mixed acid thereof is used. The concentration of the electrolyte can be appropriately determined depending on the kind of the electrolyte.

Since the conditions of the anodizing treatment are varied depending on the electrolyte used, they cannot be defined generally. However, it is ordinarily preferred that electrolyte concentration in the solution is from 1 to 80% by weight, liquid temperature is from 5 to 70°C, current density is from 5 to 60 A/dm$^2$, voltage is from 1 to 100 V, and electrolysis time is from 10 seconds to 5 minutes. The amount of the anodized film formed is preferably from 1.0 to 5.0 g/m$^2$, more preferably from 1.5 to 4. 0 g/m$^2$. In the range described above, good printing durability and favorable scratch resistance in the non-image area of lithographic printing plate can be achieved.

The aluminum plate subjected to the surface treatment and having the anodized film is used as it is as the support in the invention. However, in order to more improve an adhesion property to a layer provided thereon, hydrophilicity, resistance to stain, heat insulating property or the like, other treatment, for example, a treatment for enlarging micropores or a sealing treatment of micropores of the anodized film described in JP-A-2001-253181 and JP-A-2001-322365, or a surface hydrophilizing treatment by immersing in an aqueous solution containing a hydrophilic compound, may be appropriately conducted. Needless to say, the enlarging treatment and sealing treatment are not limited to those described in the above-described patents and any conventionally known method may be employed.

As the sealing treatment, as well as a sealing treatment with steam, a sealing treatment with an aqueous solution containing an inorganic fluorine compound, for example, fluorozirconic acid alone or sodium fluoride, a sealing treatment with steam having added thereto lithium chloride or a sealing treatment with hot water may be employed.

Among them, the sealing treatment with an aqueous solution containing an inorganic fluorine compound, the sealing treatment with water vapor and the sealing treatment with hot water are preferred.

The hydrophilizing treatment includes an alkali metal silicate method described in U.S. Patents 2,714,066, 3,181,461, 3, 280, 734 and 3, 902, 734. In the method, the support is subjected to an immersion treatment or an electrolytic treatment in an aqueous solution, for example, of sodium silicate. In addition, the hydrophilizing treatment includes, for example, a method of treating with potassium fluorozirconate described in JP-B-36-22063 and a method of treating with polyvinylphosphonic acid described in U. S. Patents 3, 276, 868, 4, 153, 461 and 4,689,272.

In the case of using a support having a surface of insufficient hydrophilicity, for example, a polyester film, in the invention, it is desirable to coat a hydrophilic layer thereon to make the surface sufficiently hydrophilic. Examples of the hydrophilic layer preferably includes a hydrophilic layer formed by coating a coating solution containing a colloid of oxide or hydroxide of at least one element selected from beryllium, magnesium, aluminum, silicon, titanium, boron, germanium, tin, zirconium, iron, vanadium, antimony and a transition metal described in JP-A-2001-199175, a hydrophilic layer containing an organic hydrophilic matrix obtained by crosslinking or pseudo-crosslinking of an organic hydrophilic polymer described in JP-A-2002-79772, a hydrophilic layer containing an inorganic hydrophilic matrix obtained by sol-gel conversion comprising hydrolysis and condensation reaction of polyalkoxysilane and titanate, zirconate or aluminate, and a hydrophilic layer comprising an inorganic thin layer having a surface containing metal oxide. Among them, the hydrophilic layer formed by coating a coating solution containing a colloid of oxide or hydroxide of silicon is preferred.

Further, in the case of using, for example, a polyester film as the support in the invention, it is preferred to provide an antistatic layer on the hydrophilic layer side, opposite side to the hydrophilic layer or both sides. When the antistatic layer is provided between the support and the hydrophilic layer, it also contributes to improve the adhesion property of the hydrophilic layer to the support. As the antistatic layer, a polymer layer having fine particles of metal oxide or a matting agent dispersed therein described in JP-A-2002-79772 can be used.

The support preferably has a center line average roughness of 0.10 to 1.2 μm. In the range described above, good adhesion property to the photosensitive layer, good printing durability, and good resistance to stain can be achieved.

The color density of the support is preferably from 0.15 to 0.65 in terms of the reflection density value. In the range described above, good image-forming property by preventing halation at the image exposure and good aptitude for plate inspection after development can be achieved.

[Undercoat layer]

In the lithographic printing plate precursor according to the invention, an undercoat layer comprising a compound having a polymerizable group may be provided on the support. When the undercoat layer is used, the fine particle-containing layer is provided on the undercoat layer. The undercoat layer has the effects of strengthening the adhesion property between the support and the fine particle-containing layer in the exposed area and facilitating separation of the fine particle-containing layer from the support in the unexposed area, thereby improving the developing property.

As the compound for the undercoat layer, specifically, a silane coupling agent having an addition-polymerizable ethylenic double bond reactive group described in JP-A-10-282679 and a phosphorus compound having an ethylenic double bond reactive group described in JP-A-2-304441 are preferably exemplified. A particularly preferable compound is a compound having both a polymerizable group, for example, a methacryl group or an allyl group and a support-adsorbing group, for example, a sulfonic acid group, a phosphoric acid group or a phosphoric acid ester group. Also, a compound having a hydrophilicity-imparting group, for example, an ethylene oxide group, in addition to the polymerizable group and the support-adsorbing group, can be preferably used.

The coating amount (solid content) of the undercoat layer is preferably from 0.1 to 100 $mg/m^2$, more preferably from 1 to 30 $mg/m^2$.

[Protective layer]

In the lithographic printing plate precursor according to the invention, a protective layer (oxygen-blocking layer) is preferably provided on the photosensitive layer in order to prevent diffusion and penetration of oxygen which inhibits the polymerization reaction at the time of exposure. The protective layer for use in the invention preferably has oxygen permeability (A) at 25°C under one atmosphere of $1.0 \leq (A) \leq 20$ ($ml/m^2 \cdot day$). When the oxygen permeability (A) is extremely lower than 1.0 ($ml/m^2 \cdot day$), problems may occur in that an undesirable polymerization reaction arises during the production or preservation before image exposure and in that undesirable fog or spread of image line occurs at the image exposure. On the contrary, when the oxygen permeability (A) greatly exceeds 20 ($ml/m^2 \cdot day$), decrease in sensitivity may be incurred. The oxygen permeability (A) is more preferably in a range of $1.5 \leq (A) \leq 12$ ($ml/m^2 \cdot day$), still

more preferably in a range of 2.0 ≤ (A) ≤ 10. 0 (ml/m$^2$·day). Besides the above described oxygen permeability, as for the characteristics required of the protective layer, it is desired that the protective layer does not substantially hinder the transmission of light for the exposure, is excellent in the adhesion property to the photosensitive layer, and can be easily removed during a development step after the exposure. Contrivances on the protective layer have been heretofore made and described in detail in U.S. Patent 3,458,311 and JP-B-55-49729.

As the material of the protective layer, a water-soluble polymer compound relatively excellent in crystallizability is preferably used. Specifically, a water-soluble polymer, for example, polyvinyl alcohol, vinyl alcohol/vinyl phthalate copolymer, vinyl acetate/vinyl alcohol/vinyl phthalate copolymer, vinyl acetate/crotonic acid copolymer, polyvinyl pyrrolidone, acidic cellulose, gelatin, gum arabic, polyacrylic acid or polyacrylamide is enumerated. The water-soluble polymer compounds may be used individually or as a mixture. Of the compounds, when polyvinyl alcohol is used as a main component, the best results can be obtained in the fundamental characteristics, for example, oxygen-blocking property and removability of the protective layer by development.

Polyvinyl alcohol for use in the protective layer may be partially substituted with ester, ether or acetal as long as it contains unsubstituted vinyl alcohol units for achieving the necessary oxygen-blocking property and water solubility. Also, a part of polyvinyl alcohol may have other copolymer component.

As specific examples of the polyvinyl alcohol, polyvinyl alcohols having a hydrolysis degree of 71 to 100% and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). They can be used individually or as a mixture. According to a preferred embodiment, the content of polyvinyl alcohol in the protective layer is from 20 to 95% by weight, more preferably from 30 to 90% by weight.

Also, known modified polyvinyl alcohol can be preferably used. For instance, polyvinyl alcohols of various polymerization degrees having at random a various kind of hydrophilic modified cites, for example, an anion-modified cite modified with an anion, e.g., a carboxyl group or a sulfo group, a cation-modified cite modified with a cation, e.g., an amino group or an ammonium group, a silanol-modified cite or a thiol-modified cite, and polyvinyl alcohols of various polymerization degrees having at the terminal of the polymer a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are exemplified.

As a component used as a mixture with polyvinyl alcohol, polyvinyl pyrrolidone or a modified product thereof is preferable from the viewpoint of the oxygen-blocking property and removability by development. The content thereof is ordinarily from 3.5 to 80% by weight, preferably from 10 to 60% by weight, more preferably from 15 to 30% by weight, in the protective layer.

The components of the protective layer (selection of PVA and use of additives) and the coating amount are determined taking into consideration fog-preventing property, adhesion property and scratch resistance besides the oxygen-blocking property and removability by development. In general, the higher the hydrolyzing rate of the PVA used (the higher the unsubstituted vinyl alcohol unit content in the protective layer) and the larger the layer thickness, the higher is the oxygen-blocking property, thus it is advantageous in the point of sensitivity. The molecular weight of the polymer compound, for example, polyvinyl alcohol (PVA) is ordinarily from 2,000 to 10,000,000, preferably from 20,000 to 3,000,000.

As other additive of the protective layer, glycerin, dipropylene glycol or the like can be added in an amount corresponding to several % by weight of the polymer compound to provide flexibility. Further, an anionic surfactant, for example, sodium alkylsulfate or sodium alkylsulfonate; an amphoteric surfactant, for example, alkylaminocarboxylate and alkylaminodicarboxylate; or a nonionic surfactant, for example, polyoxyethylene alkyl phenyl ether can be added in an amount corresponding to several % by weight of the polymer compound.

The adhesion property of the protective layer to the photosensitive layer and scratch resistance are also extremely important in view of handling of the printing plate precursor. Specifically, when a hydrophilic layer comprising a water-soluble polymer is laminated on the oleophilic photosensitive layer, layer peeling due to an insufficient adhesion property is liable to occur, and the peeled portion causes such a defect as failure in curing of the photosensitive layer due to polymerization inhibition by oxygen. Various proposals have been made for improving the adhesion property between the photosensitive layer and the protective layer. For example, it is described in U.S. Patent Application Nos. 292,501 and 44,563 that a sufficient adhesion property can be obtained by mixing from 20 to 60% by weight of an acryl-based emulsion or a water-insoluble vinyl pyrrolidone/vinyl acetate copolymer with a hydrophilic polymer mainly comprising polyvinyl alcohol and laminating the resulting mixture on the photosensitive layer. Any of these known techniques can be applied to the protective layer according to the invention. Coating methods of the protective layer are described in detail, for example, in U.S. Patent 3,458,311 and JP-B-55-49729.

Further, it is also preferred to incorporate an inorganic stratiform compound into the protective layer of the

lithographic printing plate precursor according to the invention for the purpose of improving the oxygen-blocking property and property for protecting the surface of photosensitive layer.

The inorganic stratiform compound used here is a particle having a thin tabular shape and includes, for instance, mica, for example, natural mica represented by the following formula: A (B, C)$_{2-5}$ $D_4$ $O_{10}$ (OH, F, O)$_2$, (wherein A represents any one of K, Na and Ca, B and C each represents any one of Fe (II), Fe(III), Mn, Al, Mg and V, and D represents Si or A1) or synthetic mica; talc represented by the following formula: $3MgO \cdot 4SiO \cdot H_2O$; teniolite; montmorillonite; saponite; hectolite; and zirconium phosphate.

Of the micas, examples of the natural mica include muscovite, paragonite, phlogopite, biotite and lepidolite. Examples of the synthetic mica include non-swellable mica, for example, fluorphlogopite $KMg_3(AlSi_3O_{10})F_2$ or potassium tetrasilic mica $KMg_{2.5}(Si_4O_{10})F_2$, and swellable mica, for example, Na tetrasilic mica $NaMg_{2.5}(Si_4O_{10})F_2$, Na or Li teniolite (Na, Li)$Mg_2Li(Si_4O_{10})F_2$, or montmorillonite based Na or Li hectolite (Na, Li)$_{1/8}Mg_{2/5}Li_{1/8}$ $(Si_4O_{10})F_2$. Synthetic smectite is also useful.

Of the inorganic stratiform compounds, fluorine based swellable mica, which is a synthetic inorganic stratiform compound, is particularly useful in the invention. Specifically, the swellable synthetic mica and an swellable clay mineral, for example, montmorillonite, saponite, hectolite or bentonite have a stratiform structure comprising a unit crystal lattice layer having thickness of approximately 10 to 15 angstroms, and metallic atom substitution in the lattices thereof is remarkably large in comparison with other clay minerals. As a result, the lattice layer results in lack of positive charge and in order to compensate it, a cation, for example, $Na^+$, $Ca^{2+}$ or $Mg^{2+}$, is adsorbed between the lattice layers. The cation existing between the lattice layers is referred to as an exchangeable cation and is exchangeable with various cations. In particular, in the case where the cation between the lattice layers is Li+ or $Na^+$, because of a small ionic radius, a bond between the stratiform crystal lattices is week, and the inorganic stratiform compound greatly swells upon contact with water. When share is applied under such condition, the stratiform crystal lattices are easily cleaved to form a stable sol in water. The bentnite and swellable synthetic mica have strongly such tendency and are useful in the invention. Particularly, the swellable synthetic mica is preferably used.

With respect to the shape of the inorganic stratiform compound used in the invention, the thinner the thickness or the larger the plain size as long as smoothness of coated surface and transmission of actinic radiation are not damaged, the better from the standpoint of control of diffusion. Therefore, an aspect ratio of the inorganic stratiform compound is ordinarily 20 or more, preferably 100 or more, particularly preferably 200 or more. The aspect ratio is a ratio of thickness to major axis of particle and can be determined, for example, from a projection drawing of particle by a microphotography. The larger the aspect ratio, the greater the effect obtained.

As for the particle size of the inorganic stratiform compound used in the invention, an average major axis is ordinarily from 0.3 to 20 $\mu$m, preferably from 0.5 to 10 $\mu$m, particularly preferably from 1 to 5 $\mu$m. An average thickness of the particle is ordinarily 0.1 $\mu$m or less, preferably 0.05 $\mu$m or less, particularly preferably 0.01 $\mu$m or less. For example, in the swellable synthetic mica that is the representative compound of the inorganic stratiform compounds, thickness is approximately from 1 to 50 nm and plain size is approximately from 1 to 20 $\mu$m.

When such an inorganic stratiform compound particle having a large aspect ratio is incorporated into the protective layer, strength of coated layer increases and penetration of oxygen or moisture can be effectively inhibited so that the protective layer can be prevented from deterioration due to deformation, and even when the lithographic printing plate precursor is preserved for a long period of time under a high humidity condition, it is prevented from decrease in the image-forming property thereof due to the change of humidity and exhibits excellent preservation stability.

The content of the inorganic stratiform compound in the protective layer is preferably from 5/1 to 1/00 in terms of weight ratio to the amount of binder used in the protective layer. When a plurality of inorganic stratiform compounds is used in combination, it is also preferred that the total amount of the inorganic stratiform compounds fulfills the above-described weight ratio.

An example of common dispersing method for the inorganic stratiform compound used in the protective layer is described below. Specifically, from 5 to 10 parts by weight of a swellable stratiform compound that is exemplified as a preferred inorganic stratiform compound is added to 100 parts by weight of water to adapt the compound to water and to be swollen, followed by dispersing using a dispersing machine. The dispersing machine used include, for example, a variety of mills conducting dispersion by directly applying mechanical power, a high-speed agitation type dispersing machine providing a large shear force and a dispersion machine providing ultrasonic energy of high intensity. Specific examples thereof include a ball mill, a sand grinder mill, a visco mill, a colloid mill, a homogenizer, a dissolver, a polytron, a homomixer, a homoblender, a keddy mill, a jet agitor, a capillary type emulsifying device, a liquid siren, an electromagnetic strain type ultrasonic generator and an emulsifying device having a Polman whistle. A dispersion containing from 5 to 10% by weight of the inorganic stratiform compound thus prepared is highly viscous or gelled and exhibits extremely good preservation stability. In the formation of a coating solution for protective layer using the dispersion, it is preferred that the dispersion is diluted with water, sufficiently stirred and then mixed with a binder solution.

To the coating solution for protective layer can be added known additives, for example, a surfactant for improving coating property or a water-soluble plasticizer for improving physical property of coated layer in addition to the inorganic

stratiform compound. Examples of the water-soluble plasticizer include propionamide, cyclohexanediol, glycerin or sorbitol. Also, a water-soluble (meth) acrylic polymer can be added. Further, to the coating solution may be added known additives for increasing adhesion property to the photosensitive layer or for improving preservation stability of the coating solution.

The coating solution for protective layer thus-prepared is coated on the photosensitive layer provided on the support and then dried to form a protective layer. The coating solvent may be appropriately selected in view of the binder used, and when a water-soluble polymer is used, distilled water or purified water is preferably used as the solvent. A coating method of the protective layer is not particularly limited, and known methods, for example, methods described in U.S. Patent 3,458,311 and JP-B-55-49729 can be utilized. Specific examples of the coating method for the protective layer include a blade coating method, an air knife coating method, a gravure coating method, a roll coating method, a spray coating method, a dip coating method and a bar coating method.

The coating amount of the protective layer is preferably in a range of 0.05 to 10 g/$m^2$ in terms of the coating amount after drying. When the protective layer contains the inorganic stratiform compound, it is more preferably in a range of 0.1 to 0.5 g/$m^2$, and when the protective layer does not contain the inorganic stratiform compound, it is more preferably in a range of 0.5 to 5 g/$m^2$.

[Backcoat layer]

A backcoat layer may be provided on the back surface of the support, if desired.

The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, $Si(OCH_3)_4$, $Si(OC_2H_5)_4$, Si $(OC_3H_7)_4$ or $Si(OC_4H_9)_4$ is preferred since the starting material is inexpensive and easily available.

[Method of preparing lithographic printing plate]

The method of preparing a lithographic printing plate according to the invention is described in detail below. The method of preparing lithographic printing plate according to the invention mainly comprises imagewise exposing the lithographic printing plate precursor, if desired, heating the entire surface of the exposed lithographic printing plate precursor, and then developing it by an automatic developing machine with a developer having pH of 2 to 10.

[Exposure]

As the laser light source for use in the image exposure of the lithographic printing plate precursor according to the invention, for example, a semiconductor laser of 488 nm or 532 nm or an FD-YAG laser is used. In recent years, a CTP system equipped with a semiconductor laser of 405 nm has become widespread in view of system cost and handling properties. For instance, it is possible that the lithographic printing plate precursor is loaded in an inner drum exposure apparatus equipped with a light source having an oscillation wavelength in a range of 350 to 450 nm (wherein a light beam emitted from the light source is parallel divided into an ordinary beam and an extraordinary beam in an equal amount and these two beam spots are adjacently aligned with a partial overlap in the sub-scanning direction to form a spot shape of light beam), and subjected to exposure with the spot shape of light beam to perform image-recording.

The exposure apparatus for use in the invention may be any of an internal drum system, an external drum system and a flat bed system. Further, the highly accurate image can be recorded at high speed by simultaneously recording the image using a multibeam exposure system.

Moreover, the image-recording can be performed using an FM screen at the exposure of lithographic printing plate precursor according to the invention.

[Heating]

According to the invention, the lithographic printing plate precursor exposed imagewise may be heated overall between the exposure and development, if desired. By the heating, the image-forming reaction in the photosensitive layer is accelerated to achieve advantages, for example, improvement in the sensitivity and printing durability and stabilization of the sensitivity.

In the case where the protective layer is provided on the photosensitive layer, it is also preferred to carry out a water washing treatment before the development processing.

[Plate making]

The lithographic printing plate precursor according to the invention is exposed imagewise with a semiconductor laser or a solid laser as described above, if desired, heated the entire surface of the exposed lithographic printing plate precursor as described above, and then rubbed the surface of the exposed lithographic printing plate precursor with a rubbing member in the presence of a developer having pH of 2 to 10 in an automatic processor equipped with the rubbing member to remove an unexposed area of the photosensitive layer, thereby preparing a lithographic printing plate.

The developer for use in the invention is preferably, for example, water alone or an aqueous solution containing water as a main component (containing 60% by weight or more of water). Particularly, an aqueous solution having the same composition as conventionally known dampening water, an aqueous solution containing a surfactant (for example, an anionic, nonionic or cationic surfactant) or an aqueous solution containing a water-soluble polymer compound is preferable. An aqueous solution containing both a surfactant and a water-soluble polymer compound is especially preferable. The pH of the developer is preferably from 3 to 8, more preferably from 4 to 7.

The anionic surfactant for use in the developer according to the invention includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, dialkylsulfosuccinic acid salts, alkyl sulfate ester salts and alkylnaphthalenesulfonic acid salts are particularly preferably used.

The cationic surfactant for use in the developer according to the invention is not particularly limited and conventionally known cationic surfactants can be used. Examples of the cationic surfactant include alkylamine salts, quaternary ammonium salts, polyoxyethylene alkyl amine salts and polyethylene polyamine derivatives.

The nonionic surfactant for use in the developer according to the invention includes, for example, polyethylene glycol type higher alcohol ethylene oxide addacts, alkylphenol ethylene oxide addacts, fatty acid ethylene oxide addacts, polyhydric alcohol fatty acid ester ethylene oxide addacts, higher alkylamine ethylene oxide addacts, fatty acid amide ethylene oxide addacts, ethylene oxide addacts of fat, polypropylene glycol ethylene oxide addacts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines.

In the invention, ethylene oxide addacts of sorbitol and/or sorbitan fatty acid esters, polypropylene glycol ethylene oxide addacts, dimethylsiloxane-ethylene oxide block copolymers, dimethylsiloxane-(propylene oxide-ethylene oxide) block copolymers and fatty acid esters of polyhydric alcohols are more preferable.

Further, from the standpoint of stable solubility in water or opacity, with respect to the nonionic surfactant used in the developer according to the invention, the HLB (hydrophile-lipophile balance) value thereof is preferably 6 or more, more preferably 8 or more.

Furthermore, an oxyethylene adduct of acetylene glycol type or acetylene alcohol type or a surfactant, for example, a fluorine-based surfactant or a silicon-based surfactant can also be used.

Of the surfactants used in the developer according to the invention, the nonionic surfactant is particularly preferred in view of foam depressing property.

The surfactants may be used individually or as a mixture of two or more thereof. An amount of the surfactant contained in the developer is preferably from 0.01 to 10% by weight, more preferably from 0.01 to 5% by weight.

The water-soluble polymer compound for use in the developer according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, those known can be used. For example, as a commercial product, Soyafive (trade name, produced by Fuji Oil Co., Ltd.) is available and various grade products can be used. The soybean polysaccharide preferably used has viscosity in a range of 10 to 100 mPa/sec in a 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene

is added thereto in an alkali.

Two or more of the water-soluble polymer compounds may be used in combination. The content of the water-soluble polymer compound is preferably from 0.1 to 20% by weight, more preferably from 0.5 to 10% by weight, in the developer.

The developer for use in the invention may contain an organic solvent. The organic solvent that can be contained in the developer include, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or monochlorobenzene) and a polar solvent.

Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).

Further, when the organic solvent is insoluble in water, it may be employed by being solubilized in water using a surfactant or the like. In the case where the developer contains the organic solvent, the concentration of the organic solvent is desirably less than 40% by weight in view of safety and inflammability.

Into the developer for use in the invention, an antiseptic agent, a chelating agent, a defoaming agent, anorganic acid, an inorganic acid, an inorganic salt or the like can be incorporated in addition to the above components.

As the antiseptic agent, for example, phenol or a derivative thereof, formalin, an imidazole derivative, sodium dehydroacetate, a 4-isothiazolin-3-one derivative, benzisotiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative and a nitro bromo alcohol, e.g., 2-bromo-2-nitropropane-1,3-diol, 1-dibromo-1-nitro-2-ethanol or 1,1-dibromo-1-nitro-2-propanol are preferably used.

As the chelating agent, for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof; organic phosphonic acids, for example, 1-hydroxyethane-1,1-diphosphonic acid, potassium salt thereof, sodium salt thereof; aminotri(methylenephosphonic acid), potassium salt thereof, sodium salt thereof; and phophonoalkanetricarboxylic acids are illustrated. A salt of an organic amine is also effectively used in place of the sodium salt or potassium salt in the chelating agents.

As the defoaming agent, for example, a conventional silicone-based self-emulsifying type or emulsifying type defoaming agent, and a nonionic surfactant having HLB of 5 or less are used. The silicone defoaming agent is preferably used. Any of emulsifying dispersing type and solubilizing type can be used.

As the organic acid, for example, citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid and an organic phosphonic acid are illustrated. The organic acid can also be used in the form of an alkali metal salt or an ammonium salt.

As the inorganic acid and inorganic salt, for example, phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate and nickel sulfate are illustrated.

The developer described above can be used as a developer and a development replenisher for an exposed negative-working lithographic printing plate precursor, and it is preferably applied to an automatic processor described hereinafter. In the case of conducting the development processing using an automatic processor, the developer becomes fatigued in accordance with the processing amount, and hence the processing ability may be restored using a replenisher or a fresh developer. Such a replenishment system can be preferably applied to the plate-making method of the lithographic printing plate precursor according to the invention.

The development processing using the developer having pH of 2 to 10 according to the invention is preferably performed by an automatic processor equipped with a supplying means for a developer and a rubbing member. As the automatic processor, there are illustrated an automatic processor in which a lithographic printing plate precursor after image exposure is subjected to a rubbing treatment while it is transporting described in JP-A-2-220061 and JP-A-60-59351, and an automatic processor in which a lithographic printing plate precursor after image exposure placed on a cylinder is subjected to a rubbing treatment while rotating the cylinder described in U.S. Patents 5,148,746 and 5,568,768and British Patent 2, 297, 719. Among them, the automatic processor using a rotating brush roll as the rubbing member is particularly preferred.

The rotating brush roller which can be preferably used in the invention can be appropriately selected by taking account, for example, of scratch resistance of the image area and nerve strength of the support of the lithographic printing plate precursor. As for the rotating brush roller, a known rotating brush roller produced by implanting a brush material in a plastic or metal roller can be used. For example, a rotating brush roller described in JP-A-58-159533 and JP-A-3-100554, or a brush roller described in JP-U-B-62-167253 (the term "JP-UM-B" as used herein means an "examined Japanese utility model publication"), in which a metal or plastic groove-type member having implanted therein in rows a brush material is closely radially wound around a plastic or metal roller acting as a core, can be used.

As the brush material, a plastic fiber (for example, a polyester-based synthetic fiber, e.g., polyethylene terephthalate or polybutylene terephthalate; a polyamide-based synthetic fiber, e.g., nylon 6.6 or nylon 6.10; a polyacrylic synthetic fiber, e.g., polyacrylonitrile or polyalkyl (meth)acrylate; and a polyolefin-based synthetic fiber, e.g., polypropylene or polystyrene) can be used. For instance, a brush material having a fiber bristle diameter of 20 to 400 μm and a bristle length of 5 to 30 mm can be preferably used. The outer diameter of the rotating brush roller is preferably from 30 to 200 mm, and the peripheral velocity at the tip of the brush rubbing the plate surface is preferably from 0.1 to 5 m/sec. Further, it is preferred to use a plurality, that is, two or more of the rotating brush rollers.

The rotary direction of the rotating brush roller for use in the invention may be the same direction or the opposite direction with respect to the transporting direction of the lithographic printing plate precursor of the invention, but when two or more rotating brush rollers are used in an automatic processor as shown in Fig. 1, it is preferred that at least one rotating brush roller rotates in the same direction and at least one rotating brush roller rotates in the opposite direction with respect to the transporting direction. By such arrangement, the photosensitive layer in the non-image area can be more steadily removed. Further, a technique of rocking the rotating brush roller in the rotation axis direction of the brush roller is also effective.

The developer can be used at an appropriate temperature, and the developer temperature is preferably from 10 to 50°C.

In the invention, the lithographic printing plate after the aforementioned treatment may be subsequently subjected to water washing, a drying treatment and an oil-desensitization treatment, if desired. In the oil-desensitization treatment, a known oil-desensitizing solution can be used.

## EXAMPLES

The present invention will be described in more detail with reference to the following examples, but the invention should not be construed as being limited thereto.

[Preparation of solution of Organic resin fine particle (1)]

In a 1,000-ml three-necked flask, 8 g of styrene, 1 g of divinylbenzene and 0.45 g of sodium dodecylsulfate were supplied and dissolved in 28 g of distilled water and the solution was stirred at 65°C under nitrogen stream for 30 minutes. To the solution was added a solution prepared by dissolving 18.6 mg of 2,2'-azobis(2-amidinoprpoane)dihydrochloride in 2g of distilled water, followed by stirring at the same temperature for 6 hours. After the completion of the reaction, the reaction mixture was filtered with a glass filter to obtain a solution of Organic resin fine particle (1). The solid concentration of the solution of Organic resin fine particle (1) was 20%, and the average particle size of Organic resin fine particle (1) measured by a light scattering method using LASER SCATTERING PARTICLE SIZE DISTRIBUTION ANALYZER LA-910 (produced by HORIBA) was 87 nm.

[Preparation of solution of Organic resin fine particle (2)]

In a 500-ml three-necked flask, 300 ml of distilled water, 10 g of a dispersing agent (Trax H-45, produced by NOF Corp.) and 104.4 g of a mixture of styrene, chloromethylstyrene and divinylbenzene (44:44:12 in a molar ratio) were supplied, heated at 60°C and stirred under nitrogen stream for 30 minutes. To the solution was added a solution prepared by dissolving 0.8 g of potassium persulfate in 15 ml of distilled water and one minute later, a solution prepared by dissolving 0.25 g of sodium hydrogen sulfite in 5 ml of distilled water was added, followed by stirring at the same temperature for 6 hours. After the completion of the reaction, the reaction mixture was filtered with a glass filter and to the filtrate were added 350 g of distilled water and 140 g of isopropanol and then, 36.14 g of triethylamine was dropwise added thereto over a period of 30 minutes. The reaction mixture was stirred at 60°C for 6 hours. The reaction mixture thus-obtained was filtered with a glass filter and dialyzed (distilled water was exchanged twice) for 24 hours to remove

the remaining monomer and unreacted triethylamine. Then, the reaction mixture was put in a 2-liter beaker, heated at 85°C for 30 minutes, cooled to room temperature and 200 ml of an aqueous saturated sodium chloride solution was added dropwise thereto over a period of 30 minutes to flocculate resin fine particles. The flocculated resin fine particles were filtered by a glass filter and the resin fine particles separated were thoroughly washed with distilled water and dried under a reduced pressure to obtain Organic resin fine particle (2) as colorless powder. The average particle size of Organic resin fine particle (2) was 78 nm. In a polyethylene vessel were supplied 10 g of Organic resin fine particle (2) and 40 g of acetonitrile and 2 g of glass beads were added thereto, and the mixture was well shaken in a paint shaker for one hour to prepare a solution of Organic resin fine particle (2).

[Preparation of solution of Organic resin fine particle (3)]

In a 2,000-ml three-necked flask, 9.2 g of sodium dodecylsulfate and 1,200 ml of distilled water and the solution was stirred at 75°C under nitrogen stream for 10 minutes. To the solution was added a solution prepared by mixing 0.426 g of potassium persulfate, 11.3 ml of distilled water and 3.5 ml of an aqueous saturated sodium hydrogen carbonate solution. Then, a mixed solution of 113.76 g of tert-butyl methacrylate and 39. 65 g of ethylene glycol dimethacrylate and a solution prepared by mixing 0.426 g of potassium persulfate, 14.2 ml of distilled water and 3.5 ml of an aqueous saturated sodium hydrogen carbonate solution were dropwise added thereto over a period of 3 hours. After the completion of the dropwise addition, the stirring was further continued for one hour. The reaction mixture thus-obtained was cooled to room temperature and filtered with a glass filter to obtain a solution of Organic resin fine particle (3). The solid concentration of the solution of Organic resin fine particle (3) was 11%, and the average particle size of Organic resin fine particle (3) was 21 nm.

[Preparation of solutions of Organic resin fine particles (4) to (22)]

Solutions of Organic resin fine particles (4) to (22) were prepared according to the preparation of solutions of Organic resin fine particles (1) to (3) described above and known synthesis methods of resin particles, respectively.
The composition of the solution of organic resin fine particle and the structure and physical properties of the organic resin fine particle are set forth below.

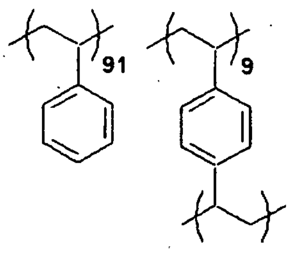

(1)

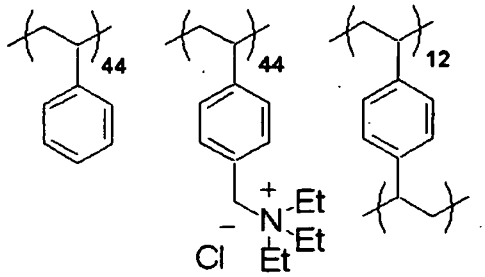

(2)

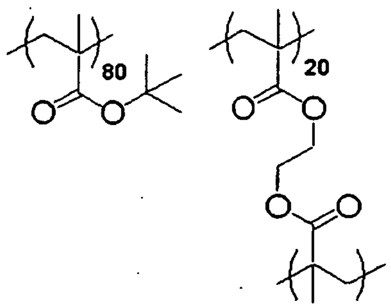

(3)

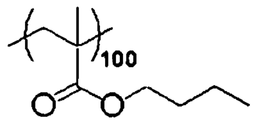

(4)

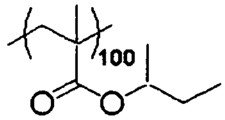

(5)

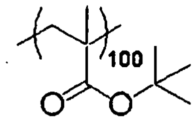

(6)

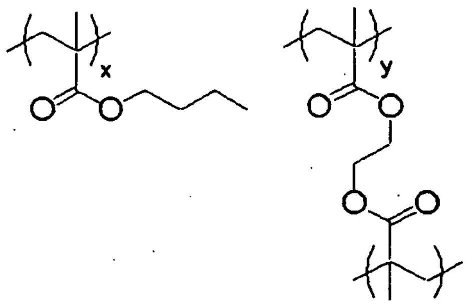

(7):x=97.5,y=2.5
(8):x=95,y=5
(9):x=90,y=10

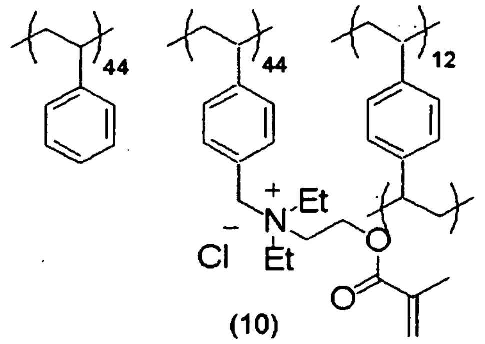

(10)

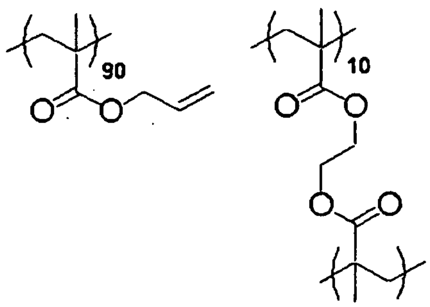

(11)

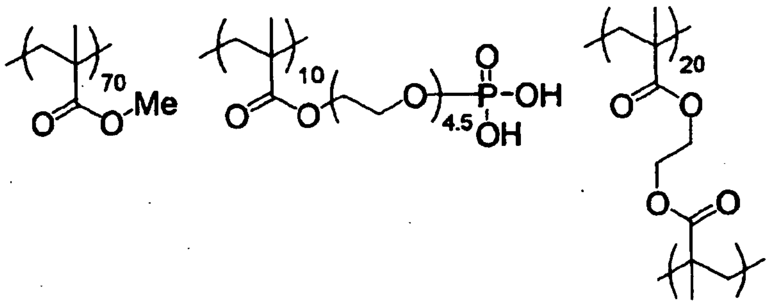

(12)

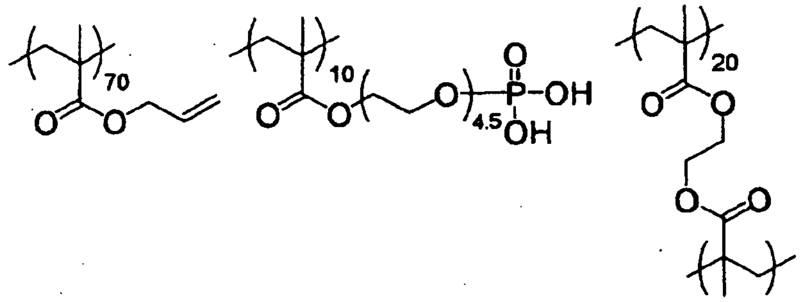

(13)

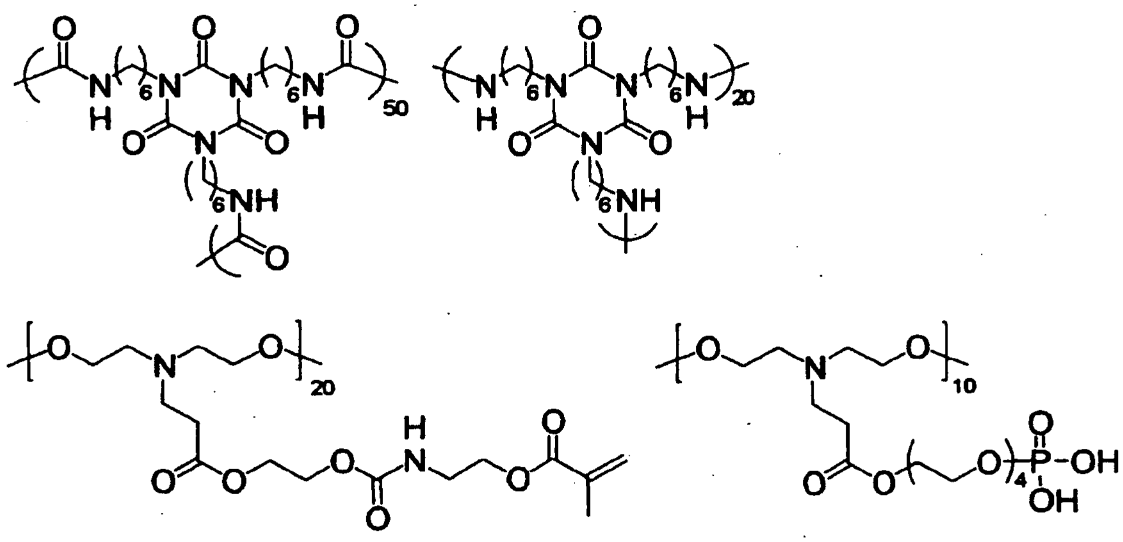

(14)

TABLE 1

| Solution of Organic Resin Fine Particle | Structure of Organic Resin Fine Particle | Average Particle Size of Organic Resin Fine Particle (nm) | Minimum Film-forming Temperature of Organic Resin Fine Particle (°C) | Dispersion Solvent | Solid Concentration (%) |
|---|---|---|---|---|---|
| (1) | (1) | 87 | >100 | Water | 20 |
| (2) | (2) | 78 | >100 | Acrylonitrile | 20 |
| (3) | (3) | 21 | >100 | Water | 11 |
| (4) | (4) | 80 | 25 | Water | 11 |
| (5) | (5) | 80 | 60 | Water | 11 |
| (6) | (6) | 80 | >100 | Water | 11 |
| (7) | (7) | 80 | 40 | Water | 11 |

(continued)

| Solution of Organic Resin Fine Particle | Structure of Organic Resin Fine Particle | Average Particle Size of Organic Resin Fine Particle (nm) | Minimum Film-forming Temperature of Organic Resin Fine Particle (°C) | Dispersion Solvent | Solid Concentration (%) |
|---|---|---|---|---|---|
| (8) | (8) | 80 | 60 | Water | 11 |
| (9) | (9) | 80 | 80 | Water | 11 |
| (10) | (6) | 10 | >100 | Water | 12 |
| (11) | (6) | 30 | >100 | Water | 11 |
| (12) | (6) | 50 | >100 | Water | 11 |
| (13) | (6) | 100 | >100 | Water | 10 |
| (14) | (6) | 150 | >100 | Water | 10 |
| (15) | (6) | 200 | >100 | Water | 10 |
| (16) | (6) | 400 | >100 | Water | 10 |
| (17) | (6) | 600 | >100 | Water | 10 |
| (18) | (10) | 80 | >100 | Acrylonitrile | 20 |
| (19) | (11) | 80 | 80 | Water | 11 |
| (20) | (12) | 75 | >100 | Water | 12 |
| (21) | (13) | 75 | >100 | Water | 12 |
| (22) | (14) | 200 | >100 | Water | 20 |

[Preparation of Aluminum plate S-1 with fine particle-containing layer]

An aluminum plate (material: JIS A1050) having a thickness of 0.30 mm was subjected to a degrease treatment by washing with trichloroethylene. Then, the aluminum plate surface was grained using a nylon brush and an aqueous suspension of 400 mesh pumice stone and thoroughly washed with water. The plate was subjected to etching by immersing it in an aqueous 25% by weight sodium hydroxide solution at 45°C for 9 seconds and after washing with water, immersed in an aqueous 2% by weight nitric acid solution for 20 seconds, followed by washing with water. The etching amount of the grained surface was about 3 g/$m^2$. The plate was then treated in an aqueous 7% by weight sulfuric acid solution as an electrolyte at a current density of 15 A/$dm^2$ to provide a direct current anodic oxide film of 3 g/$m^2$, thereafter washed with water and dried. The aluminum plate was immersed in an aqueous 2.5% by weight sodium silicate solution No. 3 (at 70°C) for 14 seconds, washed with water and dried. The aluminum plate thus-obtained was referred to as Aluminum plate SC-0. A solution prepared by adjusting the solid concentration of Solution of organic resin fine particle (1) to 4% by weight with the dispersion solvent was coated on Aluminum plate SC-0 and dried at 80°C for 3 minutes to prepare Aluminum plate S-1 with a fine particle-containing layer. The dry coating amount of the fine particle-containing layer was 0.1 g/$m^2$.

[Preparation of Aluminum plates S-2 to S-22 with fine particle-containing layer]

Aluminum plates S-2 to S-22 with fine particle-containing layer were prepared in the same manner as in the preparation of Aluminum plate S-1 with fine particle-containing layer except for using Solutions of organic resin fine particles (2) to (21) prepared by adjusting the solid concentration to 4% by weight with the dispersion solvent, respectively. The dry coating amount of the fine particle-containing layer on each aluminum plate was 0.1 g/$m^2$.

[Preparation of Aluminum plate S-23 with fine particle-containing layer]

A solution prepared by mixing equal amounts of Solution of organic resin fine particle (11) prepared by adjusting the solid concentration to 4% by weight with the dispersion solvent and Solution of organic resin fine particle (14) prepared

by adjusting the solid concentration to 4% by weight with the dispersion solvent was coated on Aluminum plate SC-0 and dried at 80°C for 3 minutes to prepare Aluminum plate S-23 with a fine particle-containing layer. The dry coating amount of the fine particle-containing layer was 0.1 g/m$^2$.

[Preparation of Aluminum plate S-24 with fine particle-containing layer]

A solution prepared by mixing equal amounts of Solution of organic resin fine particle (19) prepared by adjusting the solid concentration to 4% by weight with the dispersion solvent and Solution of organic resin fine particle (20) prepared by adjusting the solid concentration to 4% by weight with the dispersion solvent was coated on Aluminum plate SC-0 and dried at 80°C for 3 minutes to prepare Aluminum plate S-24 with a fine particle-containing layer. The solid content of the fine particle-containing layer was 0.1 g/m$^2$.

[Preparation of Aluminum plate S-25 with fine particle-containing layer]

A solution prepared by mixing Solution of organic resin fine particle (4) prepared by adjusting the solid concentration to 4% by weight with the dispersion solvent and Solution of organic resin fine particle (6) prepared by adjusting the solid concentration to 4% by weight with the dispersion solvent in a weight ratio of 1: 9 was coated on Aluminum plate SC-0 and dried at 80°C for 3 minutes to prepare Aluminum plate S-25 with a fine particle-containing layer. The solid content of the fine particle-containing layer was 0.1 g/m$^2$.

[Preparation of Aluminum plate S-26 with fine particle-containing layer]

Solution [1] shown below was coated on Aluminum plate SC-0 to prepare Aluminum plate S-26 with a fine particle-containing layer. The solid content of the fine particle-containing layer was 0.1 g/m$^2$.

| Solution [1] | |
|---|---|
| Solution of organic resin fine particle (6) (solid concentration: 11% by weight) | 90.0 g |
| Polyacrylic acid (weight average molecular weight: 120,000) | 0.1 g |
| Distilled water | 159.9 g |

[Preparation of Aluminum plate S-27 with fine particle-containing layer]

Solution [2] shown below was coated on Aluminum plate SC-0 to prepare Aluminum plate S-27 with a fine particle-containing layer. The solid content of the fine particle-containing layer was 0.1 g/m$^2$.

| Solution [2] | |
|---|---|
| Solution of organic resin fine particle (6) (solid concentration: 11% by weight) | 90.0 g |
| Hydrophilic resin (1) shown below (weight average molecular weight: 120,000) | 0.1 g |
| Distilled water | 159.9 g |

Hydrophilic resin (1):

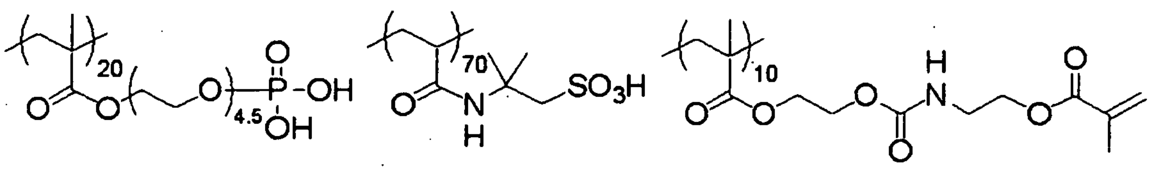

(1)

[Preparation of Aluminum plates S-28 to S-32 with fine particle-containing layer]

Aluminum plates S-28 to S-32 with fine particle-containing layer were prepared in the same manner as in the

preparation of Aluminum plate S-1 with fine particle-containing layer except for using Solution of organic resin fine particle (6) prepared by adjusting the solid concentration to 4% by weight with the dispersion solvent and varying the solid content of the fine particle-containing layer as shown below, respectively. Specifically, the solid contents of the fine particle-containing layers of Aluminum plates S-28 to S-32 were adjusted to 0.005 g/m$^2$, 0.015 g/m$^2$, 0.05 g/m$^2$, 0.15 g/m$^2$ and 0.3 g/m$^2$, respectively.

[Preparation of Aluminum plate S-33 with fine particle-containing layer]

Solution [3] shown below was coated on Aluminum plate SC-0 to prepare Aluminum plate S-33 with a fine particle-containing layer. The solid content of the fine particle-containing layer was 0.1 g/m$^2$.

| | |
|---|---|
| Solution [3] | |
| Solution of organic resin fine particle (6) (solid concentration: 11% by weight) | 90.0 g |
| Diethylhexyl 2-sulfosuccinate | 0.01 g |
| Distilled water | 159.9 g |

[Preparation of Aluminum plate S-34 with fine particle-containing layer]

Solution [4] shown below was coated on Aluminum plate SC-0 to prepare Aluminum plate S-34 with a fine particle-containing layer. The solid content of the fine particle-containing layer was 0.1 g/m$^2$.

| | |
|---|---|
| Solution [4] | |
| Solution of organic resin fine particle (21) (solid concentration: 12% by weight) | 82.5 g |
| Hydrophilic resin (1) shown above (weight average molecular weight: 120,000) | 0.1 g |
| Distilled water | 167.4 g |

[Preparation of aluminum plate SC-1 with undercoat layer of organic resin]

Solution [5] shown below was coated on Aluminum plate SC-0 and dried at 80°C for 3 minutes to prepare Aluminum plate SC-1 with undercoat layer of organic resin. The solid content of the undercoat layer of organic resin was 0.1 g/m$^2$.

| | |
|---|---|
| Solution [5] | |
| Poly(tert-butyl methacrylate) (weight average molecular weight: 120,000) | 4.0 g |
| Methyl ethyl ketone | 96.0 g |

[Preparation of Aluminum plate SC-2 with undercoat layer of organic resin]

Solution [6] shown below was coated on Aluminum plate SC-0 and dried at 80°C for 3 minutes to prepare Aluminum plate SC-2 with undercoat layer of organic resin. The solid content of the undercoat layer of organic resin was 0.1 g/m$^2$.

| | |
|---|---|
| Solution [6] | |
| Hydrophilic resin (1) shown above (weight average molecular weight: 120,000) | 4.0 g |
| Methanol | 96.0 g |

[Preparation of Aluminum plate SC-3 with undercoat layer of organic resin]

Solution [7] shown below was coated on Aluminum plate SC-0 and dried at 80°C for 3 minutes to prepare Aluminum plate SC-3 with undercoat layer of organic resin. The solid content of the undercoat layer of organic resin was 0.1 g/m$^2$.

| | |
|---|---|
| Solution [7] | |
| Hydrophilic resin (2) shown below (weight average molecular weight: 120,000) | 4.0 g |

(continued)

| | |
|---|---|
| Solution [7] | |
| Methanol | 96.0 g |

Hydrophilic resin (2):

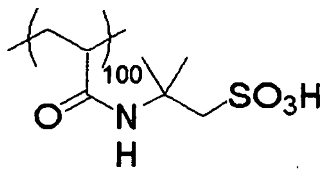

(2)

EXAMPLES 1 TO 34 AND COMPARATIVE EXAMPLES 1 TO 4

<Preparation of Lithographic printing plate precursors (1) to (38)>

On each of the aluminum plates prepared above, Coating Solution 1 for Photosensitive Layer having the composition shown below was coated and dried at 80°C for one minute. The coating amount of the photosensitive layer was 1.2 g/$m^2$.

| | |
|---|---|
| (Coating Solution 1 for Photosensitive Layer) | |
| Binder Polymer (1) shown below | 0.54 g |
| Polymerizable compound | 0.40 g |
| Isocyanuric acid EO-modified triacrylate (Aronics M-315, produced by Toa Gosei Co., Ltd.) | |
| Polymerizable compound | 0.08 g |
| Ethoxylated trimethylolpropane triacrylate (SR9035, produced by Nippon Kayaku Co., Ltd., EO addition molar number: 15, molecular weight: 1,000) | |
| Sensitizing Dye (1) shown below | 0.06 g |
| Polymerization Initiator (1) shown below | 0.10 g |
| Co-sensitizer (1) shown below | 0.07 g |
| Dispersion of ε-phthalocyanine pigment | 0.40 g |
| [pigment: 15 parts by weight; dispersing agent (allyl methacrylate/methacrylic acid (80/20) copolymer): 10 parts by weight; solvent (cyclohexanone/methoxypropyl acetate/1-methoxy-2-propanol = 15 parts by weight/20 parts by weight/40 parts by weight)] | |
| Methyl ethyl ketone | 4.80 g |
| Dimethylsulfoxide | 4.80 g |

Binder Polymer (1):

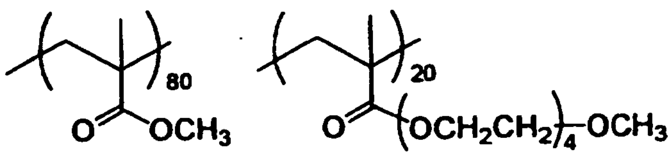

Sensitizing Dye (1):

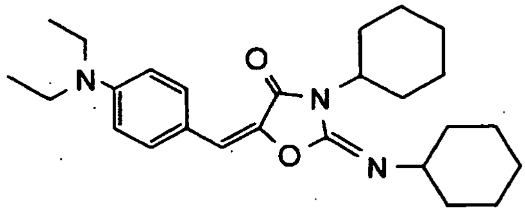

Polymerization Initiator (1):

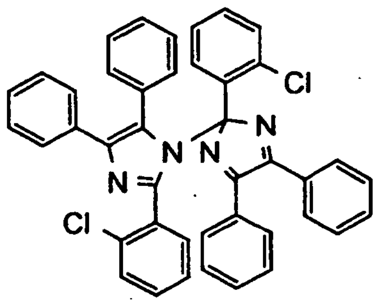

Co-sensitizer (1):

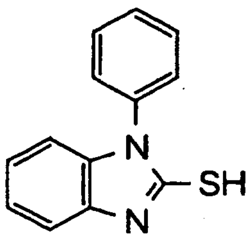

On the photosensitive layer, Coating Solution 1 for Protective Layer having the composition shown below was coated using a bar so as to have a dry coating amount of 0.75 $g/m^2$ and dried at 125°C for 70 seconds to form a protective layer, thereby preparing Lithographic Printing Plate Precursors (1) to (38), respectively.

| | |
|---|---|
| (Coating Solution 1 for Protective Layer) | |
| Polyvinyl alcohol (saponification degree: 98% by mole; polymerization degree: 500) | 40 g |
| Polyvinyl pyrrolidone (molecular weight: 50, 000) | 5 g |
| Vinyl pyrrolidone/vinyl acetate (1/1) copolymer (molecular weight: 70,000) | 0.5 g |
| Surfactant (Emalex 710, produced by Nihon-Emulsion Co., Ltd.) | 0.5 g |
| Water | 950 g |

(1) Exposure, Development and Printing

Each of Lithographic Printing Plate Precursors (1) to (38) was subjected to imagewise exposure using a semiconductor laser of 405 nm having an output of 100 mW at energy of 100 $\mu J/cm^2$.

Then, development processing was performed in an automatic development processor having a structure shown in Fig. 1 using

Aqueous solution 1 having the composition shown below to prepare a lithographic printing plate (without heating). The automatic development processor had two rotating brush rollers. The first brush roller was a brush roller having an outer diameter of 90 mm and being implanted with fiber of polybutylene terephthalate (bristle diameter: 200 μm, bristle length: 17 mm), and the brush roller was rotated at 200 rpm (peripheral velocity at the tip of brush: 0.94 m/sec) in the same direction as the transporting direction. The second brush roller was a brush roller having an outer diameter of 60 mm and being implanted with fiber of polybutylene terephthalate (bristle diameter: 200μm, bristle length: 17 mm), and the brush roller was rotated at 200 rpm (peripheral velocity at the tip of brush: 0.63 m/sec) in the opposite direction to the transporting direction. The transportation of the lithographic printing plate precursor was performed at transporting speed of 100 cm/min. Aqueous solution 1 was supplied on the surface of the lithographic printing plate precursor by showering from a spray pipe using a circulation pump. The tank volume for Aqueous solution 1 was 10 liters.

| Aqueous solution 1 | |
|---|---|
| Water | 100.00 g |
| Benzyl alcohol | 1.00 g |
| Polyoxyethylene naphthyl ether (average number of oxyethylene: n = 13) | 1.00 g |
| Sodium salt of dioctylsulfosuccinic acid ester | 0. 50 g |
| Gum arabic | 1.00 g |
| Ethylene glycol | 0. 50 g |
| Ammonium primary phosphate | 0.05 g |
| Citric acid | 0.05 g |
| Tetrasodium salt of ethylenediaminetetraacetate (pH = 5) | 0.05 g |

On the other hand, within 30 seconds after the laser imagewise exposure, the exposed lithographic printing plate precursor was put in an oven and heated the whole surface of the lithographic printing plate precursor by blowing hot air to maintain at 110°C for 15 seconds and then the development processing was performed within 30 seconds in the same manner as described above to prepare a lithographic printing plate (with heating).

Then, each of the lithographic printing plate (without heating) and the lithographic printing plate (with heating) was mounted on a printing machine, SOR-M, produced by Heidelberg, and printing was performed at a printing speed of 6,000 sheets per hour using dampening water (EU-3 (etching solution, produced by Fuji Film Co., Ltd.))/water/isopropyl alcohol = 1/89/10 (by volume ratio)) and TRANS-G(N) black ink (produced by Dainippon Ink & Chemicals, Inc.).

(2) Evaluation

With respect to the lithographic printing plates prepared above, the printing durability and stain resistance were evaluated in the following manner. The results are shown in Table 2.

<Printing durability>

As increase in the number of printing sheets, the photosensitive layer was gradually abraded to cause decrease in the ink receptivity, resulting in decrease of ink density on a printed material. With respect to the lithographic printing plate obtained by the exposure in the same exposure amount, a number of printed materials obtained until the ink density (reflection density) decreased by 0.1 from that at the initiation of printing was determined to relatively evaluate the printing durability. Specifically, the printing durability was calculated according to the formula shown below using Comparative Example 1 as the criterion (100). As the value increases, the printing durability becomes higher.

Printing durability = (Number of printed materials of subject lithographic printing plate) / (Number of printed materials of criterion lithographic printing plate) x 100

<Stain resistance>

The 500th sheet of the printed material from the initiation of printing was picked up and the density of ink adhered on the non-image area was measured to relatively evaluate the stain resistance. Specifically, the stain resistance was calculated according to the formula shown below using Comparative Example 1 as the criterion (100). As the value increases, the density of ink adhered on the non-image area decreases, that is, the stain resistance becomes better.

Stain resistance = (Ink density on non-image area of criterion lithographic printing plate)/(Ink density on non-image area of subject lithographic printing plate) x 100

TABLE 2

| | Aluminum Plate | Lithographic Printing Plate Precursor | Printing Durability | | Stain Resistance | |
|---|---|---|---|---|---|---|
| | | | Without Heating | With Heating | Without Heating | With Heating |
| Example 1 | S-1 | (1) | 110 | 110 | 720 | 720 |
| Example 2 | S-2 | (2) | 120 | 120 | 720 | 720 |
| Example 3 | S-3 | (3) | 140 | 140 | 720 | 720 |
| Example 4 | S-4 | (4) | 130 | 140 | 640 | 640 |
| Example 5 | S-5 | (5) | 120 | 130 | 700 | 700 |
| Example 6 | S-6 | (6) | 110 | 110 | 720 | 720 |
| Example 7 | S-7 | (7) | 125 | 135 | 700 | 700 |
| Example 8 | S-8 | (8) | 120 | 130 | 700 | 700 |
| Example 9 | S-9 | (9) | 110 | 120 | 720 | 720 |
| Example 10 | S-10 | (10) | 150 | 150 | 700 | 700 |
| Example 11 | S-11 | (11) | 120 | 120 | 720 | 720 |
| Example 12 | S-12 | (12) | 110 | 110 | 720 | 720 |
| Example 13 | S-13 | (13) | 110 | 110 | 720 | 720 |
| Example 14 | S-14 | (14) | 110 | 110 | 720 | 720 |
| Example 15 | S-15 | (15) | 110 | 110 | 720 | 720 |
| Example 16 | S-16 | (16) | 105 | 105 | 720 | 720 |
| Example 17 | S-17 | (17) | 100 | 100 | 720 | 720 |
| Example 18 | S-18 | (18) | 140 | 140 | 720 | 720 |
| Example 19 | S-19 | (19) | 120 | 130 | 720 | 720 |
| Example 20 | S-20 | (20) | 120 | 120 | 720 | 720 |
| Example 21 | S-21 | (21) | 150 | 150 | 720 | 720 |
| Example 22 | S-22 | (22) | 120 | 120 | 720 | 720 |
| Example 23 | S-23 | (23) | 120 | 120 | 720 | 720 |
| Example 24 | S-24 | (24) | 130 | 140 | 720 | 720 |
| Example 25 | S-25 | (25) | 120 | 120 | 720 | 720 |
| Example 26 | S-26 | (26) | 110 | 110 | 720 | 720 |

(continued)

| | Aluminum Plate | Lithographic Printing Plate Precursor | Printing Durability | | Stain Resistance | |
|---|---|---|---|---|---|---|
| | | | Without Heating | With Heating | Without Heating | With Heating |
| Example 27 | S-27 | (27) | 130 | 140 | 720 | 720 |
| Example 28 | S-28 | (28) | 110 | 110 | 640 | 640 |
| Example 29 | S-29 | (29) | 110 | 110 | 700 | 700 |
| Example 30 | S-30 | (30) | 110 | 110 | 720 | 720 |
| Example 31 | S-31 | (31) | 110 | 110 | 720 | 720 |
| Example 32 | S-32 | (32) | 100 | 100 | 720 | 720 |
| Example 33 | S-33 | (33) | 110 | 110 | 720 | 720 |
| Example 34 | S-34 | (34) | 160 | 160 | 720 | 720 |
| Comparative Example 1 | SC-0 | (35) | 100 | 100 | 100 | 100 |
| Comparative Example 2 | SC-1 | (36) | 100 | 100 | 70 | 70 |
| Comparative Example 3 | SC-2 | (37) | 60 | 60 | 720 | 720 |
| Comparative Example 4 | SC-3 | (38) | 10 | 10 | 720 | 720 |

EXAMPLES 35 TO 49 AND COMPARATIVE EXAMPLES 5 TO 8

<Preparation of Lithographic printing plate precursors (39) to (57)>

On each of the aluminum plates as shown in Table 3 below, Coating Solution 2 for Photosensitive Layer having the composition shown below was coated in a dry coating amount of 1.2 g/$m^2$ to from a photosensitive layer. On the photosensitive layer, Coating Solution 1 for Protective Layer described above was coated using a bar so as to have a dry coating amount of 0.75 g/$m^2$ and dried at 125°C for 70 seconds to form a protective layer, thereby preparing Lithographic Printing Plate Precursors (39) to (57), respectively.

(Coating Solution 2 for Photosensitive Layer)

| | |
|---|---|
| Binder Polymer (2) shown below | 0.54 g |
| Polymerizable Compound (2) shown below | 0.48 g |
| Sensitizing Dye (1) shown above | 0.06 g |
| Polymerization Initiator (1) shown above | 0.18 g |
| Co-sensitizer (1) shown above | 0.07 g |
| Dispersion of ε-phthalocyanine pigment | 0.40 g |
| [pigment: 15 parts by weight; dispersing agent (allyl methacrylate/methacrylic acid (80/20) copolymer): 10 parts by weight; solvent (cyclohexanone/methoxypropyl acetate/1-methoxy-2-propanol = 15 parts by weight/20 parts by weight/40 parts by weight)] | |
| Thermal polymerization inhibitor N-nitrosophenylhydroxylamine aluminum salt | 0.01 g |
| Fluorine-Based Surfactant (1) shown below | 0.001 g |
| Polyoxyethylene-polyoxypropylene condensate (Pluronic L44, produced by ADEKA Corp.) | 0.04 g |
| Tetraethylamine hydrochloride | 0.01 g |
| 1-Methoxy-2-propanol | 3.5 g |
| Methyl ethyl ketone | 8.0 g |

Binder Polymer (2):

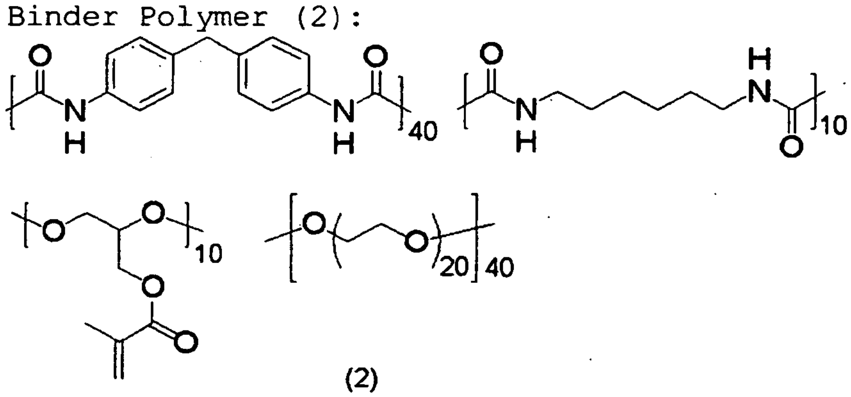

(2)

Polymerizable Compound (2):

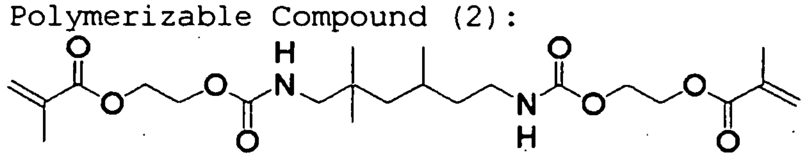

Fluorine-Based Surfactant (1):

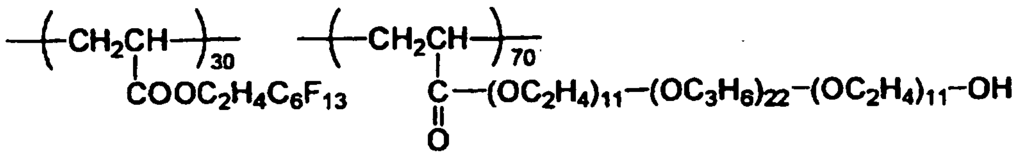

Lithographic Printing Plate Precursors (39) to (57) thus-obtained were evaluated in the same manner as in Example 1. As the criterion lithographic printing plate for the evaluation, the lithographic printing plate of Comparative Example 5 was used. The results are shown in Table 3.

TABLE 3

| | Aluminum Plate | Lithographic Printing Plate Precursor | Printing Durability | | Stain Resistance | |
|---|---|---|---|---|---|---|
| | | | Without Heating | With Heating | Without Heating | With Heating |
| Example 35 | S-1 | (39) | 110 | 110 | 720 | 720 |
| Example 36 | S-2 | (40) | 120 | 120 | 720 | 720 |
| Example 37 | S-3 | (41) | 140 | 140 | 720 | 720 |
| Example 38 | S-18 | (42) | 140 | 140 | 720 | 720 |
| Example 39 | S-19 | (43) | 120 | 130 | 720 | 720 |
| Example 40 | S-20 | (44) | 120 | 120 | 720 | 720 |
| Example 41 | S-21 | (45) | 150 | 150 | 720 | 720 |
| Example 42 | S-22 | (46) | 120 | 120 | 720 | 720 |
| Example 43 | S-23 | (47) | 120 | 120 | 720 | 720 |
| Example 44 | S-24 | (48) | 130 | 140 | 720 | 720 |
| Example 45 | S-25 | (49) | 120 | 120 | 720 | 720 |

(continued)

| | Aluminum Plate | Lithographic Printing Plate Precursor | Printing Durability | | Stain Resistance | |
|---|---|---|---|---|---|---|
| | | | Without Heating | With Heating | Without Heating | With Heating |
| Example 46 | S-26 | (50) | 110 | 110 | 720 | 720 |
| Example 47 | S-27 | (51) | 130 | 140 | 720 | 720 |
| Example 48 | S-33 | (52) | 110 | 110 | 720 | 720 |
| Example 49 | S-34 | (53) | 160 | 160 | 720 | 720 |
| Comparative Example 5 | SC-0 | (54) | 100 | 100 | 100 | 100 |
| Comparative Example 6 | SC-1 | (55) | 100 | 100 | 70 | 70 |
| Comparative Example 7 | SC-2 | (56) | 60 | 60 | 720 | 720 |
| Comparative Example 8 | SC-3 | (57) | 10 | 10 | 720 | 720 |

As is apparent from the results shown above, the lithographic printing plate precursor according to the invention can provide a lithographic printing plate exhibiting good stain resistance and high printing durability.

## Claims

1. A negative type lithographic printing plate precursor comprising, in the following order:

   a support;
   a layer comprising organic resin fine particles; and
   a photosensitive layer containing (a) a radical polymerizable compound, (b) a binder polymer, (c) an initiator and (d) a sensitizing dye having an absorption maximum in a wavelength range of from 350 to 450 nm.

2. The negative type lithographic printing plate precursor as claimed in Claim 1, wherein the organic resin fine particle has a functional group which interacts with the photosensitive layer.

3. The negative type lithographic printing plate precursor as claimed in Claim 1 or 2, wherein the organic resin fine particle has a functional group which interacts with a surface of the support.

4. The negative type lithographic printing plate precursor as claimed in any one of Claims 1 to 3, wherein the organic resin fine particle has a minimum film-forming temperature of 60°C or more.

5. The negative type lithographic printing plate precursor as claimed in any one of Claims 1 to 4, wherein the photosensitive layer is free from a light-to-heat conversion agent.

6. The negative type lithographic printing plate precursor as claimed in any one of Claims 1 to 5, which further comprises a protective layer, so that the support, the layer comprising organic resin fine particles, the photosensitive layer and the protective layer are provided in this order.

7. The negative type lithographic printing plate precursor as claimed in any one of Claims 1 to 6, wherein an amount of the organic resin fine particles in the organic resin particle-containing layer is 50% by weight or more based on a total solid content of the particle-containing layer.

8. The negative type lithographic printing plate precursor as claimed in any one of Claims 1 to 7, wherein an average particle size of the organic resin fine particles is from 0.01 to 1 μm.

**9.** A method of preparing a lithographic printing plate, comprising:

exposing imagewise the lithographic printing plate precursor as claimed in any one of Claims 1 to 8 with a laser; and
rubbing a surface of the exposed lithographic printing plate precursor with a rubbing member in the presence of a developer having pH of from 2 to 10 in an automatic processor equipped with the rubbing member to remove an unexposed area of the photosensitive layer and the layer comprising an organic resin particle.

**10.** The method of preparing a lithographic printing plate as claimed in Claim 9, wherein the exposed lithographic printing plate precursor is subjected to a heat treatment between the exposure and the development.

**Patentansprüche**

**1.** Lithographischer Druckplattenvorläufer vom negativen Typ, umfassend, in folgender Reihenfolge:

einen Träger;
eine organische Harzfeinteilchen umfassende Schicht; und
eine lichtempfindliche Schicht, enthaltend (a) eine radikalisch polymerisierbare Verbindung, (b) ein Bindemittelpolymer, (c) einen Initiator und (d) einen Sensibilisierungsfarbstoff mit einem Absorptionsmaximum in einem Wellenlängenbereich von 350 bis 450 nm.

**2.** Lithographischer Druckplattenvorläufer vom negativen Typ nach Anspruch 1, worin das organische Harzfeinteilchen eine funktionale Gruppe besitzt, die mit der lichtempfindlichen Schicht wechselwirkt.

**3.** Lithographischer Druckplattenvorläufer vom negativen Typ nach Anspruch 1 oder 2, worin das organische Harzfeinteilchen eine funktionale Gruppe besitzt, die mit einer Oberfläche des Trägers wechselwirkt.

**4.** Lithographischer Druckplattenvorläufer vom negativen Typ nach einem der Ansprüche 1 bis 3, worin das anorganische Harzfeinteilchen eine minimale Filmbildungstemperatur von 60°C oder mehr besitzt.

**5.** Lithographischer Druckplattenvorläufer vom negativen Typ nach einem der Ansprüche 1 bis 4, worin die lichtempfindliche Schicht frei von einem Licht-in-Wärme-Umwandlungsmittel ist.

**6.** Lithographischer Druckplattenvorläufer vom negativen Typ, nach einem der Ansprüche 1 bis 5, der ferner eine Schutzschicht umfasst, so dass der Träger, die organische Harzfeinteilchen umfassende Schicht, die lichtempfindliche Schicht und die Schutzschicht, in dieser Reihenfolge, bereitgestellt sind.

**7.** Lithographischer Druckplattenvorläufer vom negativen Typ, nach einem der Ansprüche 1 bis 6, worin die Menge der organischen Harzfeinteilchen in der organischen Harzteilchen enthaltenden Schicht 50 Gew.% oder mehr, basierend auf dem Gesamtfeststoffgehalt der Teilchen enthaltenden Schicht, beträgt.

**8.** Lithographischer Druckplattenvorläufer vom negativen Typ, nach einem der Ansprüche 1 bis 7, worin die durchschnittliche Teilchengröße der organischen Harzfeinteilchen 0,01 bis 1 μm beträgt.

**9.** Verfahren zur Herstellung einer lithographischen Druckplatte, umfassend:

bildweises Belichten des lithographischen Druckplattenvorläufers, wie in einem der Ansprüche 1 bis 8 definiert, durch einen Laser; und
Abreiben der Oberfläche des belichteten lithographischen Druckplattenvorläufers mit einem Abriebselement in Gegenwart eines Entwicklungsmittels mit einem pH-Wert von 2 bis 10 in einem automatischen Prozessor, der mit einem Abriebselement ausgestattet ist, um eine unbelichtete Fläche der lichtempfindlichen Schicht und die organische Harzteilchen umfassenden Schicht zu entfernen.

**10.** Verfahren zur Herstellung einer lithographischen Druckplatte nach Anspruch 9, worin der belichtete lithographische Druckplattenvorläufer einer Erhitzungsbehandlung zwischen der Belichtung und der Entwicklung unterzogen wird.

## Revendications

1. Précurseur de plaque d'impression lithographique du type négatif comprenant, dans l'ordre suivant :

   un support;
   une couche comprenant des particules fines de résine organique; et
   une couche photosensible contenant (a) un composé polymérisable radical, (b) un polymère liant, (c) un initiateur et (d) un colorant de sensibilisation ayant un niveau maximal d'absorption dans une gamme de longueur d'onde de 350 à 450 nm.

2. Précurseur de plaque d'impression lithographique du type négatif selon la revendication 1, dans lequel la particule fine de résine organique a un groupe fonctionnel qui interagit avec la couche photosensible.

3. Précurseur de plaque d'impression lithographique du type négatif selon la revendication 1 ou 2, dans lequel la particule fine de résine organique a un groupe fonctionnel qui interagit avec une surface du support.

4. Précurseur de plaque d'impression lithographique du type négatif selon l'une quelconque des revendications 1 à 3, dans lequel la particule fine de résine organique a une température minimale de formation de film de 60°C ou plus.

5. Précurseur de plaque d'impression lithographique du type négatif selon l'une quelconque des revendications 1 à 4, dans lequel la couche photosensible ne contient aucun agent convertissant la lumière en chaleur.

6. Précurseur de plaque d'impression lithographique du type négatif selon l'une quelconque des revendications 1 à 5, qui comprend en plus une couche de protection, de sorte que le support, la couche comprenant des particules fines de résine organique, la couche photosensible et la couche de protection soient fournies dans cet ordre.

7. Précurseur de plaque d'impression lithographique du type négatif selon l'une quelconque des revendications 1 à 6, dans lequel une quantité des particules fines de résine organique dans la couche contenant des particules de résine organique est de 50% en poids ou plus sur la base d'une teneur totale en matière solide de la couche contenant les particules.

8. Précurseur de plaque d'impression lithographique du type négatif selon l'une quelconque des revendications 1 à 7, dans lequel la taille particulaire moyenne des particules fines de résine organique est de 0,01 à 0,1 μm.

9. Procédé de préparation de plaque d'impression lithographique, comprenant le fait de :

   exposer en mode image le précurseur de plaque d'impression lithographique selon l'une quelconque des revendications 1 à 8 avec un laser; et
   frotter une surface du précurseur de plaque d'impression lithographique exposé avec un élément de frottement en présence d'un révélateur ayant un pH dans la plage de 2 à 10 dans un processeur automatique équipé d'un élément de frottement pour retirer une zone non exposée de la couche photosensible et la couche comprenant des particules de résine organique.

10. Procédé de préparation d'une plaque d'impression lithographique selon la revendication 9, dans lequel le précurseur de plaque d'impression lithographique exposé est soumis à un traitement thermique entre l'exposition et le développement.

FIG. 1

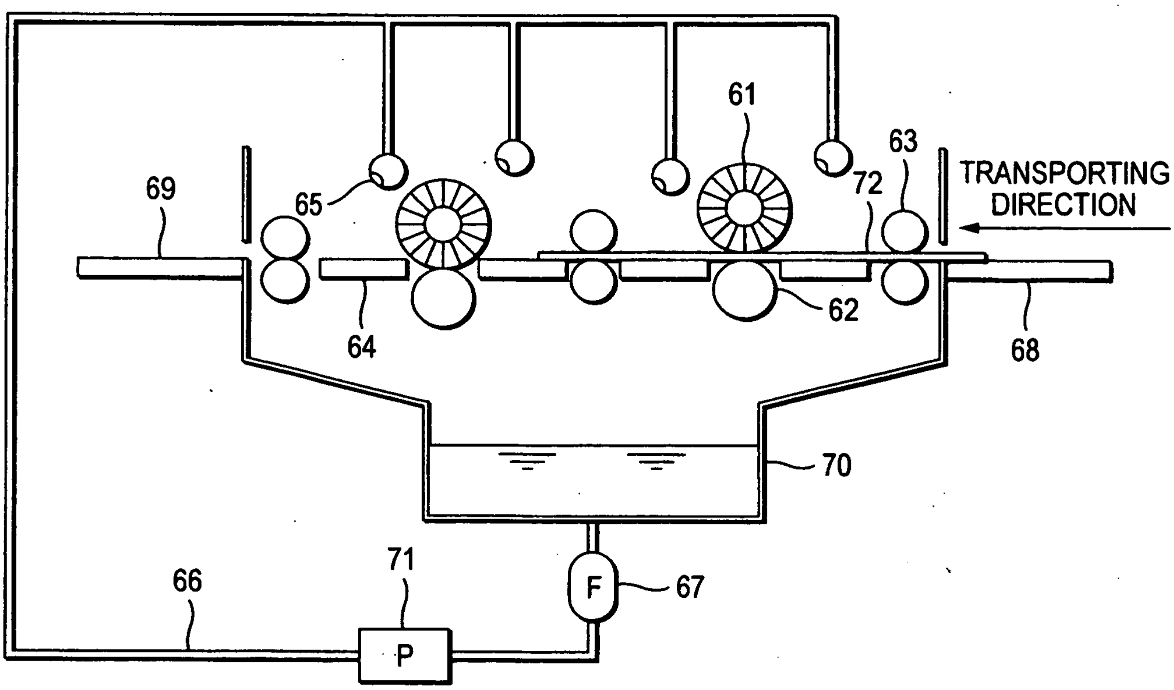

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4708925 A
- JP 8276558 A
- US 6132935 A
- US 2850445 A
- JP 4420189 B
- JP 2938397 B
- US 6030750 A
- JP 2000211262 A
- JP 2001277740 A
- US 20010018159 A1
- JP 2002029162 A
- US 20020031715 A1
- JP 2002046361 A
- JP 2002137562 A
- US 20020102488 A1
- JP 2002326470 A
- US 20020117066 A1
- JP 2001337460 A
- US 20030190553 A1
- EP 1630618 A
- US 20060166137 A1
- EP 1685957 A
- EP 1798031 A
- US 20070009829 A1
- EP 1865382 A1
- US 2800457 A
- US 2800458 A
- GB 990443 A
- US 3287154 A
- JP 3819574 B
- JP 42446 B
- JP 42711 B
- US 3418250 A
- US 3660304 A
- US 3796669 A
- US 3914511 A
- US 4001140 A
- US 4087376 A
- US 4089802 A
- US 4025445 A
- JP 369163 B
- JP 51009079 B
- GB 930422 A
- US 3111407 A
- GB 952807 A
- GB 967074 A
- JP 62170950 A
- JP 62226143 A
- JP 60168144 A
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- US 3905815 A
- JP 46004605 B
- JP 48036281 A
- JP 53133428 A
- JP 55032070 A
- JP 60239736 A
- JP 61169835 A
- JP 61169837 A
- JP 62058241 A
- JP 62212401 A
- JP 63070243 A
- JP 63298339 A
- JP 8108621 A
- JP 59152396 A
- JP 61151197 A
- JP 63041484 A
- JP 2000249 A
- JP 2004705 A
- JP 5083588 A
- JP 1304453 A
- JP 1152109 A
- JP 6029285 B

- US 3479185 A
- US 4311783 A
- US 4622286 A
- JP 62143044 A
- JP 62150242 A
- JP 9188685 A
- JP 9188686 A
- JP 9188710 A
- JP 2000131837 A
- JP 2002107916 A
- JP 2764769 B
- JP 2002116539 A
- JP 6157623 A
- JP 6175564 A
- JP 6175561 A
- JP 6175554 A
- JP 6175553 A
- JP 6348011 A
- JP 7128785 A
- JP 7140589 A
- JP 7306527 A
- JP 7292014 A
- JP 61166544 A
- JP 2002328465 A
- JP 2000066385 A
- JP 2000080068 A
- US 4069055 A
- JP 4365049 A
- US 4069056 A
- EP 104143 A
- US 339049 A
- US 410201 A
- JP 2150848 A
- JP 2296514 A
- EP 370693 A
- EP 390214 A
- EP 233567 A
- EP 297443 A
- EP 297442 A
- US 4933377 A
- US 161811 A
- US 4760013 A
- US 4734444 A
- US 2833827 A
- DE 2904626
- DE 3604580
- DE 3604581
- JP 2001343742 A
- JP 2002148790 A
- JP 3296759 A
- JP 59028329 B
- JP 9236913 A
- JP 2001277742 A
- JP 62293247 A
- JP 54063902 A
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- JP 2001199175 A
- JP 2002079772 A
- JP 10282679 A
- JP 2304441 A
- US 3458311 A
- JP 55049729 B
- US 292501 A
- US 44563 A
- JP 5045885 A
- JP 6035174 A
- JP 2220061 A
- JP 60059351 A
- US 5148746 A
- US 5568768 A
- GB 2297719 A
- JP 58159533 A
- JP 3100554 A
- JP B62167253 U

**Non-patent literature cited in the description**

- *Nippon Secchaku Kyokaishi,* 1984, vol. 20 (7), 300-308
- **WAKABAYASHI et al.** *Bull. Chem. Soc. Japan,* 1969, vol. 42, 2924
- **M. P. HUTT.** *Journal of Heterocyclic Chemistry,* 1970, vol. 1 (3
- **MARTIN KUNZ.** *Rad Tech' 98, Proceeding,* 19 April 1998
- *J. C. S. Perkin II,* 1979, 1653-1660
- *J. C. S. Perkin II,* 1979, 156-162
- *Journal of Photopolymer Science and Technology,* 1995, 202-232
- **S. I. SCHLESINGER.** *Photogr. Sci. Eng.,* 1974, vol. 18, 387
- **T. S. BAL et al.** *Polymer,* 1980, vol. 21, 423
- **J.V. CRIVELLO et al.** *Macromolecules,* 1977, vol. 10 (6), 1307
- **J.V. CRIVELLO et al.** *J. Polymer Sci., Polymer Chem. Ed.,* 1979, vol. 17, 1047
- **C.S. WEN et al.** *Teh, Proc. Conf. Rad. Curing ASIA,* October 1988, 478
- **L.G. BROOKER et al.** *J. Am. Chem. Soc.,* 1951, vol. 73, 5326-5358